# EUROPEAN PATENT SPECIFICATION

(11) **EP 4 372 067 B1**
(45) Date of publication and mention of the grant of the patent: **14.01.2026**
(21) Application number: 23209613.1
(22) Date of filing: 14.11.2023
(51) Int. Cl.: C09K 11/06, H10K 50/12, H10K 85/30

(54) **ORGANOMETALLIC COMPLEX AND ORGANIC LIGHT-EMITTING ELEMENT**
ORGANOMETALLISCHER KOMPLEX UND ORGANISCHES LICHTEMITTIERENDES ELEMENT
COMPLEXE ORGANOMÉTALLIQUE ET ÉLÉMENT ÉLECTROLUMINESCENT ORGANIQUE

(30) Priority: 15.11.2022 JP 2022182649
(43) Date of publication of application: 22.05.2024
(73) Proprietor: CANON KABUSHIKI KAISHA, Tokyo 146-8501 (JP)
(72) Inventor: NISHIDE, Yosuke, Tokyo, 146-8501 (JP); OHRUI, Hiroki, Tokyo, 146-8501 (JP); IWAWAKI, Hironobu, Tokyo, 146-8501 (JP); HORIUCHI, Takayuki, Tokyo, 146-8501 (JP); MIYASHITA, Hirokazu, Tokyo, 146-8501 (JP); YAMADA, Naoki, Tokyo, 146-8501 (JP)
(74) Representative: TBK

(56) References cited:
- EP-A1- 4 056 578
- CN-A- 115 109 039
- US-A1- 2020 313 097

## Description

### BACKGROUND OF THE INVENTION

### Field of the Invention

The present disclosure relates to an organometallic complex and an organic light-emitting element including the organometallic complex.

### Description of the Related Art

An organic light-emitting element (also referred to as an organic electroluminescent element (an organic EL element)) is an electronic element that includes a pair of electrodes and an organic compound layer between these electrodes. Electrons and holes are injected from the pair of electrodes to generate an exciton of a light-emitting organic compound in the organic compound layer. When the exciton returns to its ground state, the organic light-emitting element emits light.

With recent significant advances in organic light-emitting elements, it is possible to realize low drive voltage, various emission wavelengths, high-speed responsivity, and thin and light light-emitting devices.

sRGB and Adobe^{™} RGB standards are used for a color reproduction range for displays, and materials for reproducing these standards have been studied. BT-2020 has recently been proposed as a standard to further expand the color reproduction range.

At present, the use of phosphorescence has been proposed to improve the luminescence efficiency of organic EL elements. Organic EL elements utilizing phosphorescence are expected to have luminescence efficiency theoretically approximately four times the luminescence efficiency of those utilizing fluorescence. Thus, phosphorescent organometallic complexes have been actively developed. This is because the development of organometallic complexes with good emission properties is important for high-performance organic light-emitting elements.

Japanese Patent Laid-Open No. 2009-114137 (PTL 1) discloses the following compound 1-a as an organometallic complex developed so far.

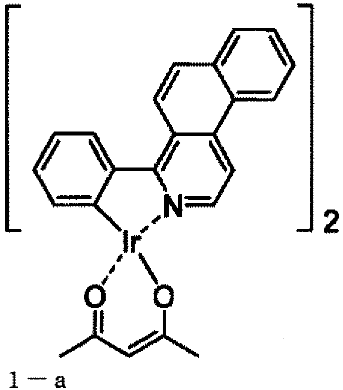

Although an organic light-emitting element including a compound described in PTL 1 can emit light with high luminescence efficiency and color purity, further improvement is required for high color purity, high efficiency, and high durability required for BT-2020.

PTL 2 (EP4056578 A1) discloses a compound of Formula Ir(L_{A})(L_{B})(L_{C}).

In Formula Ir(L_{A})(L_{B})(L_{C}), L_{A} has Formula I,L_{B} has Formula II,; L_{C} is a monoanionic bidentate ligand that does not comprise a phenylpyridine ligand; and each of L_{A}, L_{B}, and L_{C} is different. Each of moieties A, C, and D is independently a monocyclic ring or a polycyclic fused ring structure or 5-membered and/or 6-membered rings; each of X¹ to X⁶ is C or N; each of Z¹ and Z² is C or N; at least one of Z¹ and Z² is N; each R^{A}, R^{B}, R^{C}, and R^{D} is independently a hydrogen or a General Substituent; and any two adjacent substituents can be joined or fused together to form a ring.

PTL 3 (CN115109039 A) discloses a carbazole derivative and application thereof in an organic light emitting diode (OLED). The carbazole derivative has a condensed carbazole structure, has a high triplet state energy level, and increases conjugation of a carbazole parent nucleus, so that the thermal stability and the carrier conveying capability of the material are improved. The structural formula of the carbazole derivative is as shown in formula (I).

PTL 4 (US2020313097 A1) discloses an organometallic compound, an organic light-emitting device including the same, and an electronic apparatus including the organic light-emitting device. The organometallic compound is represented by the formula Ir(L1)(L2)(L3), wherein L1 may be a ligand represented by Formula 1-1, L2 may be a ligand represented by Formula 1-2, L3 may be a ligand represented by Formula 1-3, and L1 and L2 may be different from each other.

### SUMMARY OF THE INVENTION

In view of these issues, the present disclosure provides an organometallic complex that emits red light with high color purity.

The present disclosure in its first aspect provides an organometallic complex as specified in claims 1 to 8.

The present disclosure in its second aspect provides an organic light-emitting element as specified in claims 9 to 13.

The present disclosure in its third aspect provides a display apparatus as specified in claim 14.

The present disclosure in its fourth aspect provides an image display apparatus as specified in claim 15.

The present disclosure in its fifth aspect provides a photoelectric conversion apparatus as specified in claim 16.

The present disclosure in its sixth aspect provides electronic equipment as specified in claim 17.

The present disclosure in its seventh aspect provides a lighting apparatus as specified in claim 18.

The present disclosure in its eighth aspect provides a moving body as specified in claim 19.

The present disclosure in its ninth aspect provides an image-forming apparatus as specified in claim 20.

Further features of the present disclosure will become apparent from the following description of exemplary embodiments with reference to the attached drawings.

### BRIEF DESCRIPTION OF THE DRAWINGS

Fig. 1 is a table of the optimized structures and the half-value widths of emission spectra of an exemplary compound and comparative compounds.
Fig. 2 is a table of the optimized structures and the half-value widths of emission spectra of exemplary compounds and a comparative compound.
Fig. 3 is a table of the external quantum efficiency (E.Q.E.) ratios and the luminance decay rate ratios in continuous operation of an exemplary compound and comparative compounds.
Fig. 4A is a schematic cross-sectional view of an example of a pixel of a display apparatus according to an embodiment of the present disclosure.
Fig. 4B is a schematic cross-sectional view of an example of a display apparatus including an organic light-emitting element according to an embodiment of the present disclosure.
Fig. 5 is a schematic view of an example of a display apparatus according to an embodiment of the present disclosure.
Fig. 6A is a schematic view of an example of an imaging apparatus according to an embodiment of the present disclosure.
Fig. 6B is a schematic view of an example of electronic equipment according to an embodiment of the present disclosure.
Fig. 7A is a schematic view of an example of a display apparatus according to an embodiment of the present disclosure.
Fig. 7B is a schematic view of an example of a foldable display apparatus.
Fig. 8A is a schematic view of an example of a lighting apparatus according to an embodiment of the present disclosure.
Fig. 8B is a schematic view of an example of a moving body with a vehicle lamp according to an embodiment of the present disclosure.
Fig. 9A is a schematic view of an example of a wearable device according to an embodiment of the present disclosure.
Fig. 9B is a schematic view of another example of a wearable device according to an embodiment of the present disclosure.
Fig. 10A is a schematic view of an example of an image-forming apparatus according to an embodiment of the present disclosure.
Fig. 10B is a schematic view of an example of an exposure light source of an image-forming apparatus according to an embodiment of the present disclosure.
Fig. 10C is a schematic view of an example of an exposure light source of an image-forming apparatus according to an embodiment of the present disclosure.

### DESCRIPTION OF THE EMBODIMENTS

### <<Organometallic Complex>>

An organometallic complex according to the present embodiment is represented by the following general formula [1]:

Ir(L)ₘ(L')ₙ [1]

wherein Ir denotes iridium.
L and L' denote different bidentate ligands.
m is 2, , and m + n = 3.

A plurality of L or L', if present, may be the same or different. In an organometallic complex according to another embodiment, ligands coordinated to the iridium metal may be different. For example, the organometallic complex may have a partial structure represented by the general formula [2-1] or [2-2], a ligand represented by the general formula [3], and a ligand represented by the general formula [4].

### <Partial Structure Ir(L)ₘ>

The partial structure Ir(L)ₘ is a partial structure represented by the following general formula [2-1] or [2-2].

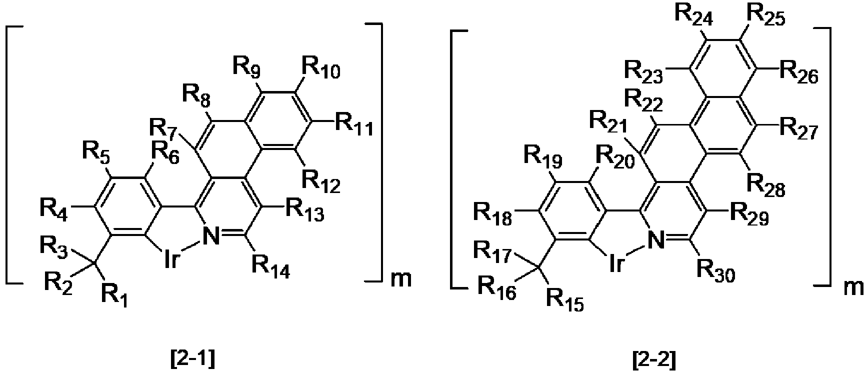

### [R₁ to R₃, R₁₅ to R₁₇]

In the formula [2-1], R₁ to R₃ are each independently selected from the group consisting of a hydrogen atom, a deuterium atom, a substituted or unsubstituted alkyl group, a substituted or unsubstituted alkoxy group, a substituted or unsubstituted silyl group, a substituted or unsubstituted aryl group, and a substituted or unsubstituted heteroaryl group, provided that at least one of R₁ to R₃ is not a hydrogen atom or a deuterium atom; and provided that, when two of R₁ to R₃ are a hydrogen atom or a deuterium atom, the other one of R₁ to R₃ is a substituted or unsubstituted secondary or higher alkyl group. At least two of R₁ to R₃ can be other than a hydrogen atom and a deuterium atom and can be a substituted or unsubstituted alkyl group.

In the formula [2-2], R₁₅ to R₁₇ are each independently selected from the group consisting of a hydrogen atom, a deuterium atom, a substituted or unsubstituted alkyl group, a substituted or unsubstituted alkoxy group, a substituted or unsubstituted silyl group, a substituted or unsubstituted aryl group, and a substituted or unsubstituted heteroaryl group, provided that at least one of R₁₅ to R₁₇ is not a hydrogen atom or a deuterium atom; and provided that, when two of R₁₅ to R₁₇ are a hydrogen atom or a deuterium atom, the other one of R₁₅ to R₁₇ is a substituted or unsubstituted secondary or higher alkyl group. At least two of R₁₅ to R₁₇ can be other than a hydrogen atom or a deuterium atom and can be a substituted or unsubstituted alkyl group.

The alkyl group can be an alkyl group with 1 or more and 10 or less carbon atoms or an alkyl group with 1 or more and 6 or less carbon atoms. More specifically, the alkyl group is, for example, a methyl group, an ethyl group, a n-propyl group, an i-propyl group, a n-butyl group, an i-butyl group, a sec-butyl group, a tert-butyl group, a n-pentyl group, an i-pentyl group, a tert-pentyl group, a neopentyl group, a 3-pentyl group, a n-hexyl group, or a cyclohexyl group. Among these, a methyl group, an i-propyl group, and a tert-butyl group may be mentioned.

The alkoxy group may be more specifically a methoxy group, an ethoxy group, an i-propoxy group, a n-butoxy group, a tert-butoxy group, or the like and can be a methoxy group.

The silyl group is, for example, but not limited to, a trimethylsilyl group, a triphenylsilyl group, or the like.

The aryl group may be more specifically a phenyl group, a naphthyl group, a phenanthryl group, an anthryl group, a fluorenyl group, a biphenylenyl group, an acenaphthylenyl group, a chrysenyl group, a pyrenyl group, a triphenylenyl group, a picenyl group, a fluoranthenyl group, a perylenyl group, a naphthacenyl group, a biphenyl group, a terphenyl group, or the like. Among these, a phenyl group, a naphthyl group, a fluorenyl group, or a biphenyl group may be mentioned, and a phenyl group may be mentioned.

The heteroaryl group may be more specifically a thienyl group, a pyrrolyl group, a pyrazinyl group, a pyridyl group, an indolyl group, a quinolyl group, an isoquinolyl group, a naphthyridinyl group, an acridinyl group, a phenanthrolinyl, a carbazolyl group, a benzo[a]carbazolyl group, a benzo[b]carbazolyl group, a benzo[c]carbazolyl group, a phenazinyl group, a phenoxazinyl group, a phenothiazinyl, a benzothiophenyl group, a dibenzothiophenyl group, a benzofuranyl group, a dibenzofuranyl group, an oxazolyl group, an oxadiazolyl group, or the like.

An optional substituent of the alkyl group, the alkoxy group, the silyl group, the aryl group, and the heteroaryl group is, for example, but not limited to, a deuterium atom, a fluorine atom, an alkyl group, such as a methyl group, an ethyl group, a n-propyl group, an i-propyl group, a n-butyl group, an i-butyl group, a sec-butyl group, a tert-butyl group, a n-pentyl group, an i-pentyl group, a tert-pentyl group, a neopentyl group, a n-hexyl group, or a cyclohexyl group; an alkoxy group, such as a methoxy group, an ethoxy group, an i-propoxy group, a n-butoxy group, or a tert-butoxy group; an amino group, such as an N-methylamino group, an N-ethylamino group, an N,N-dimethylamino group, an N,N-diethylamino group, an N-methyl-N-ethylamino group, an N-benzylamino group, an N-methyl-N-benzylamino group, an N,N-dibenzylamino group, an anilino group, an N,N-diphenylamino group, an N,N-dinaphthylamino group, an N,N-difluorenylamino group, an N-phenyl-N-tolylamino group, an N,N-ditolylamino group, an N-methyl-N-phenylamino group, an N,N-dianisolylamino group, an N-mesityl-N-phenylamino group, an N,N-dimesitylamino group, an N-phenyl-N-(4-tert-butylphenyl)amino group, or an N-phenyl-N-(4-trifluoromethylphenyl)amino group; an aryl group, such as a phenyl group, a naphthyl group, a phenanthryl group, an anthryl group, a fluorenyl group, a biphenylenyl group, an acenaphthylenyl group, a chrysenyl group, a pyrenyl group, a triphenylenyl group, a picenyl group, a fluoranthenyl group, a perylenyl group, a naphthacenyl group, a biphenyl group, or a terphenyl group; a heterocyclic group, such as a thienyl group, a pyrrolyl group, a pyrazinyl group, a pyridyl group, an indolyl group, a quinolyl group, an isoquinolyl group, a naphthyridinyl group, an acridinyl group, a phenanthrolinyl, a carbazolyl group, a benzo[a]carbazolyl group, a benzo[b]carbazolyl group, a benzo[c]carbazolyl group, a phenazinyl group, a phenoxazinyl group, a phenothiazinyl group, a benzothiophenyl group, a dibenzothiophenyl group, a benzofuranyl group, a dibenzofuranyl group, an oxazolyl group, or an oxadiazolyl group; a cyano group, a trifluoromethyl group, a thiol group, or the like. A hydrogen atom of these optional substituents may be replaced with a deuterium atom.

An optional substituent of the alkyl group, the alkoxy group, the silyl group, the aryl group, and the heteroaryl group can be a deuterium atom, a methyl group, an i-propyl group, a tert-butyl group, a methoxy group, an N,N-dimethylamino group, an N,N-diphenylamino group, a phenyl group, a naphthyl group, a fluorenyl group, a biphenyl group, or a terphenyl group, particularly a deuterium atom, a methyl group, an i-propyl group, a tert-butyl group, or a phenyl group.

Adjacent R₁ to R₃ may be bonded together to form a ring, and adjacent R₁₅ to R₁₇ may be bonded together to form a ring. More specifically, for example, adjacent R₁ to R₃ or adjacent R₁₅ to R₁₇ may be bonded together to form a cycloalkyl group, such as a cyclohexyl group.

### [R₄ to R₁₄, R₁₈ to R₃₀]

In the formula [2-1], R₄ to R₁₄ are each independently selected from the group consisting of a hydrogen atom, a deuterium atom, a halogen atom, a substituted or unsubstituted alkyl group, a substituted or unsubstituted alkoxy group, a substituted or unsubstituted silyl group, a substituted or unsubstituted amino group, a substituted or unsubstituted allyl group, a substituted or unsubstituted aryl group, a substituted or unsubstituted heteroaryl group, a substituted or unsubstituted aryloxy group, a substituted or unsubstituted heteroaryloxy group, and a cyano group. R₅ can be other than a hydrogen atom and a deuterium atom and can be the same group as - CR₁(R₂)(R₃).

In the formula [2-2], R₁₈ to R₃₀ are each independently selected from the group consisting of a hydrogen atom, a deuterium atom, a halogen atom, a substituted or unsubstituted alkyl group, a substituted or unsubstituted alkoxy group, a substituted or unsubstituted silyl group, a substituted or unsubstituted amino group, a substituted or unsubstituted allyl group, a substituted or unsubstituted aryl group, a substituted or unsubstituted heteroaryl group, a substituted or unsubstituted aryloxy group, a substituted or unsubstituted heteroaryloxy group, and a cyano group. R₁₉ can be other than a hydrogen atom and a deuterium atom and can be the same group as - CR₁₅(R₁₆)(R₁₇).

The alkyl group, the alkoxy group, the silyl group, the aryl group, and the heteroaryl group denoted by R₄ to R₁₄ and R₁₈ to R₃₀ may be the same as those described for R₁ to R₃ and R₁₅ to R₁₇.

The amino group may be more specifically an N-methylamino group, an N-ethylamino group, an N,N-dimethylamino group, an N,N-diethylamino group, an N-methyl-N-ethylamino group, an N-benzylamino group, an N-methyl-N-benzylamino group, an N,N-dibenzylamino group, an anilino group, an N,N-diphenylamino group, an N,N-dinaphthylamino group, an N,N-difluorenylamino group, an N-phenyl-N-tolylamino group, an N,N-ditolylamino group, an N-methyl-N-phenylamino group, an N,N-dianisolylamino group, an N-mesityl-N-phenylamino group, an N,N-dimesitylamino group, an N-phenyl-N-(4-tert-butylphenyl)amino group, an N-phenyl-N-(4-trifluoromethylphenyl)amino group, or the like. Among these, an N,N-dimethylamino group and an N,N-diphenylamino group may be mentioned.

The aryloxy group is, for example, but not limited to, a phenoxy group, a naphthoxy group, or the like.

The heteroaryloxy group is, for example, but not limited to, a furanyloxy group, a thienyloxy group, or the like.

Optional substituents of the alkyl group, the alkoxy group, the silyl group, the amino group, the allyl group, the aryl group, the heteroaryl group, the aryloxy group, and the heteroaryloxy group denoted by R₄ to R₁₄ and R₁₈ to R₃₀ may be the same as those described for R₁ to R₃ and R₁₅ to R₁₇.

Adjacent R₄ to R₁₄ may be bonded together to form a ring, and adjacent R₁₈ to R₃₀ may be bonded together to form a ring. To be bonded together to form a ring means a ring formed by adjacent Rs bonding together and also means that rings to which adjacent Rs are bonded form a fused ring. A ring formed by Rs bonding together may be an aromatic ring.

### <L'>

L' denotes a bidentate ligand represented by the following general formula [3] or [4].

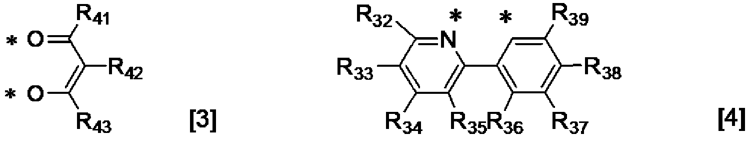

### [R₄₁ to R₄₃]

In the formula [3], R₄₁ to R₄₃ are each independently selected from the group consisting of a hydrogen atom, a deuterium atom, a fluorine atom, a substituted or unsubstituted alkyl group, a substituted or unsubstituted alkoxy group, a substituted or unsubstituted amino group, a substituted or unsubstituted aryl group, and a substituted or unsubstituted heteroaryl group. R₄₁ to R₄₃ can be a hydrogen atom, a deuterium atom, or a substituted or unsubstituted alkyl group. Adjacent R₄₁ to R₄₃ may be bonded together to form a ring.

The alkyl group, the alkoxy group, the amino group, the aryl group, and the heteroaryl group denoted by R₄₁ to R₄₃ may be the same as those described for R₁ to R₃, R₁₅ to R₁₇, R₄ to R₁₄, and R₁₈ to R₃₀. Optional substituents of the alkyl group, the alkoxy group, the amino group, the aryl group, and the heteroaryl group may be the same as those described for R₁ to R₃ and R₁₅ to R₁₇.

### [R₃₂ to R₃₉]

In the formula [4], R₃₂ to R₃₉ are each independently selected from the group consisting of a hydrogen atom, a deuterium atom, a fluorine atom, a substituted or unsubstituted alkyl group, a substituted or unsubstituted alkoxy group, a substituted or unsubstituted amino group, a substituted or unsubstituted allyl group, a substituted or unsubstituted aryl group, and a substituted or unsubstituted heteroaryl group.

The alkyl group, the alkoxy group, the amino group, the aryl group, and the heteroaryl group denoted by R₃₂ to R₃₉ may be the same as those described for R₁ to R₃, R₁₅ to R₁₇, R₄ to R₁₄, and R₁₈ to R₃₀. Optional substituents of the alkyl group, the alkoxy group, the amino group, the allyl group, the aryl group, and the heteroaryl group may be the same as those described for R₁ to R₃ and R₁₅ to R₁₇.

Adjacent R₃₂ to R₃₉ may be bonded together to form a ring. To be bonded together to form a ring means the same as that described for R₄ to R₁₄ and R₁₈ to R₃₀.

### <Synthesis Method>

Next, a method for synthesizing the organometallic complex according to the present embodiment is described. The organometallic complex according to the present embodiment is synthesized, for example, in accordance with a reaction scheme 1 or 2 shown below.

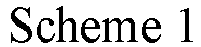

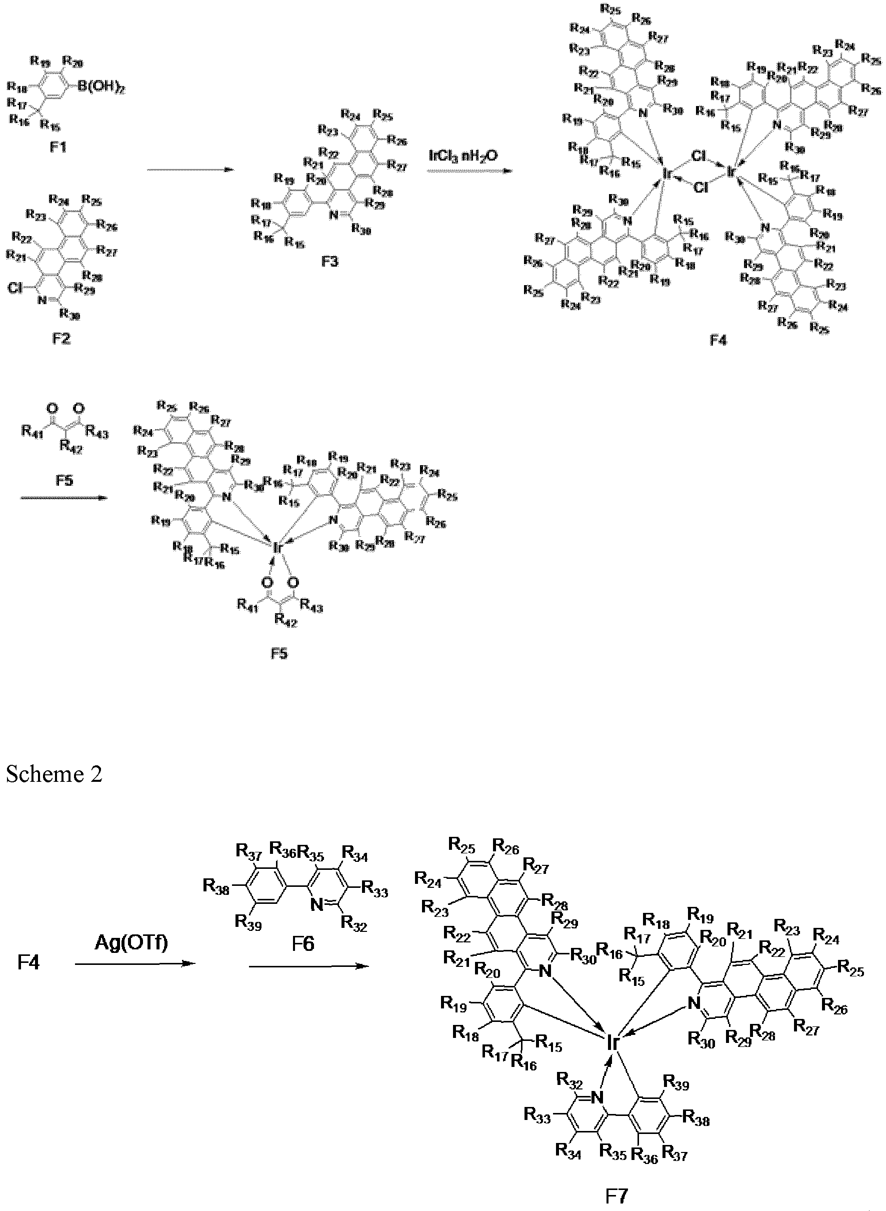

In the synthesis schemes 1 and 2 of the organometallic complex according to the present embodiment, the following (c) or (d) is synthesized via (a) and (b).
(a) Ligand derivative (F3)
(b) Dichloro dimer derivative (F4)
(c) Acetylacetone derivative ligand complex (F5)
(d) ppy derivative ligand complex (F7)

In the synthesis schemes 1 and 2, various exemplary compounds can be synthesized by changing F1, F2, F5, and F6.

The method for synthesizing the organometallic complex according to the present embodiment is not limited to these synthesis schemes and may be a known method using various synthesis reagents.

### <Properties>

In the disclosure of the organometallic complex represented by the general formula [1], the present inventors have focused on the type and position of a substituent of a ligand of the organometallic complex.

The organometallic complex according to the present embodiment has a bulky substituent at an ortho position with respect to the binding position of the benzene ring of the main ligand L to Ir (hereinafter sometimes referred to simply as "an ortho position of the benzene ring of the main ligand L") and is therefore a stable compound that emits red light with high efficiency and high color purity.

The properties of the organometallic complex according to the present embodiment are described below as compared with a comparative compound with a structure similar to that of the organometallic complex according to the present embodiment. More specifically, the properties of an exemplary compound CC1 according to the present disclosure are described below using the following comparative compound 1-a and comparative compound 2-a as comparative compounds.

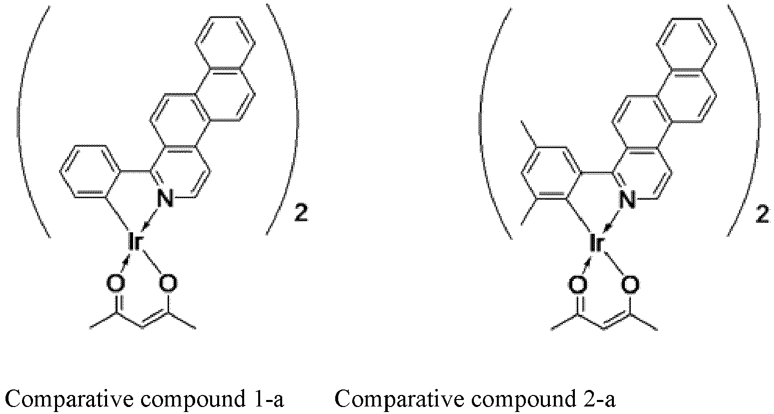

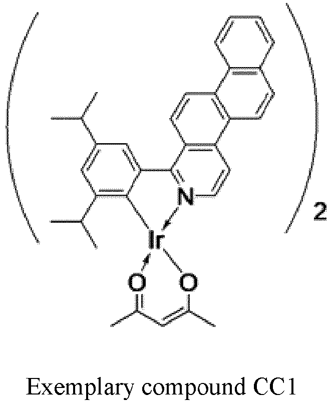

The comparative compound 1-a is a compound with no substituent at the ortho position of the benzene ring of the main ligand L. The comparative compound 2-a is a compound with a methyl group at the ortho position of the benzene ring of the main ligand L, that is, a compound represented by the formula [2-2] in which R₁₅ to R₁₇ are all hydrogen atoms. On the other hand, the exemplary compound CC1 is a compound with an isopropyl group at the ortho position of the benzene ring of the main ligand L, that is, a compound represented by the formula [2-2] in which one of R₁₅ to R₁₇ is a hydrogen atom and the other two are methyl groups.
(1) The main ligand L has less vibration and provides an emission spectrum with a narrow half-value width.

The present inventors have found that a bulky substituent at the ortho position of the benzene ring of the main ligand L reduces the vibration of the main ligand L and provides an emission spectrum with a narrow half-value width.

Even if an emission spectrum has the same maximum peak wavelength, a narrower half-value width results in improved color purity. In the present embodiment, a half-value width for high color purity is a half-value width of less than 40 nm of an emission spectrum in a dilute solution.

The skeleton of benzoisoquinoline, naphthoisoquinoline, or the like constituting the main ligand L emits good red light by itself. However, it is difficult to satisfy the color purity of red light emission according to BT-2020 by itself. Thus, in addition to the baseline characteristics, an attempt was made to reduce the half-value width of an emission spectrum and thereby achieve red light emission with high color purity. In the CIE coordinates, preferably, the X coordinate is 0.68 or more, and the Y coordinate is 0.33 or less. Materials with high color purity can be used to provide a light-emitting element that satisfies the color purity of red light emission according to BT-2020.

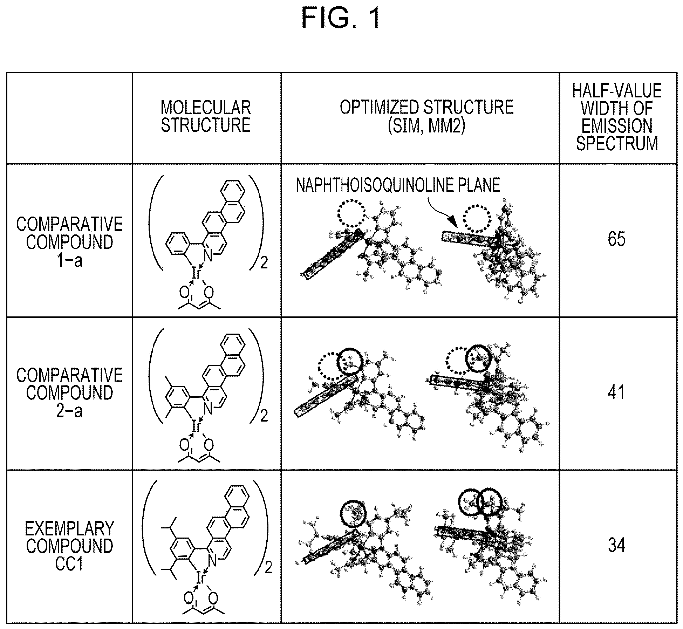

The present inventors compared the half-value widths of actually measured emission spectra of the comparative compound 1-a, the comparative compound 2-a, and the exemplary compound CC1. Fig. 1 shows the results. The emission wavelength was measured with F-4500 manufactured by Hitachi, Ltd. in photoluminescence (PL) measurement of a diluted toluene solution at room temperature and at an excitation wavelength of 350 nm. To explain this phenomenon, figures of optimized structure calculation results by MM2 of Chem3D are also shown.

As shown in Fig. 1, the comparative compound 1-a has a half-value width as wide as 65 nm and has low color purity. The comparative compound 2-a with a methyl group at the ortho position of the benzene ring of the main ligand L has a half-value width of 41 nm and has improved color purity but does not have desired color purity. By contrast, the exemplary compound CC1 with a bulky isopropyl group at the ortho position of the benzene ring of the main ligand L has a half-value width of 34 nm, which is characteristic of a desired high color purity region, and therefore emits long-wavelength red light suitable for a red color of a display standard, such as BT-2020.

The details are described below. The present inventors have found that a bulky substituent introduced at the ortho position of the benzene ring of the main ligand L reduces the half-value width of an emission spectrum of the comparative compound 1-a.

As shown in the figure of the optimized structure of Fig. 1, the comparative compound 1-a does not have a substituent at the ortho position of the benzene ring of the main ligand L, so that the main ligand plane containing the naphthoisoquinoline skeleton can vibrate freely. Thus, many vibrational levels are generated and broaden the emission spectrum.

In the comparative compound 2-a, due to its steric hindrance effect, the methyl group introduced at the ortho position of the benzene ring of the main ligand L slightly limits the vibration of the main ligand plane containing the naphthoisoquinoline skeleton. This reduces the vibration level and narrows the emission spectrum but still cannot achieve desired color purity.

In the exemplary compound CC1, due to its significant steric hindrance effect, the isopropyl group introduced at the ortho position of the benzene ring of the main ligand L considerably limits the vibration of the main ligand plane containing the naphthoisoquinoline skeleton. This is found to greatly reduce the vibration level and provide a desired narrowed emission spectrum.

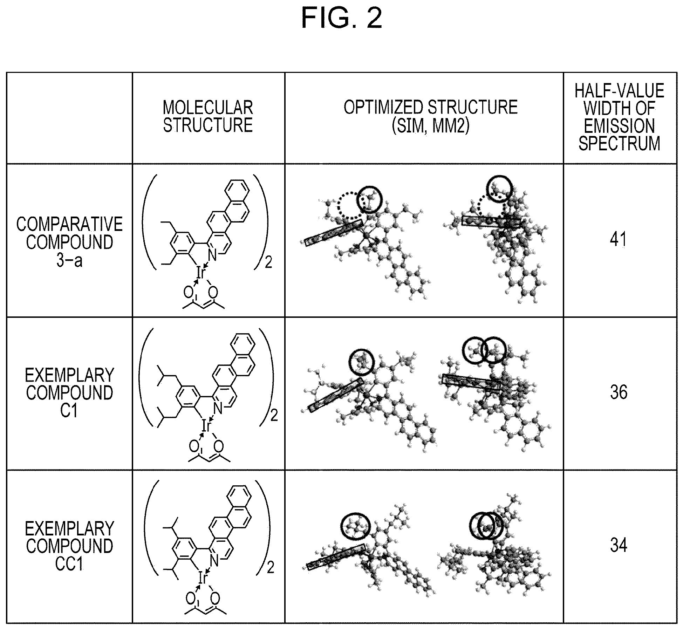

In the formulae [2-1] and [2-2] of the organometallic complex according to the present embodiment, when two of R₁ to R₃ or two of R₁₅ to R₁₇ are a hydrogen atom or a deuterium atom, the other one of R₁ to R₃ or R₁₅ to R₁₇ is a secondary or higher alkyl group; and at least two of R₁ to R₃ or at least two of R₁₅ to R₁₇ can be other than a hydrogen atom or a deuterium atom. These points are described below with reference to Fig. 2.

Fig. 2 shows the optimized structures and the half-value widths of emission spectra of a comparative compound 3-a with an ethyl group at the ortho position of the benzene ring of the main ligand L, an exemplary compound C1 with an isobutyl group at the ortho position of the benzene ring of the main ligand L, and the exemplary compound CC 1 with an isopropyl group at the ortho position of the benzene ring of the main ligand L.

The comparative compound 3-a is a compound with an ethyl group at the ortho position of the benzene ring of the main ligand L, that is, a compound represented by the formula [2-2] in which two of R₁₅ to R₁₇ are hydrogen atoms and the other is a methyl group. On the other hand, the exemplary compound C1 is a compound with an isobutyl group at the ortho position of the benzene ring of the main ligand L, that is, a compound represented by the formula [2-2] in which two of R₁₅ to R₁₇ are hydrogen atoms and the other is an isopropyl group. As described above, the exemplary compound CC 1 is a compound with an isopropyl group at the ortho position of the benzene ring of the main ligand L, that is, a compound represented by the formula [2-2] in which one of R₁₅ to R₁₇ is a hydrogen atom and the other two are methyl groups.

As shown in Fig. 2, in the comparative compound 3-a represented by the formula [2-2] in which two of R₁₅ to R₁₇ are hydrogen atoms and the other is a methyl group, the vibration of the main ligand L plane is not sufficiently suppressed, and the emission spectrum is not sufficiently narrowed.

On the other hand, in the exemplary compound C1 represented by the formula [2-2] in which two of R₁₅ to R₁₇ are hydrogen atoms and the other is an isopropyl group, the substituent at the ortho position of the benzene ring of the main ligand L is larger than that of the comparative compound 3-a. In the exemplary compound C1, this can reduce the vibration of the main ligand L plane and narrows the emission spectrum.

Furthermore, the exemplary compound CC1 represented by the formula [2-2] in which one of R₁₅ to R₁₇ is a hydrogen atom and the other two are methyl groups is bulkier around the carbon atom directly bonded to the ortho position of the benzene ring of the main ligand L than the exemplary compound C1. In the exemplary compound CC1, this can further reduce the vibration of the main ligand L plane and further narrows the emission spectrum.

Thus, the organometallic complex according to the present embodiment can emit red light with high color purity.

(2) The Ir atom, which is the central metal atom, is protected, and an increase in intermolecular distance reduces triplet exciton-triplet exciton annihilation (TTA) and improves the element efficiency and element durability.

The present inventors have found that a bulky substituent at the ortho position of the benzene ring of the main ligand L protects the Ir atom, which is the central metal atom, and increases the intermolecular distance, thereby reducing TTA and improving the element efficiency and element durability.

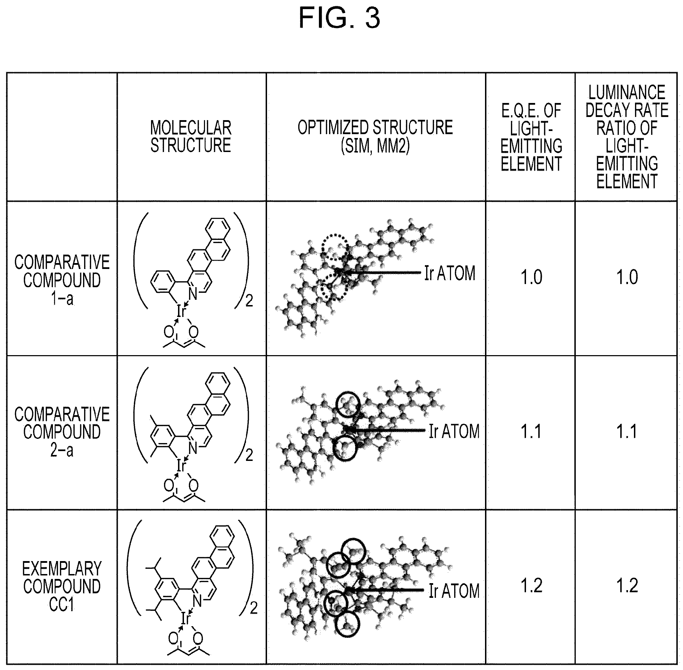

Fig. 3 shows the external quantum efficiency (E.Q.E.) ratios of a red-light-emitting element described later in an exemplary embodiment and the luminance decay rate ratios in continuous operation of the comparative compound 1-a, the comparative compound 2-a, and the exemplary compound CC1.

The present inventors have found the following. A bulky substituent at the ortho position of the benzene ring of the main ligand L provides a substituent unit near the Ir atom. This protects the Ir atom, increases the intermolecular distance while the thickness of the film is decreased, reduces triplet exciton-triplet exciton annihilation (TTA), and improves the E.Q.E. and durability of an organic light-emitting element.

In an organic light-emitting element, the organometallic complex according to the present embodiment can be suitably used as a light-emitting material, and a host material is typically doped with a few percent of the organometallic complex. In such a case, the organometallic complex serving as a light-emitting material can be uniformly dispersed in a thin film constituting a light-emitting layer, and the distance between the organometallic complex molecules can be increased. This is described below.

In an organic light-emitting element, an exciton generated by recombination of a hole and an electron in a light-emitting layer can be efficiently emitted from a light-emitting material. In the recombination, a singlet exciton and a triplet exciton are generated at a ratio of 1:3. The triplet exciton has a long excitation lifetime and can be efficiently emitted before being used in a process other than light emission. One process other than light emission is TTA. This results in the generation of a singlet exciton due to a collision between a triplet exciton and a triplet exciton and results in deactivation from transition to a higher excited state. Furthermore, TTA is significantly influenced by the intermolecular distance, and the probability of TTA increases exponentially as the distance decreases.

In a light-emitting layer, an organometallic complex serving as a light-emitting material has the lowest excitation energy, and a triplet exciton is therefore likely to be present on the organometallic complex. Thus, as organometallic complex molecules get closer to each other, energy loss or degradation due to TTA is more likely to occur. Thus, this results in a decrease in efficiency and a deterioration in durability.

The present inventors have attempted to introduce a bulky substituent to increase the distance between Ir complex molecules, particularly between Ir atoms, in the light-emitting layer.

As shown in Fig. 3, the comparative compound 1-a does not have a substituent at the ortho position of the benzene ring of the main ligand L, and there is a space near the Ir atom. Thus, the intermolecular distance in a thin film tends to decrease.

In the comparative compound 2-a, due to its steric hindrance effect, the methyl group introduced at the ortho position of the benzene ring of the main ligand L slightly protects the vicinity of the Ir atom. This increases the intermolecular distance as compared with the comparative compound 1-a.

On the other hand, in the exemplary compound CC1, the isopropyl group is introduced at the ortho position of the benzene ring of the main ligand L and has a significant steric hindrance effect, and the substituent unit protects the vicinity of the Ir atom. This greatly increases the intermolecular distance in a thin film, can reduce TTA, and can achieve high efficiency and durability.

Thus, in the organometallic complex according to the present embodiment, the bulky substituent at the ortho position of the benzene ring of the main ligand L increases the intermolecular distance. Thus, when used as a light-emitting material for an organic light-emitting element, the organometallic complex according to the present embodiment can reduce TTA and provide high element efficiency and operational durability.

(3) Sublimability is improved.

The organometallic complex according to the present embodiment is a compound with a bulky substituent at the ortho position of the benzene ring of the main ligand L. This reduces the intermolecular interaction. A decrease in intermolecular interaction results in improved sublimability.

The improvement in sublimability enables a material to be purified by sublimation purification and an organic light-emitting element to be produced by vapor deposition. This can decrease impurities contained in an organic light-emitting element and reduce a decrease in luminescence efficiency and operational durability due to impurities. Concentration quenching can be reduced to improve the luminescence efficiency of an organic light-emitting element.

### (4) Other Properties

In the organometallic complex according to the present embodiment, a halogen atom, a deuterium atom, an alkyl group, an allyl group, an aryl group, or a silyl group in the basic skeleton can reduce concentration quenching. Such substitution can provide a compound with improved sublimability at the time of sublimation and improved solvent solubility at the time of coating.

In the organometallic complex according to the present embodiment, a heteroatom-containing substituent, that is, a halogen atom, an alkoxy group, an amino group, a heteroaryl group, an aryloxy group, a heteroaryloxy group, or a cyano group in the basic skeleton can further impart electron-donating and electron-withdrawing effects to the ligand and the Ir atom. These substituents can more easily provide a compound with an adjusted emission wavelength.

### <Specific Examples>

Specific examples of an organometallic complex according to the present disclosure are described below. However, the present disclosure is not limited to these examples.

Complexes B5 to B24, BB1 to BB24, D5 to D24 and DD1 to DD24 are comparative examples which do not fall within the scope of the claims.

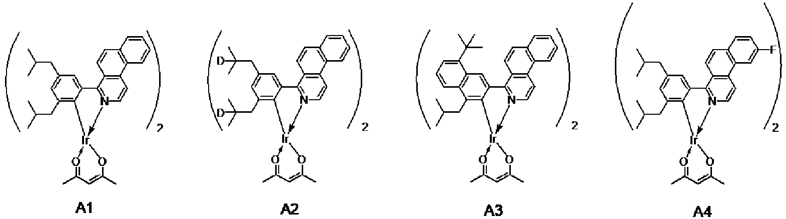

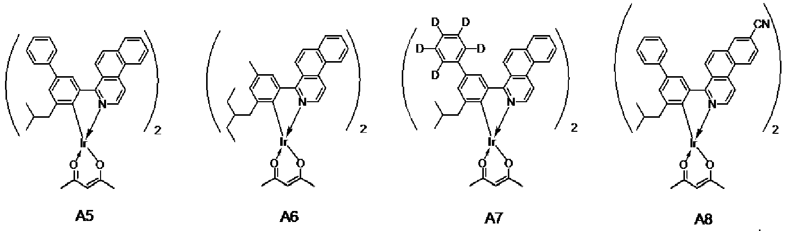

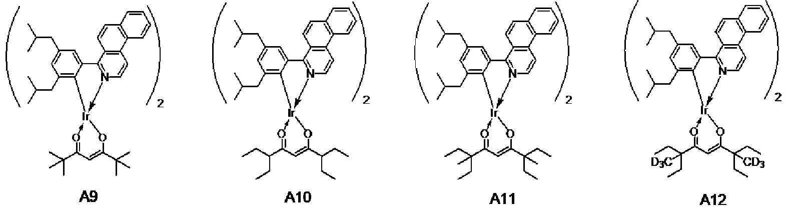

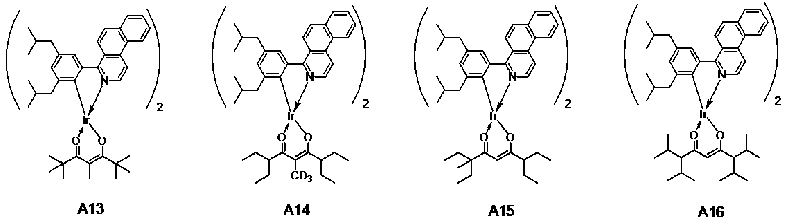

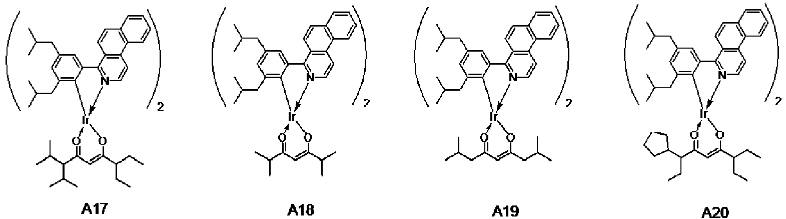

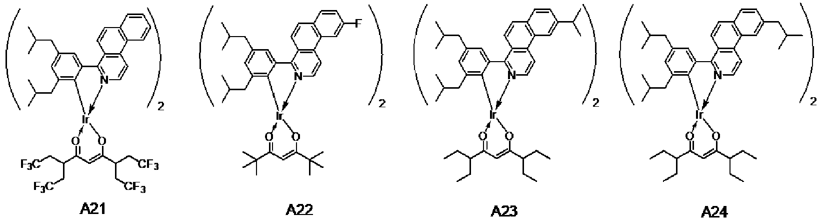

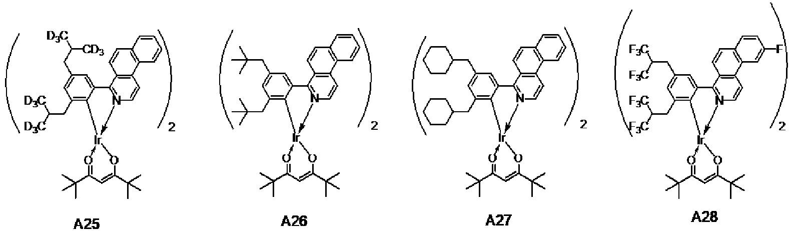

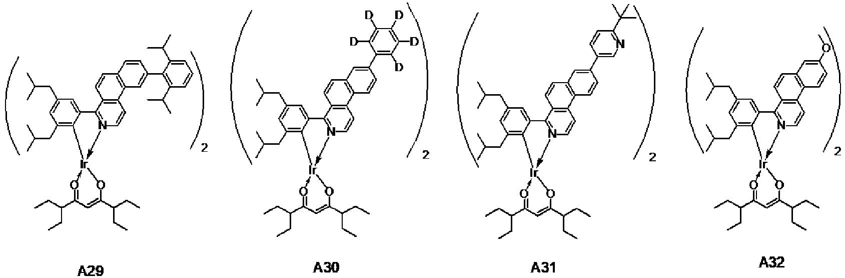

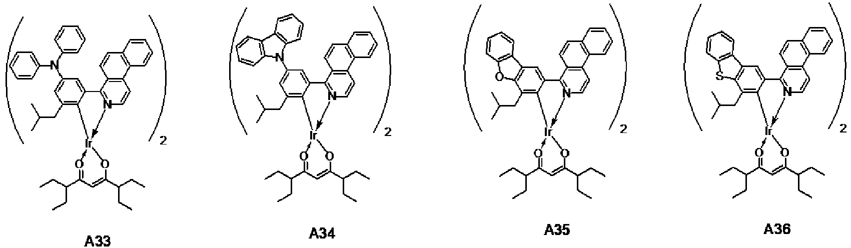

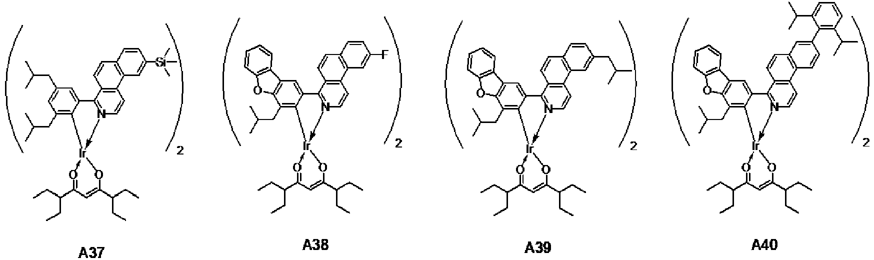

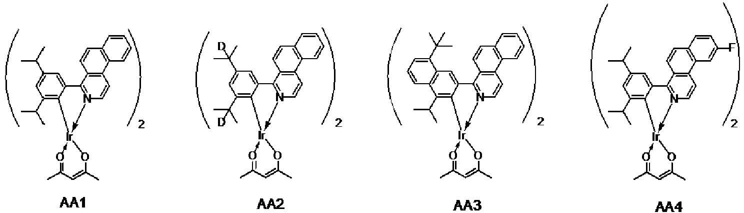

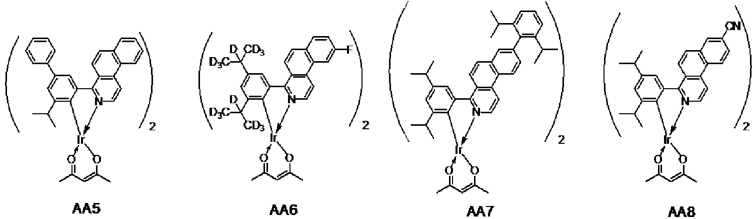

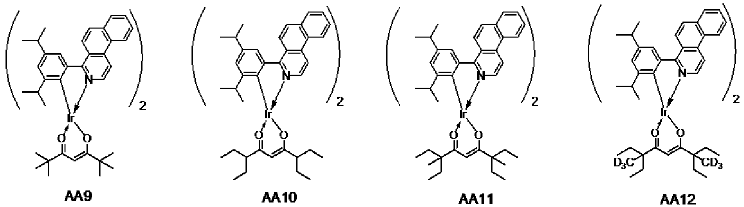

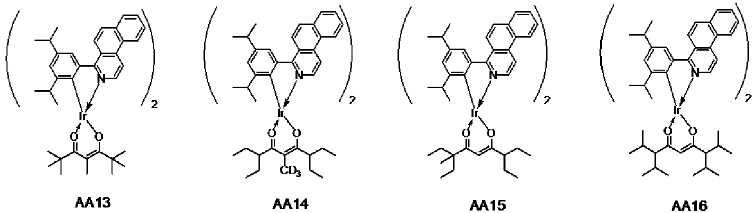

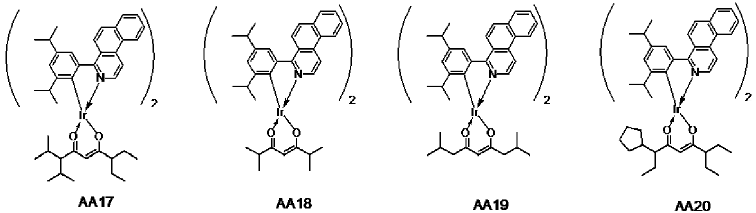

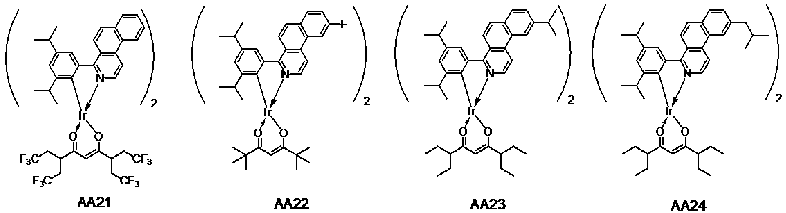

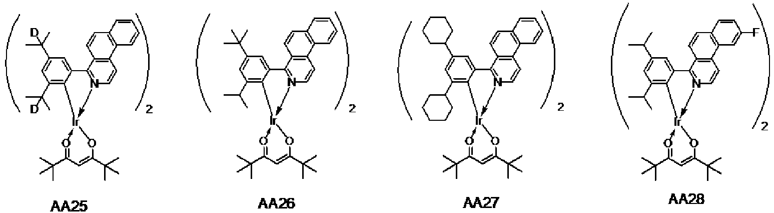

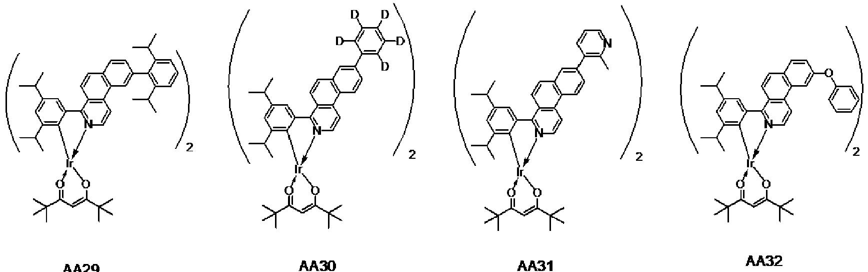

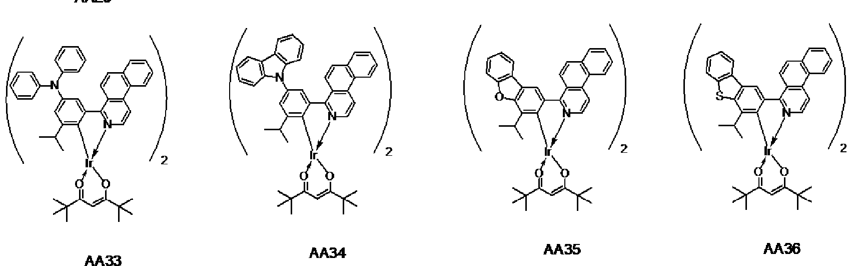

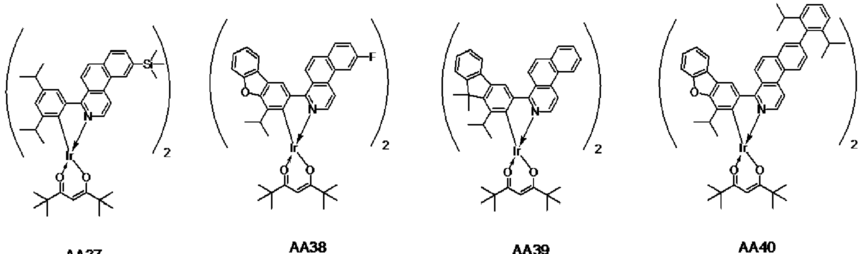

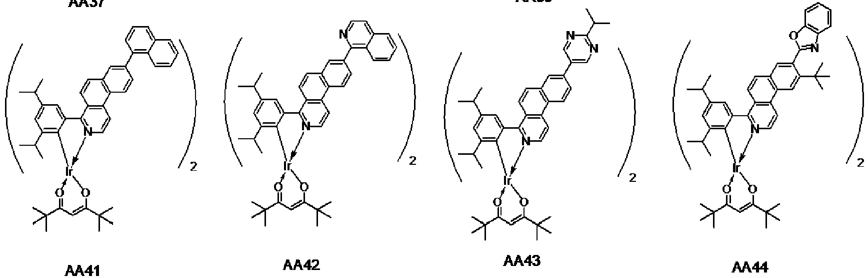

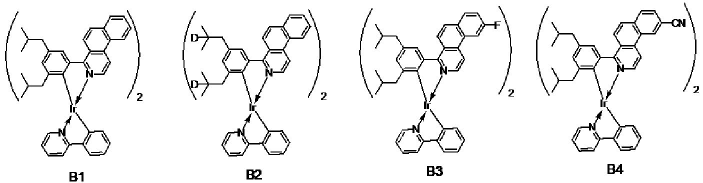

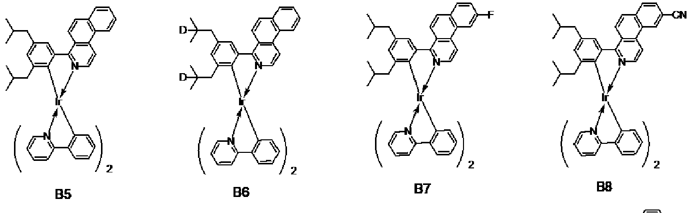

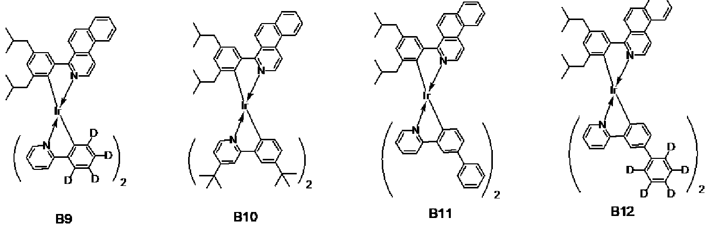

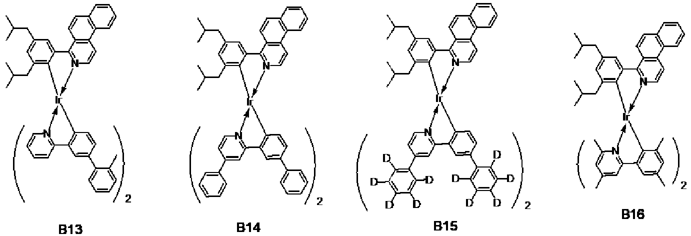

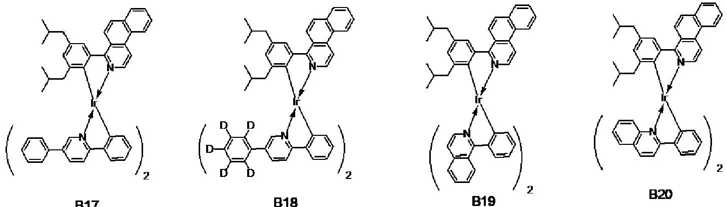

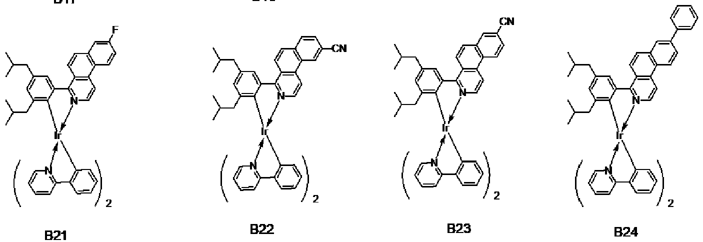

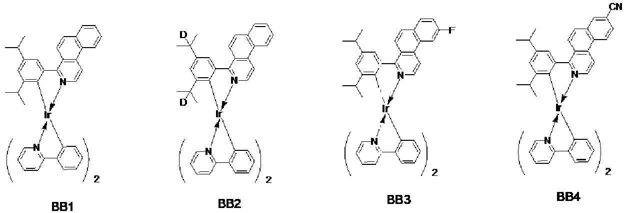

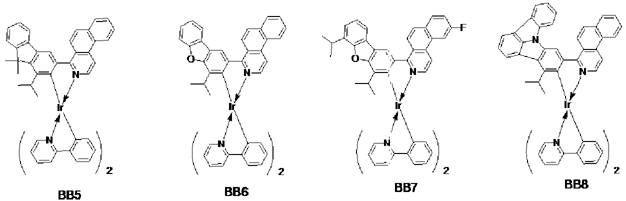

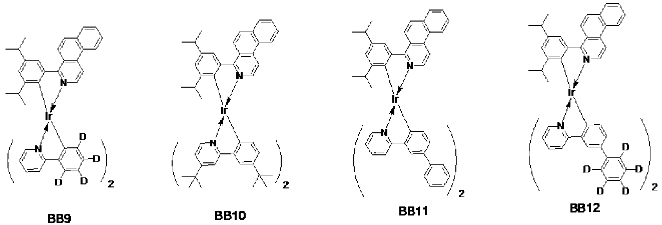

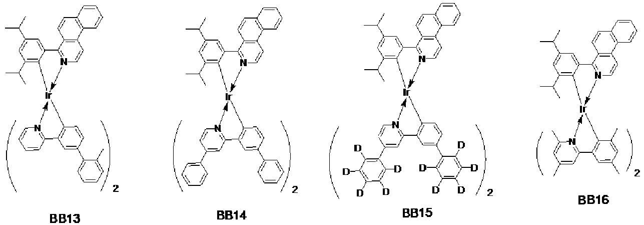

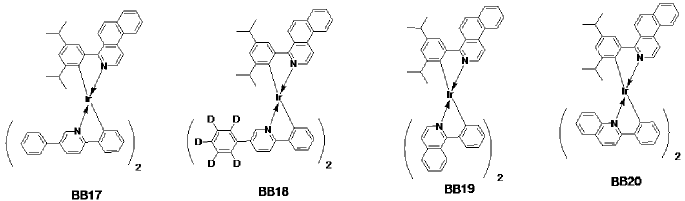

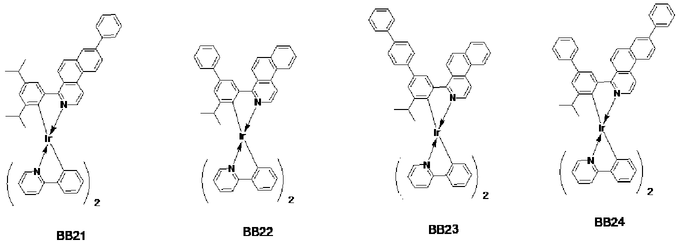

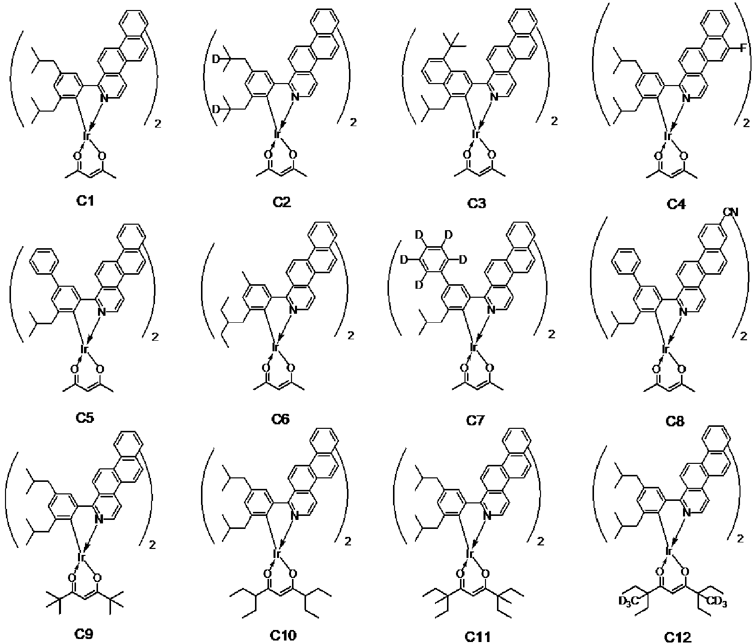

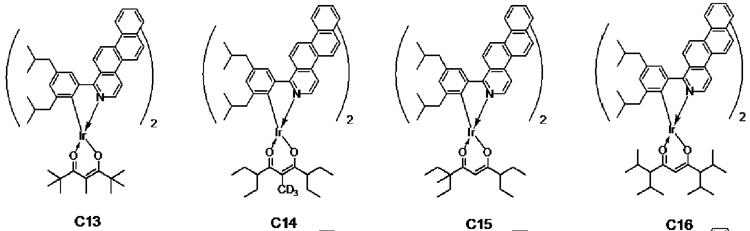

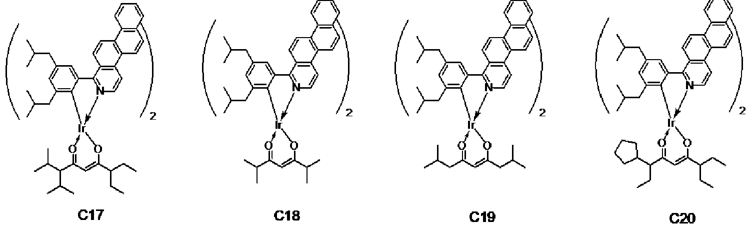

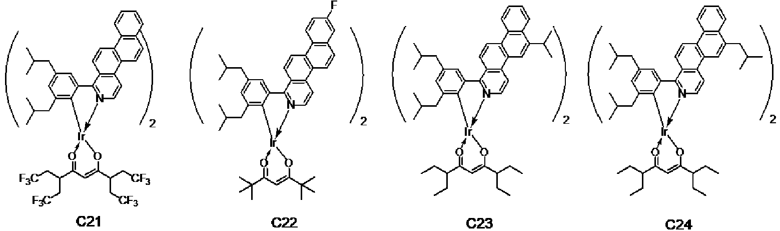

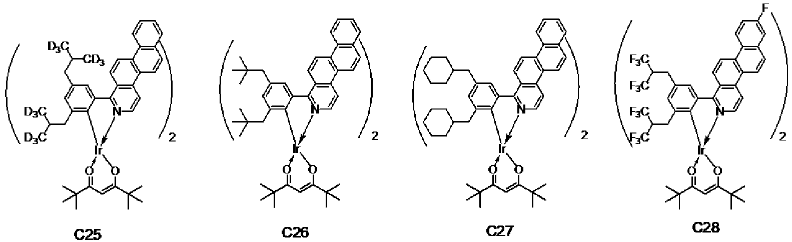

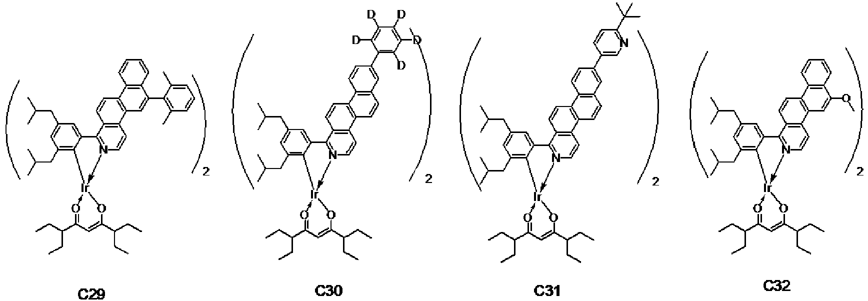

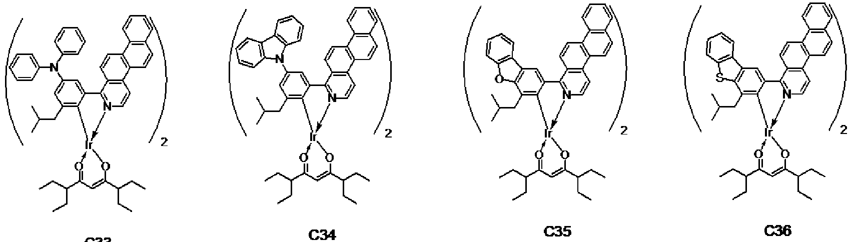

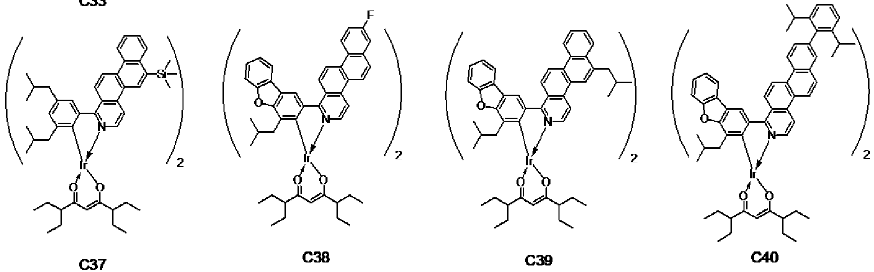

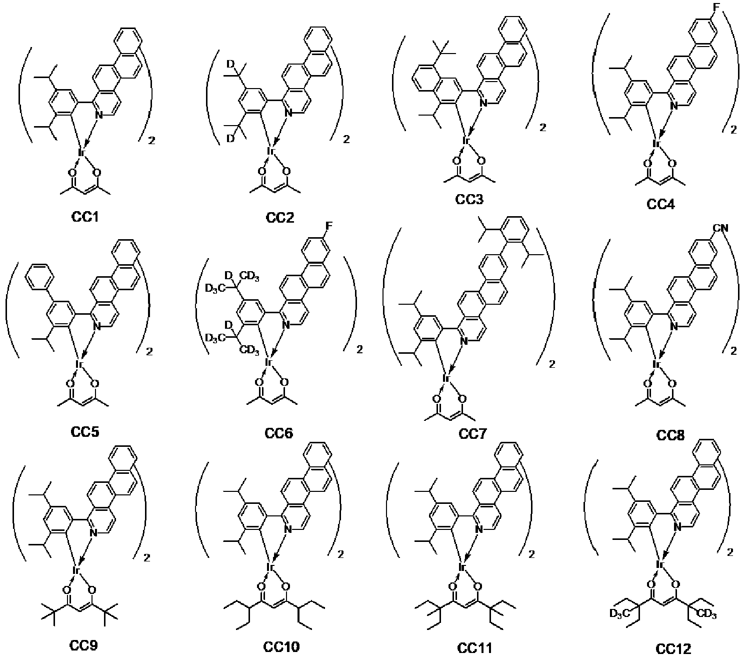

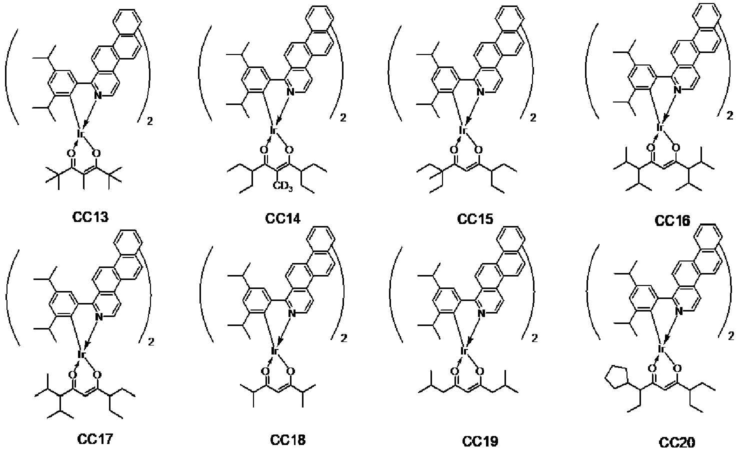

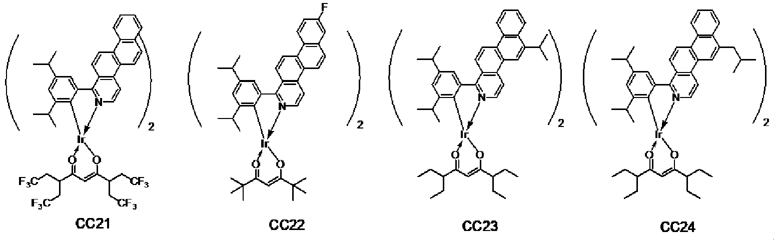

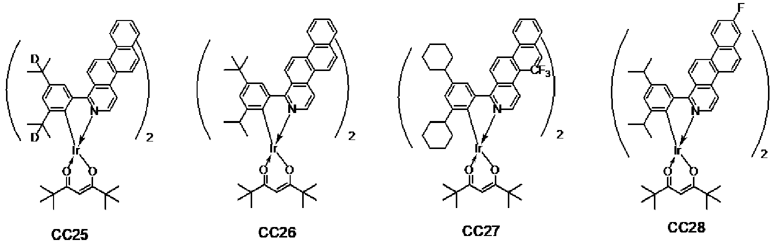

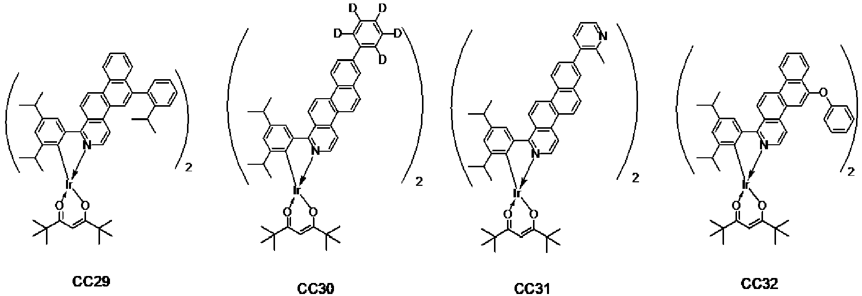

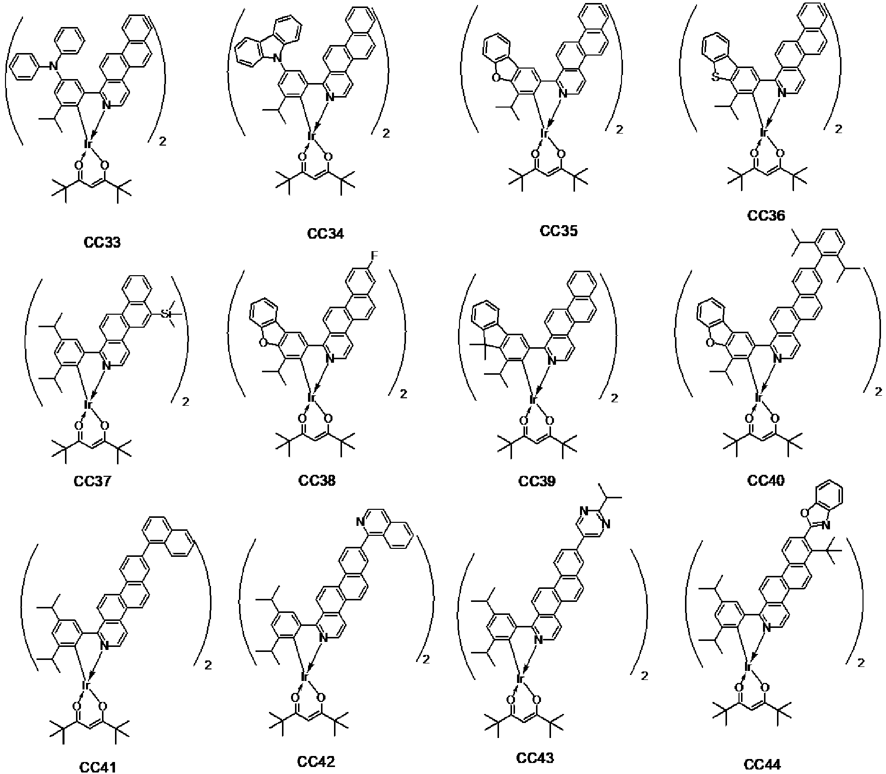

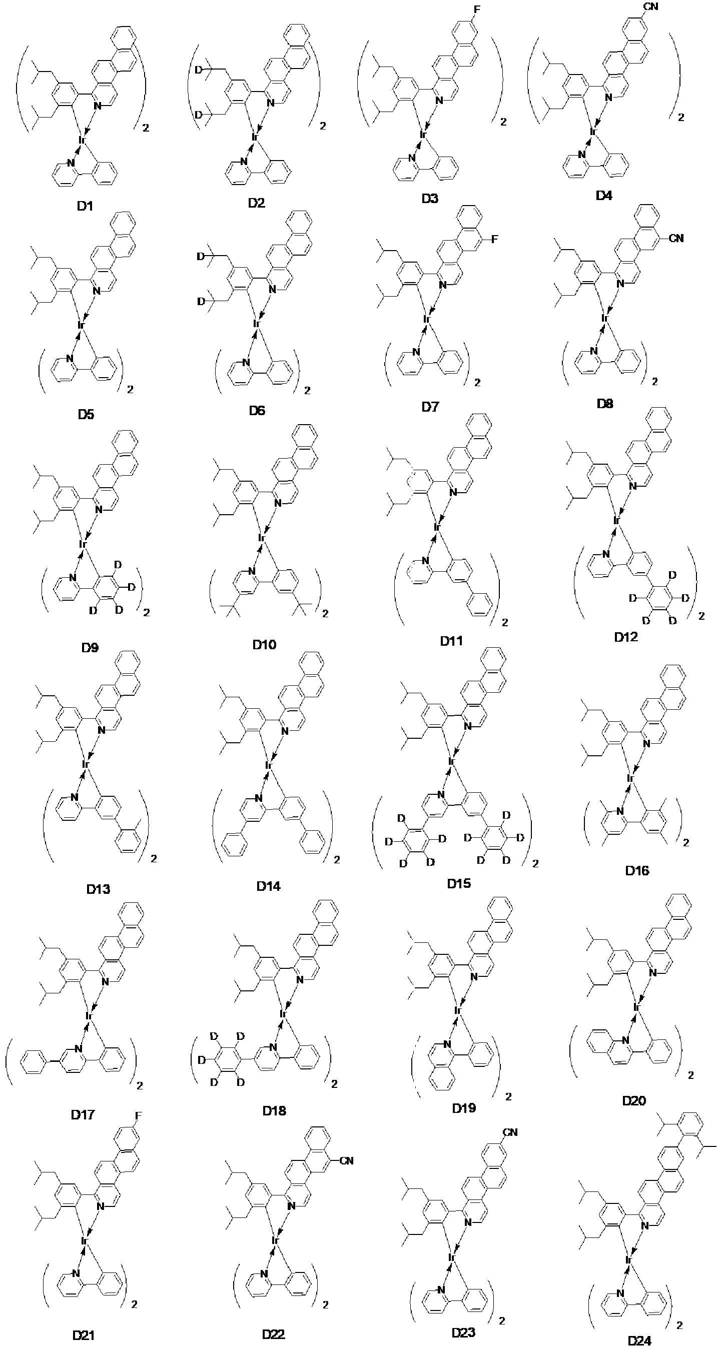

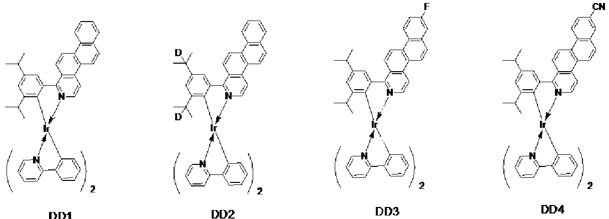

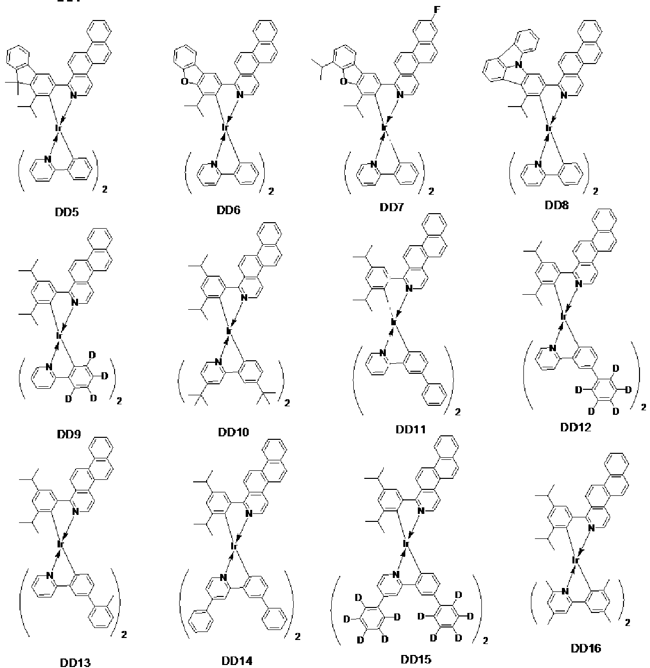

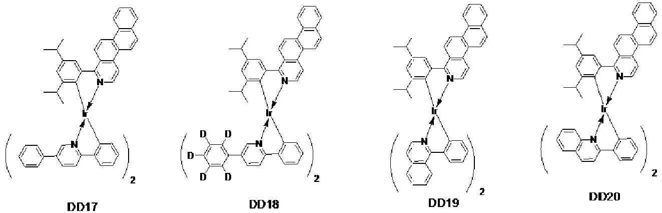

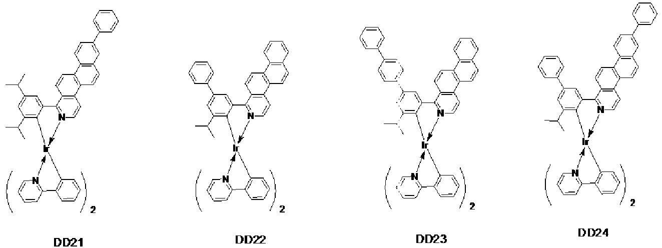

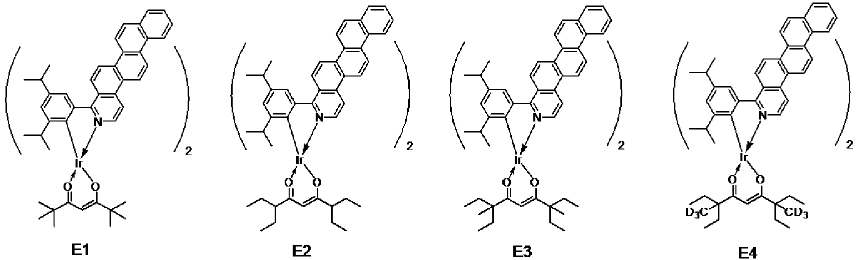

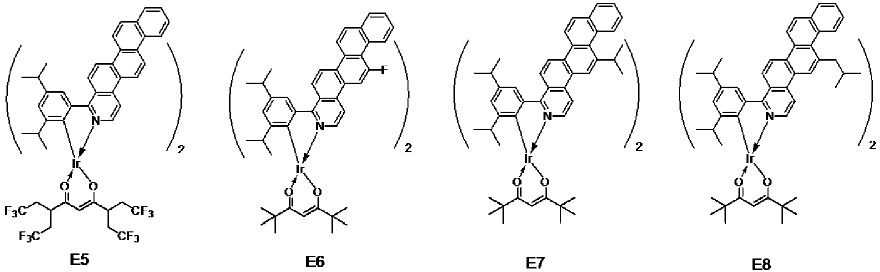

The compounds of group A are organometallic complexes in which the partial structure Ir(L)ₘ is represented by the formula [2-1], two of R₁ to R₃ are a hydrogen atom or a deuterium atom, the other is a secondary or higher alkyl group, and L' is represented by the formula [3]. Among the organometallic complexes according to the present disclosure, the compounds of group A have higher solubility and sublimability.

The compounds of group AA are organometallic complexes in which the partial structure Ir(L)ₘ is represented by the formula [2-1], two of R₁ to R₃ are not a hydrogen atom or a deuterium atom, and L' is represented by the formula [3]. Among the organometallic complexes according to the present disclosure, the compounds of group AA have a narrower half-value width and higher sublimability.

The compounds of group B are organometallic complexes in which the partial structure Ir(L)ₘ is represented by the formula [2-1], two of R₁ to R₃ are a hydrogen atom or a deuterium atom, the other is a secondary or higher alkyl group, and L' is represented by the formula [4]. Among the organometallic complexes according to the present disclosure, the compounds of group B have high stability.

The compounds of group BB are organometallic complexes in which the partial structure Ir(L)ₘ is represented by the formula [2-1], two of R₁ to R₃ are not a hydrogen atom or a deuterium atom, and L' is represented by the formula [4]. Among the organometallic complexes according to the present disclosure, the compounds of group BB have high stability.

The compounds of group C are organometallic complexes in which the partial structure Ir(L)ₘ is represented by the formula [2-2], two of R₁₅ to R₁₇ are a hydrogen atom or a deuterium atom, the other is a secondary or higher alkyl group, and L' is represented by the formula [3]. Among the organometallic complexes according to the present disclosure, the compounds of group C emit longer-wavelength light and have high solubility.

The compounds of group CC are organometallic complexes in which the partial structure Ir(L)ₘ is represented by the formula [2-2], two of R₁₅ to R₁₇ are not a hydrogen atom or a deuterium atom, and L' is represented by the formula [3]. Among the organometallic complexes according to the present disclosure, the compounds of group CC emit longer-wavelength light and have a narrow half-value width and high color purity.

The compounds of group D are organometallic complexes in which the partial structure Ir(L)ₘ is represented by the formula [2-2], two of R₁₅ to R₁₇ are a hydrogen atom or a deuterium atom, the other is a secondary or higher alkyl group, and L' is represented by the formula [4]. Among the organometallic complexes according to the present disclosure, the compounds of group D emit longer-wavelength light and have high stability.

The compounds of group DD are organometallic complexes in which the partial structure Ir(L)ₘ is represented by the formula [2-2], two of R₁₅ to R₁₇ are not a hydrogen atom or a deuterium atom, and L' is represented by the formula [4]. Among the organometallic complexes according to the present disclosure, the compounds of group DD emit longer-wavelength light and have high stability.

The compounds of group E are organometallic complexes in which the partial structure Ir(L)ₘ is represented by the formula [2-2], R₂₅ and R₂₆ form a benzene ring, two of R₁₅ to R₁₇ are not a hydrogen atom or a deuterium atom, and L' is represented by the formula [3]. The compounds of group E are also organometallic complexes in which the partial structure Ir(L)ₘ is represented by the formula [2-1] and R₉ and R₁₀ form a naphthalene ring. Among the organometallic complexes according to the present disclosure, the compounds of group E have high oscillator strength and higher efficiency.

Among the organometallic complexes according to the present disclosure, group AA and group CC are compound groups with a narrower half-value width. Furthermore, among the organometallic complexes according to the present disclosure, the compounds of group CC have a narrower half-value width, emit long-wavelength light, and emit red light with higher color purity.

An organometallic complex according to the present disclosure is a compound exhibiting light emission suitable for red light emission. Thus, an organometallic complex according to the present embodiment can be used as a constituent material of an organic light-emitting element to provide an organic light-emitting element with good emission properties and high durability.

### <<Organic Light-Emitting Element>>

The organic light-emitting element according to the present embodiment includes at least a first electrode, a second electrode, and an organic compound layer between these electrodes. One of the first electrode and the second electrode is a positive electrode, and the other is a negative electrode. In the organic light-emitting element according to the present embodiment, the organic compound layer may be a single layer or a laminate of a plurality of layers, provided that the organic compound layer has a light-emitting layer. When the organic compound layer is a laminate of a plurality of layers, the organic compound layer may have a hole-injection layer, a hole-transport layer, an electron-blocking layer, a hole/exciton-blocking layer, an electron-transport layer, and/or an electron-injection layer, in addition to a light-emitting layer. The light-emitting layer may be a single layer or a laminate of a plurality of layers.

In the organic light-emitting element according to the present embodiment, at least one organic compound layer contains the organometallic complex according to the present embodiment. More specifically, the organometallic complex according to the present embodiment is contained in one of the light-emitting layer, the hole-injection layer, the hole-transport layer, the electron-blocking layer, the hole/exciton-blocking layer, the electron-transport layer, the electron-injection layer, and the like. The organometallic complex according to the present embodiment can be contained in the light-emitting layer.

In the organic light-emitting element according to the present embodiment, when the organometallic complex according to the present embodiment is contained in the light-emitting layer, the light-emitting layer may be composed only of the organometallic complex according to the present embodiment or may be composed of the organometallic complex according to the present embodiment and another compound. When the light-emitting layer is composed of the organometallic complex according to the present embodiment and another compound, the organometallic complex according to the present embodiment may be used as a host or a guest of the light-emitting layer. The organometallic complex may also be used as an assist material that may be contained in the light-emitting layer. The host is a compound with the highest mass ratio among the compounds constituting a light-emitting layer. The guest is a compound that has a lower mass ratio than the host among the compounds constituting a light-emitting layer and that is a principal light-emitting compound. The assist material is a compound that has a lower mass ratio than the host among the compounds constituting the light-emitting layer and that assists the guest in emitting light. The assist material is also referred to as a second host.

When the organic compound according to the present embodiment is used as a guest in the light-emitting layer, the concentration of the guest is preferably 0.01% by mass or more and 20% by mass or less, more preferably 0.1% by mass or more and 10% by mass or less, of the entire light-emitting layer.

The present inventors have conducted various studies and have found that the organometallic complex according to the present embodiment can be used as a host or guest in a light-emitting layer, particularly as a guest in the light-emitting layer, to provide an element that can efficiently emit bright light and that has very high durability. The light-emitting layer may be monolayer or multilayer or may contain a light-emitting material with another emission color to mix the emission color with the red emission color of the present embodiment. The term "multilayer", as used herein, refers to a laminate of a light-emitting layer and another light-emitting layer. In such a case, the emission color of the organic light-emitting element is not limited to red. More specifically, the emission color may be white or a neutral color. For white color emission, another light-emitting layer emits light of a color other than red, such as blue or green. Furthermore, a third light-emitting layer that emits blue light and a charge generation layer may be provided between a light-emitting layer or a laminated light-emitting layer and the first or second electrode in the present embodiment. The charge generation layer has a function as a tandem element, and an electron generated from the charge generation layer and a hole injected from the first electrode are recombined and generate an exciton, and a hole generated from the charge generation layer and an electron injected from the second electrode are recombined and generate an exciton. Thus, the internal quantum efficiency is doubled. For example, a white-light-emitting element can be provided by configuring a tandem element with a yellow-light-emitting layer formed by stacking a red-light-emitting layer and a green-light-emitting layer, which are the light-emitting layers according to the present embodiment, and a blue-light-emitting layer.

The organic compound layer can be formed by any method, for example, by vapor deposition, coating, or the like. This is described in detail below in exemplary embodiments.

The organometallic complex according to the present embodiment can be used as a constituent material of an organic compound layer other than the light-emitting layer constituting the organic light-emitting element according to the present embodiment. More specifically, the organometallic complex according to the present embodiment may be used as a constituent material of an electron-transport layer, an electron-injection layer, a hole-transport layer, a hole-injection layer, and/or a hole-blocking layer. In such a case, the emission color of the organic light-emitting element is not limited to red. More specifically, the emission color may be white or a neutral color.

### <Other Compounds>

If necessary, the organometallic complex according to the present embodiment may be used in combination with a known low-molecular-weight or high-molecular-weight hole-injection compound or hole-transport compound, host compound, light-emitting compound, electron-injection compound, or electron-transport compound. Examples of these compounds are described below.

The hole-injection/transport material can be a material with high hole mobility to facilitate the injection of holes from a positive electrode and to transport the injected holes to a light-emitting layer. Furthermore, a material with a high glass transition temperature can be used to reduce degradation of film quality, such as crystallization, in an organic light-emitting element. Examples of the low-molecular-weight or high-molecular-weight material with hole-injection/transport ability include, but are not limited to, triarylamine derivatives, aryl carbazole derivatives, phenylenediamine derivatives, stilbene derivatives, phthalocyanine derivatives, porphyrin derivatives, polyvinylcarbazole, polythiophene, and other electrically conductive polymers. The hole-injection/transport material can also be used for an electron-blocking layer. Specific examples of compounds that can be used as hole-injection/transport materials include, but are not limited to, the following.

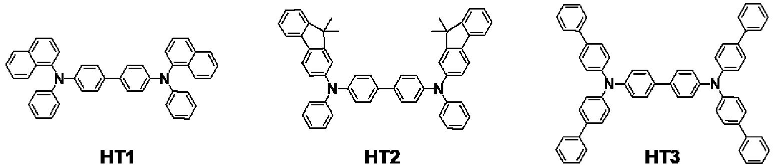

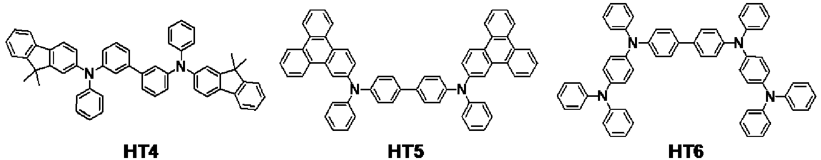

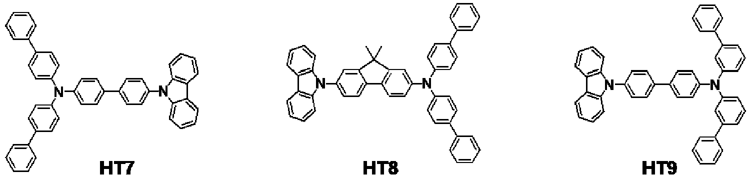

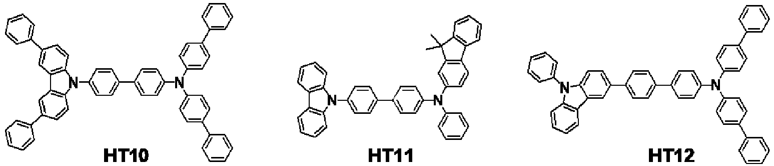

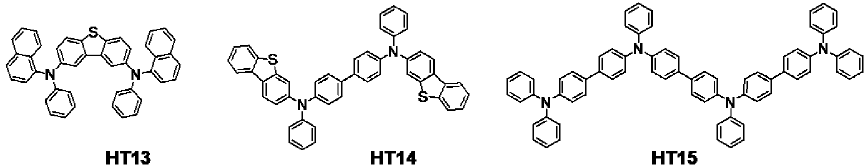

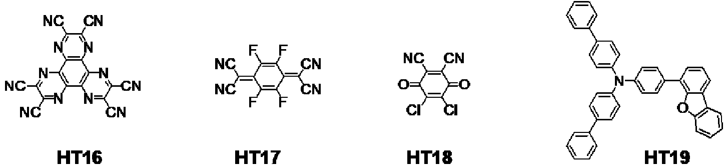

Examples of a light-emitting material mainly related to the light-emitting function include, in addition to the organometallic complex according to the present embodiment, fused-ring compounds (for example, fluorene derivatives, naphthalene derivatives, pyrene derivatives, perylene derivatives, tetracene derivatives, anthracene derivatives, rubrene, etc.), quinacridone derivatives, coumarin derivatives, stilbene derivatives, organoaluminum complexes, such as tris(8-quinolinolato)aluminum, iridium complexes, platinum complexes, rhenium complexes, copper complexes, europium complexes, ruthenium complexes, and polymer derivatives, such as poly(phenylene vinylene) derivatives, polyfluorene derivatives, and polyphenylene derivatives. Specific examples of compounds that can be used as light-emitting materials include, but are not limited to, the following.

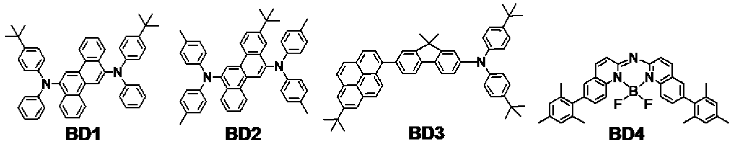

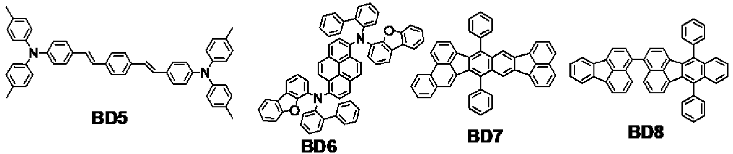

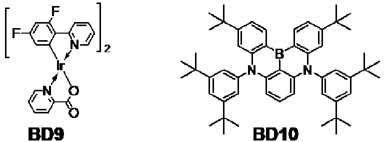

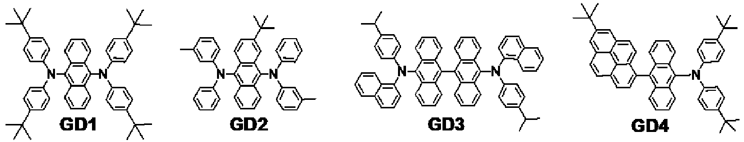

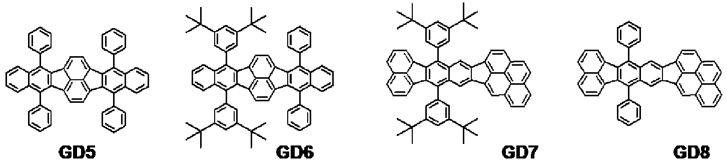

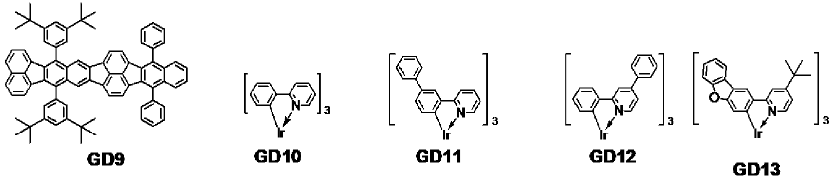

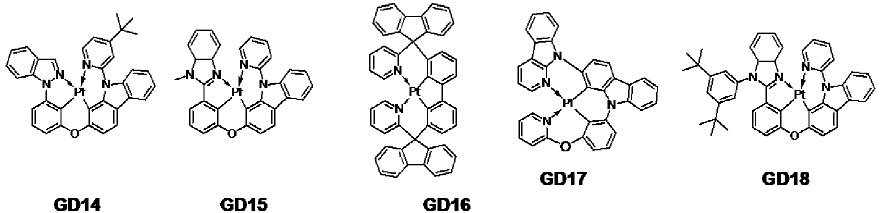

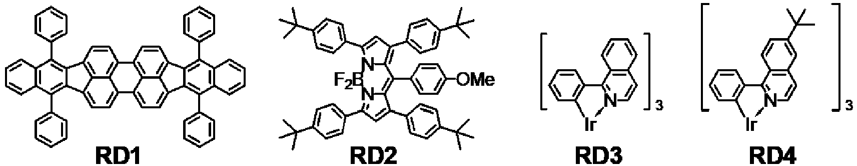

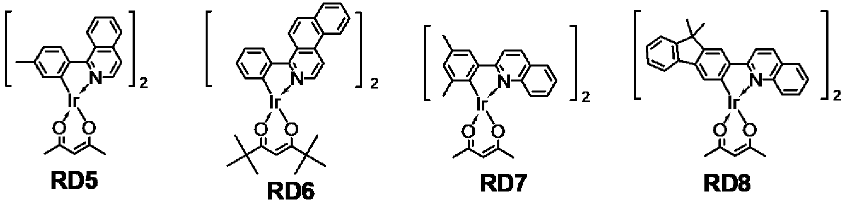

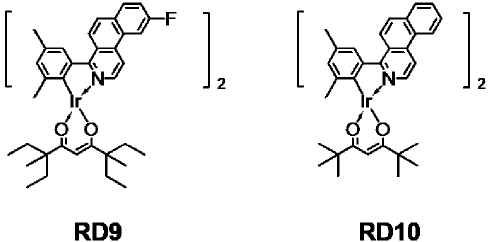

Examples of a host or a light-emitting assist material in a light-emitting layer include, but are not limited to, aromatic hydrocarbon compounds and derivatives thereof, carbazole derivatives, azine derivatives, xanthone derivatives, dibenzofuran derivatives, dibenzothiophene derivatives, organoaluminum complexes, such as tris(8-quinolinolato)aluminum, and organoberyllium complexes. Specific examples of a compound that can be used as a host or a light-emitting assist material in a light-emitting layer include, but are not limited to, the following.

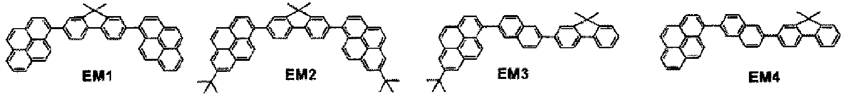

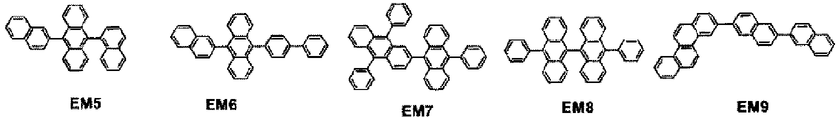

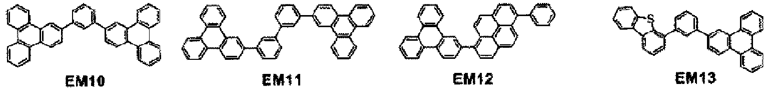

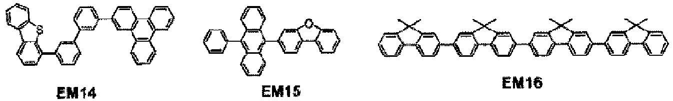

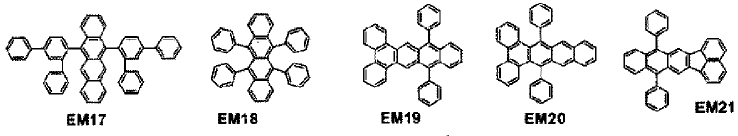

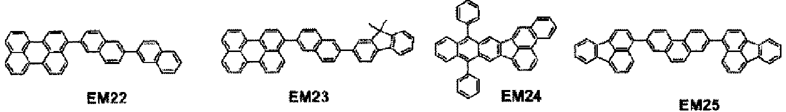

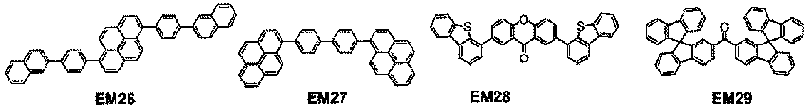

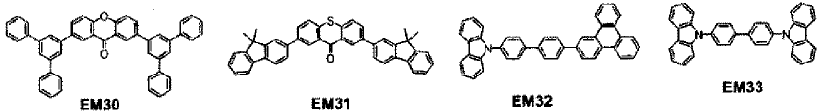

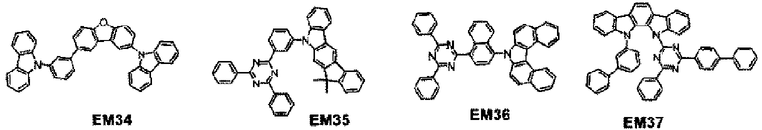

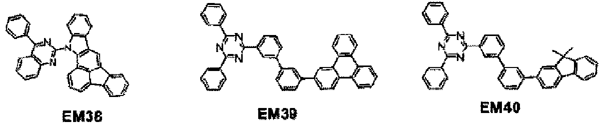

An electron-transport material can be selected from materials that can transport electrons injected from the negative electrode to the light-emitting layer and is selected in consideration of the balance with the hole mobility of a hole-transport material and the like. Examples of materials with electron-transport ability include, but are not limited to, oxadiazole derivatives, oxazole derivatives, pyrazine derivatives, triazole derivatives, triazine derivatives, quinoline derivatives, quinoxaline derivatives, phenanthroline derivatives, organoaluminum complexes, and fused-ring compounds (for example, fluorene derivatives, naphthalene derivatives, chrysene derivatives, and anthracene derivatives). Furthermore, the electron-transport material is also suitable for use in a hole-blocking layer. Specific examples of compounds that can be used as electron-transport materials include, but are not limited to, the following.

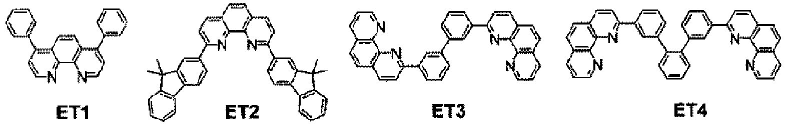

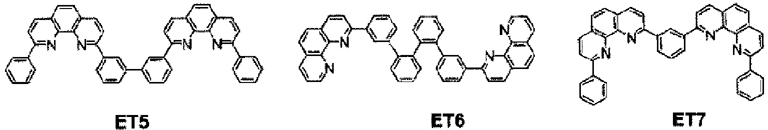

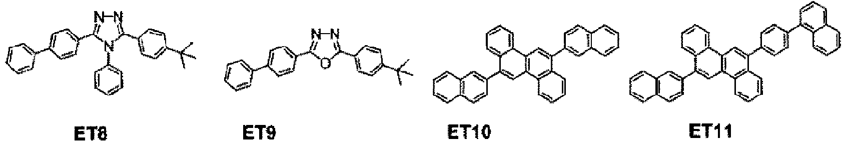

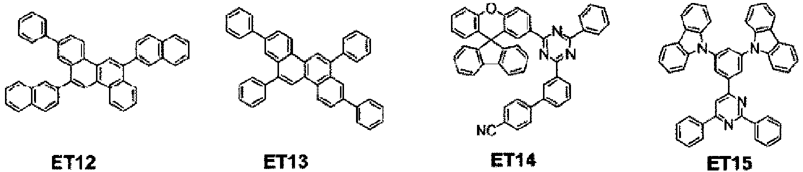

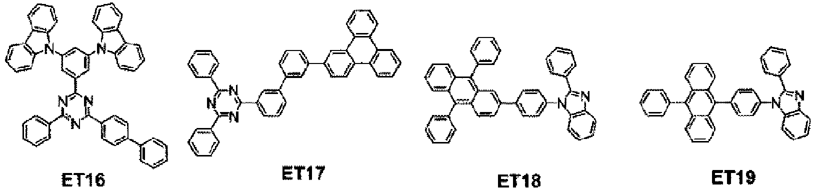

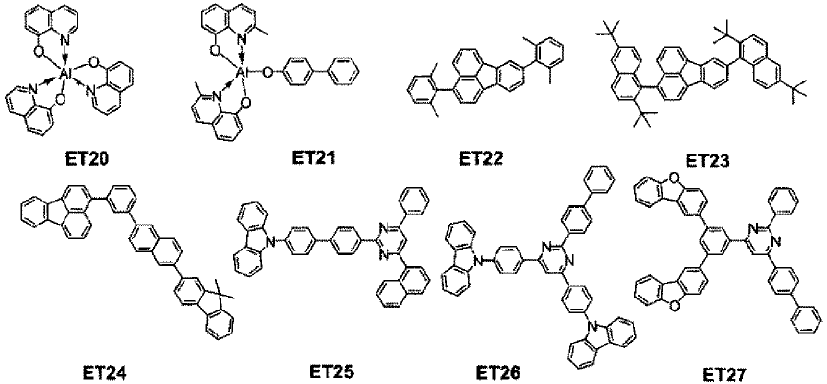

The electron-injection material can be selected from materials that can easily inject electrons from the negative electrode and is selected in consideration of the balance with the hole injection properties and the like. The organic compound may be an n-type dopant or a reducing dopant. Examples include compounds containing an alkali metal, such as lithium fluoride, lithium complexes, such as lithium quinolinol, benzimidazolidene derivatives, imidazolidene derivatives, fulvalene derivatives, and acridine derivatives. It can also be used in combination with the electron-transport material.

### <Structure of Organic Light-Emitting Element>

An organic light-emitting element includes an insulating layer, a first electrode, an organic compound layer, and a second electrode on a substrate. A protective layer, a color filter, a microlens, or the like may be provided on the second electrode. When a color filter is provided, a planarization layer may be provided between the color filter and a protective layer. The planarization layer may be composed of an acrylic resin or the like. The same applies to a planarization layer provided between a color filter and a microlens.

### [Substrate]

The substrate may be formed of quartz, glass, a silicon wafer, resin, metal, or the like. The substrate may have a switching element, such as a transistor, and wiring, on which an insulating layer may be provided. The insulating layer may be composed of any material, provided that the insulating layer can have a contact hole for wiring between the insulating layer and the first electrode and is insulated from unconnected wires. For example, the insulating layer may be formed of a resin, such as polyimide, silicon oxide, or silicon nitride.

### [Electrodes]

A pair of electrodes can be used as electrodes. The pair of electrodes may be a positive electrode and a negative electrode. When an electric field is applied in a direction in which the organic light-emitting element emits light, an electrode with a high electric potential is a positive electrode, and the other electrode is a negative electrode. In other words, the electrode that supplies holes to the light-emitting layer is a positive electrode, and the electrode that supplies electrons to the light-emitting layer is a negative electrode.

A constituent material of the positive electrode can have as large a work function as possible. Examples of the constituent material include metal elements, such as gold, platinum, silver, copper, nickel, palladium, cobalt, selenium, vanadium, and tungsten, mixtures thereof, alloys thereof, and metal oxides, such as tin oxide, zinc oxide, indium oxide, indium tin oxide (ITO), and indium zinc oxide. Electrically conductive polymers, such as polyaniline, polypyrrole, and polythiophene, may also be used.

These electrode materials may be used alone or in combination. The positive electrode may be composed of a single layer or a plurality of layers.

When used as a reflective electrode, for example, chromium, aluminum, silver, titanium, tungsten, molybdenum, an alloy thereof, or a laminate thereof can be used. These materials can also function as a reflective film that does not have a role as an electrode. When used as a transparent electrode, an oxide transparent electroconductive layer, such as indium tin oxide (ITO) or indium zinc oxide, can be used. However, the present disclosure is not limited thereto. The electrodes may be formed by photolithography.

On the other hand, a constituent material of the negative electrode can be a material with a small work function. For example, an alkali metal, such as lithium, an alkaline-earth metal, such as calcium, a metal element, such as aluminum, titanium, manganese, silver, lead, or chromium, or a mixture thereof may be used. An alloy of these metal elements may also be used. For example, magnesium-silver, aluminum-lithium, aluminum-magnesium, silver-copper, or zinc-silver may be used. A metal oxide, such as indium tin oxide (ITO), may also be used. These electrode materials may be used alone or in combination. The negative electrode may be composed of a single layer or a plurality of layers. In particular, silver can be used, and a silver alloy can be used to reduce the aggregation of silver. As long as the aggregation of silver can be reduced, the alloy may have any ratio. For example, the ratio of silver to another metal may be 1: 1, 3: 1, or the like.

The negative electrode may be, but is not limited to, an oxide electroconductive layer, such as ITO, for a top emission element or a reflective electrode, such as aluminum (Al), for a bottom emission element. The negative electrode may be formed by any method. A direct-current or alternating-current sputtering method can achieve good film coverage and easily decrease resistance.

### [Organic Compound Layer]

The organic compound layer may be formed of a single layer or a plurality of layers. Depending on their functions, the plurality of layers may be referred to as a hole-injection layer, a hole-transport layer, an electron-blocking layer, a light-emitting layer, a hole-blocking layer, an electron-transport layer, or an electron-injection layer. The organic compound layer is composed mainly of an organic compound and may contain an inorganic atom or an inorganic compound. For example, copper, lithium, magnesium, aluminum, iridium, platinum, molybdenum, zinc, or the like may be contained. The organic compound layer may be located between the first electrode and the second electrode and may be in contact with the first electrode and the second electrode.

An organic compound layer (a hole-injection layer, a hole-transport layer, an electron-blocking layer, a light-emitting layer, a hole-blocking layer, an electron-transport layer, an electron-injection layer, or the like) constituting an organic light-emitting element according to an embodiment of the present disclosure is formed by the following method.

An organic compound layer constituting an organic light-emitting element according to an embodiment of the present disclosure can be formed by a dry process, such as a vacuum evaporation method, an ionized deposition method, sputtering, or plasma. Instead of the dry process, a wet process may also be employed in which a layer is formed by a known coating method (for example, spin coating, dipping, a casting method, an LB method, an ink jet method, or the like) using an appropriate solvent.

A layer formed by a vacuum evaporation method, a solution coating method, or the like undergoes little crystallization or the like and has high temporal stability. When a film is formed by a coating method, the film may also be formed in combination with an appropriate binder resin.

Examples of the binder resin include, but are not limited to, polyvinylcarbazole resins, polycarbonate resins, polyester resins, ABS resins, acrylic resins, polyimide resins, phenolic resins, epoxy resins, silicone resins, and urea resins.

These binder resins may be used alone or in combination as a homopolymer or a copolymer. If necessary, an additive agent, such as a known plasticizer, oxidation inhibitor, and/or ultraviolet absorbent, may also be used.

### [Protective Layer]

A protective layer may be provided on the second electrode. For example, a glass sheet with a moisture absorbent may be attached to the second electrode to decrease the amount of water or the like entering the organic compound layer and to reduce the occurrence of display defects. In another embodiment, a passivation film of silicon nitride or the like may be provided on the second electrode to decrease the amount of water or the like entering the organic compound layer. For example, the second electrode may be formed and then transferred to another chamber without breaking the vacuum, and a silicon nitride film with a thickness of 2 µm may be formed as a protective layer by a chemical vapor deposition (CVD) method. The film formation by the CVD method may be followed by the formation of a protective layer by an atomic layer deposition (ALD) method. A film formed by the ALD method may be formed of any material such as silicon nitride, silicon oxide, or aluminum oxide. Silicon nitride may be further formed by the CVD method on the film formed by the ALD method. The film formed by the ALD method may have a smaller thickness than the film formed by the CVD method. More specifically, the thickness may be 50% or less or even 10% or less.

### [Color Filter]

A color filter may be provided on the protective layer. For example, a color filter that matches the size of the organic light-emitting element may be provided on another substrate and may be bonded to the substrate on which the organic light-emitting element is provided, or a color filter may be patterned on the protective layer by photolithography. The color filter may be composed of a polymer.

### [Planarization Layer]

A planarization layer may be provided between the color filter and the protective layer. The planarization layer is provided to reduce the roughness of the underlayer. The planarization layer is sometimes referred to as a material resin layer with any purpose. The planarization layer may be composed of an organic compound and can be composed of a high-molecular-weight compound, though it may be composed of a low-molecular-weight compound.

The planarization layer may be provided above and below the color filter, and the constituent materials thereof may be the same or different. Specific examples include polyvinylcarbazole resins, polycarbonate resins, polyester resins, ABS resins, acrylic resins, polyimide resins, phenolic resins, epoxy resins, silicone resins, and urea resins.

### [Microlens]

An organic light-emitting element or an organic light-emitting apparatus may include an optical member, such as a microlens, on the light output side. The microlens may be composed of an acrylic resin, an epoxy resin, or the like. The microlens may be used to increase the amount of light extracted from the organic light-emitting element or the organic light-emitting apparatus and control the direction of the extracted light. The microlens may have a hemispherical shape. For a hemispherical microlens, the vertex of the microlens is a contact point between the hemisphere and a tangent line parallel to the insulating layer among the tangent lines in contact with the hemisphere. The vertex of the microlens in any cross-sectional view can be determined in the same manner. More specifically, the vertex of the microlens in a cross-sectional view is a contact point between the semicircle of the microlens and a tangent line parallel to the insulating layer among the tangent lines in contact with the semicircle.

The midpoint of the microlens can also be defined. In a cross section of the microlens, a midpoint of a line segment from one end point to the other end point of the arc can be referred to as a midpoint of the microlens. A cross section in which the vertex and the midpoint are determined may be perpendicular to the insulating layer.

### [Opposite Substrate]

An opposite substrate may be provided on the planarization layer. The opposite substrate is so called because it faces the substrate. The opposite substrate may be composed of the same material as the substrate. When the substrate is a first substrate, the opposite substrate may be a second substrate.

### [Pixel Circuit]

An organic light-emitting apparatus including an organic light-emitting element may include a pixel circuit coupled to the organic light-emitting element. The pixel circuit may be of an active matrix type, which independently controls the light emission of a first light-emitting element and a second light-emitting element. The active-matrix circuit may be voltage programmed or current programmed. The drive circuit has a pixel circuit for each pixel. The pixel circuit may include a light-emitting element, a transistor for controlling the luminous brightness of the light-emitting element, a transistor for controlling light emission timing, a capacitor for holding the gate voltage of the transistor for controlling the luminous brightness, and a transistor for GND connection without through the light-emitting element.

A light-emitting apparatus includes a display region and a peripheral region around the display region. The display region includes the pixel circuit, and the peripheral region includes a display control circuit. The mobility of a transistor constituting the pixel circuit may be smaller than the mobility of a transistor constituting the display control circuit. The gradient of the current-voltage characteristics of a transistor constituting the pixel circuit may be smaller than the gradient of the current-voltage characteristics of a transistor constituting the display control circuit. The gradient of the current-voltage characteristics can be determined by so-called Vg-Ig characteristics. A transistor constituting the pixel circuit is a transistor coupled to a light-emitting element, such as a first light-emitting element.

### [Pixel]

An organic light-emitting apparatus including an organic light-emitting element may have a plurality of pixels. Each pixel has subpixels that emit light of different colors. For example, the subpixels may have RGB emission colors.

In each pixel, a region also referred to as a pixel aperture emits light. This region is the same as the first region. The pixel aperture may be 15 µm or less or 5 µm or more. More specifically, the pixel aperture may be 11 µm, 9.5 µm, 7.4 µm, or 6.4 µm. The distance between the subpixels may be 10 µm or less, more specifically, 8 µm, 7.4 µm, or 6.4 µm.

The pixels may be arranged in a known form in a plan view. Examples include a stripe arrangement, a delta arrangement, a PenTile arrangement, and a Bayer arrangement. Each subpixel may have any known shape in a plan view. Examples include quadrangles, such as a rectangle and a rhombus, and a hexagon. As a matter of course, the rectangle also includes a figure that is not strictly rectangular but is close to rectangular. The shape of each subpixel and the pixel array can be used in combination.

### <Applications of Organic Light-Emitting Element>

The organic light-emitting element according to the present embodiment can be used as a constituent of a display apparatus or a lighting apparatus. Other applications include an exposure light source for an electrophotographic image-forming apparatus, a backlight for a liquid crystal display, and a light-emitting apparatus with a color filter in a white light source.

The display apparatus may be an image-information-processing apparatus that includes an image input unit for inputting image information from an area CCD, a linear CCD, a memory card, or the like, includes an information processing unit for processing the input information, and displays an input image on a display unit. The display apparatus may have a plurality of pixels, and at least one of the pixels may include the organic light-emitting element according to the present embodiment and an active element, such as a transistor, coupled to the organic light-emitting element. The substrate may be a semiconductor substrate formed of silicon or the like, and the transistor may be a MOSFET formed on the substrate. The image display apparatus includes an input portion for inputting image information and a display unit for outputting an image, and the display unit includes the display apparatus according to the present embodiment.

A display unit of an imaging apparatus or an ink jet printer may have a touch panel function. A driving system of the touch panel function may be, but is not limited to, an infrared radiation system, an electrostatic capacitance system, a resistive film system, or an electromagnetic induction system. The display apparatus may be used for a display unit of a multifunction printer.

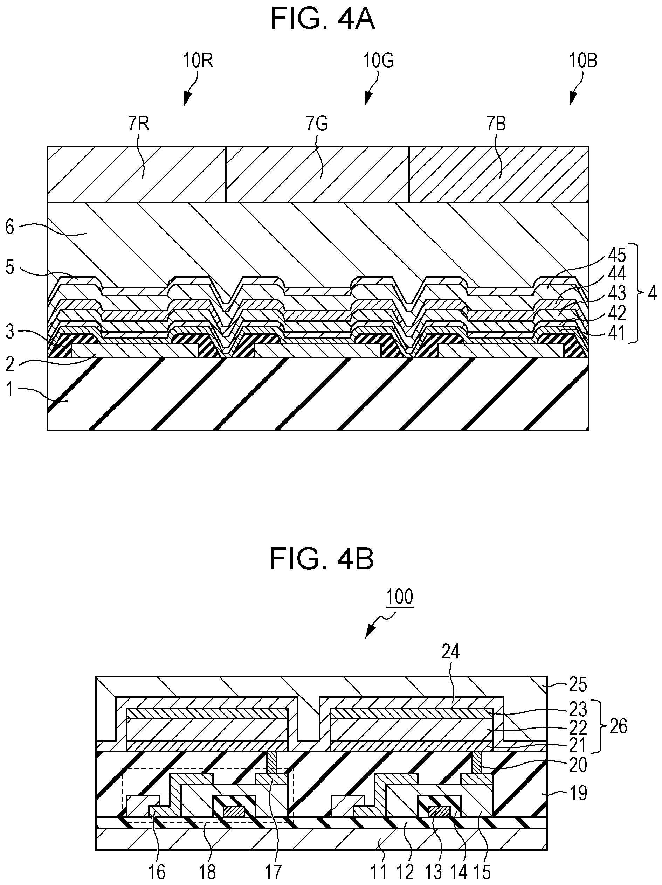

Next, a display apparatus according to the present embodiment is described with reference to the accompanying drawings. Figs. 4A and 4B are schematic cross-sectional views of an example of a display apparatus that includes an organic light-emitting element and a transistor coupled to the organic light-emitting element. The transistor is an example of an active element. The transistor may be a thin-film transistor (TFT).

Fig. 4A illustrates an example of a pixel serving as a constructional element of the display apparatus according to the present embodiment. The pixel has subpixels 10. The subpixels are 10R, 10G, and 10B with different emission colors. The emission colors may be distinguished by the wavelength of light emitted from the light-emitting layer, or light emitted from each subpixel may be selectively transmitted or color-converted with a color filter or the like. Each of the subpixels 10 includes a reflective electrode serving as a first electrode 2, an insulating layer 3 covering an end of the first electrode 2, organic compound layers 4 covering the first electrode 2 and the insulating layer 3, a transparent electrode serving as a second electrode 5, a protective layer 6, and a color filter 7 on an interlayer insulating layer 1.

A transistor and/or a capacitor element may be provided under or inside the interlayer insulating layer 1. The transistor and the first electrode 2 may be electrically connected via a contact hole (not shown) or the like.

The insulating layer 3 is also referred to as a bank or a pixel separation film. The insulating layer 3 covers the ends of the first electrode 2 and surrounds the first electrode 2. A portion not covered with the insulating layer 3 is in contact with the organic compound layers 4 and serves as a light-emitting region.

The organic compound layers 4 include a hole-injection layer 41, a hole-transport layer 42, a first light-emitting layer 43, a second light-emitting layer 44, and an electron-transport layer 45.

The second electrode 5 may be a transparent electrode, a reflective electrode, or a semitransparent electrode.

The protective layer 6 reduces the penetration of moisture into the organic compound layers 4. The protective layer 6 is illustrated as a single layer but may be a plurality of layers. The protective layer 6 may include an inorganic compound layer and an organic compound layer.

The color filter 7 is divided into 7R, 7G, and 7B according to the color. The color filter 7 may be formed on a planarization film (not shown). Furthermore, a resin protective layer (not shown) may be provided on the color filter 7. The color filter 7 may be formed on the protective layer 6. Alternatively, the color filter 7 may be bonded after being provided on an opposite substrate, such as a glass substrate.

A display apparatus 100 illustrated in Fig. 4B includes an organic light-emitting element 26 and a TFT 18, which is an example of a transistor. The display apparatus 100 includes a substrate 11 made of glass, silicon, or the like and an insulating layer 12 on the substrate 11. An active element, such as the TFT 18, and a gate electrode 13, a gate-insulating film 14, and a semiconductor layer 15 of the active element are provided on the insulating layer 12. The TFT 18 has a drain electrode 16 and a source electrode 17. The TFT 18 is covered with an insulating film 19. A positive electrode 21 of the organic light-emitting element 26 is coupled to the source electrode 17 through a contact hole 20 formed in the insulating film 19.

Electrical connection between the electrodes of the organic light-emitting element 26 (the positive electrode 21 and a negative electrode 23) and the electrodes of the TFT 18 (the source electrode 17 and the drain electrode 16) is not limited to that illustrated in Fig. 4B. More specifically, it is only necessary to electrically connect either the positive electrode 21 or the negative electrode 23 to either the source electrode 17 or the drain electrode 16 of the TFT 18.

Although an organic compound layer 22 is a single layer in the display apparatus 100 illustrated in Fig. 4B, the organic compound layer 22 may be composed of a plurality of layers. The negative electrode 23 is covered with a first protective layer 24 and a second protective layer 25 for reducing degradation of the organic light-emitting element 26.

The transistor used as a switching element in the display apparatus 100 illustrated in Fig. 4B may be replaced with another switching element, such as a metal insulator metal (MIM) element.

The transistor used in the display apparatus 100 in Fig. 4B is not limited to a thin-film transistor including an active layer on an insulating surface of a substrate and may also be a transistor including a single crystal silicon wafer. The active layer may be single-crystal silicon, non-single-crystal silicon, such as amorphous silicon or microcrystalline silicon, or a non-single-crystal oxide semiconductor, such as indium zinc oxide or indium gallium zinc oxide. The thin-film transistor is also referred to as a TFT element.

The transistor in the display apparatus 100 of Fig. 4B may be formed within a substrate, such as a Si substrate. The phrase "formed within a substrate" means that the substrate, such as a Si substrate, itself is processed to form the transistor. Thus, the transistor within the substrate can be considered that the substrate and the transistor are integrally formed.

In the organic light-emitting element according to the present embodiment, the luminous brightness is controlled with the TFT, which is an example of a switching element. The organic light-emitting element can be provided in a plurality of planes to display an image at each luminous brightness. The switching element according to the present embodiment is not limited to the TFT and may be a transistor formed of low-temperature polysilicon or an active-matrix driver formed on a substrate, such as a Si substrate. The phrase "on a substrate" may also be referred to as "within a substrate". Whether a transistor is provided within a substrate or a TFT is used depends on the size of a display unit. For example, for an approximately 1.27 cm (0.5-inch) display unit, an organic light-emitting element can be provided on a Si substrate.

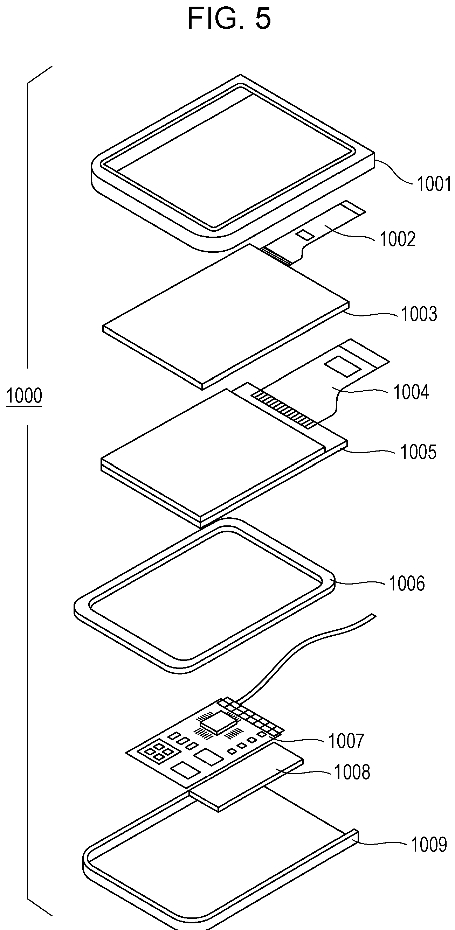

Fig. 5 is a schematic view of an example of the display apparatus according to the present embodiment. A display apparatus 1000 may include a touch panel 1003, a display panel 1005, a frame 1006, a circuit substrate 1007, and a battery 1008 between an upper cover 1001 and a lower cover 1009. The touch panel 1003 and the display panel 1005 are coupled to flexible print circuits FPC 1002 and 1004, respectively. Transistors are printed on the circuit substrate 1007. The battery 1008 is not necessarily provided when the display apparatus is not a mobile device, or may be provided at another position even when the display apparatus is a mobile device.

The display apparatus according to the present embodiment may include color filters of red, green, and blue colors. In the color filters, the red, green, and blue colors may be arranged in a delta arrangement.

The display apparatus according to the present embodiment may be used for a display unit of a mobile terminal. Such a display apparatus may have both a display function and an operation function. Examples of the mobile terminal include mobile phones, such as smartphones, tablets, and head-mounted displays.

The display apparatus according to the present embodiment may be used for a display unit of an imaging apparatus that includes an optical unit with a plurality of lenses and an imaging element for receiving light passing through the optical unit. The imaging apparatus may include a display unit for displaying information acquired by the imaging element. The display unit may be a display unit exposed outside from the imaging apparatus or a display unit located in a finder. The imaging apparatus may be a digital camera or a digital video camera.

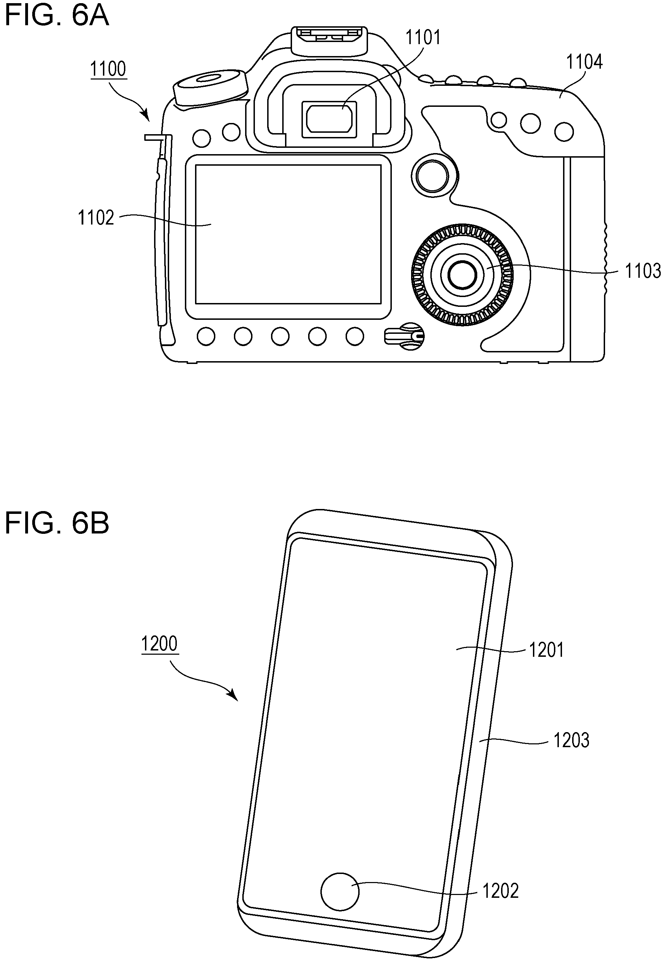

Fig. 6A is a schematic view of an example of an imaging apparatus according to the present embodiment. An imaging apparatus 1100 may include a viewfinder 1101, a rear display 1102, an operating unit 1103, and a housing 1104. The viewfinder 1101 may include the display apparatus according to the present embodiment. In such a case, the display apparatus may display environmental information, imaging instructions, and the like as well as an image to be captured. The environmental information may include the intensity of external light, the direction of external light, the travel speed of the photographic subject, the possibility that the photographic subject is shielded by a shielding material, and the like.

Because the appropriate timing for imaging is a short time, it is better to display information as early as possible. Thus, a display apparatus including the organic light-emitting element according to the present embodiment can be used. This is because the organic light-emitting element has a high response speed. A display apparatus including the organic light-emitting element can be more suitably used than these apparatuses and liquid crystal displays that require a high display speed.

The imaging apparatus 1100 includes an optical unit (not shown). The optical unit has a plurality of lenses and focuses an image on an imaging element in the housing 1104. The focus of the lenses can be adjusted by adjusting their relative positions. This operation can also be automatically performed. The imaging apparatus may also be referred to as a photoelectric conversion apparatus. The photoelectric conversion apparatus can have, as an imaging method, a method of detecting a difference from a previous image or a method of cutting out a permanently recorded image, instead of taking an image one after another.

Fig. 6B is a schematic view of an example of electronic equipment according to the present embodiment. Electronic equipment 1200 includes a display unit 1201, an operating unit 1202, and a housing 1203. The housing 1203 may include a circuit, a printed circuit board including the circuit, a battery, and a communication unit. The operating unit 1202 may be a button or a touch panel response unit. The operating unit 1202 may be a biometric recognition unit that recognizes a fingerprint and releases the lock. Electronic equipment with a communication unit may also be referred to as communication equipment. The electronic equipment 1200 may have a lens and an imaging element and thereby further have a camera function. An image captured by the camera function is displayed on the display unit 1201. The electronic equipment 1200 may be a smartphone, a notebook computer, or the like.

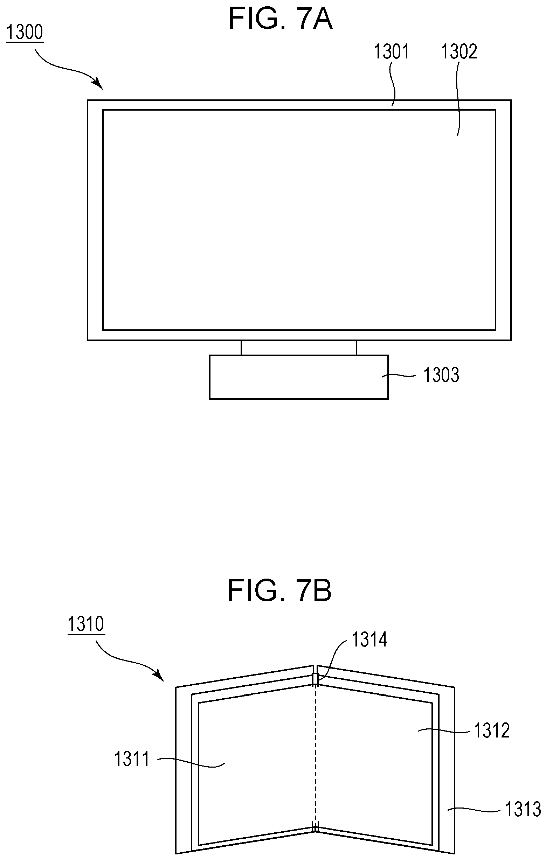

Figs. 7A and 7B are schematic views of an example of the display apparatus according to the present embodiment. Fig. 7A illustrates a display apparatus, such as a television monitor or a PC monitor. A display apparatus 1300 includes a frame 1301 and a display unit 1302. The light-emitting element according to the present embodiment may be used for the display unit 1302. The display apparatus 1300 includes a base 1303 for supporting the frame 1301 and the display unit 1302. The base 1303 is not limited to the structure illustrated in Fig. 7A. The lower side of the frame 1301 may also serve as the base. The frame 1301 and the display unit 1302 may be bent. The radius of curvature thereof may be 5000 mm or more and 6000 mm or less.

Fig. 7B is a schematic view of another example of the display apparatus according to the present embodiment. A display apparatus 1310 in Fig. 7B is configured to be foldable and is a so-called foldable display apparatus. The display apparatus 1310 includes a first display unit 1311, a second display unit 1312, a housing 1313, and a folding point 1314. The first display unit 1311 and the second display unit 1312 may include the light-emitting element according to the present embodiment. The first display unit 1311 and the second display unit 1312 may be a single display apparatus without a joint. The first display unit 1311 and the second display unit 1312 can be divided by the folding point. The first display unit 1311 and the second display unit 1312 may display different images or one image.

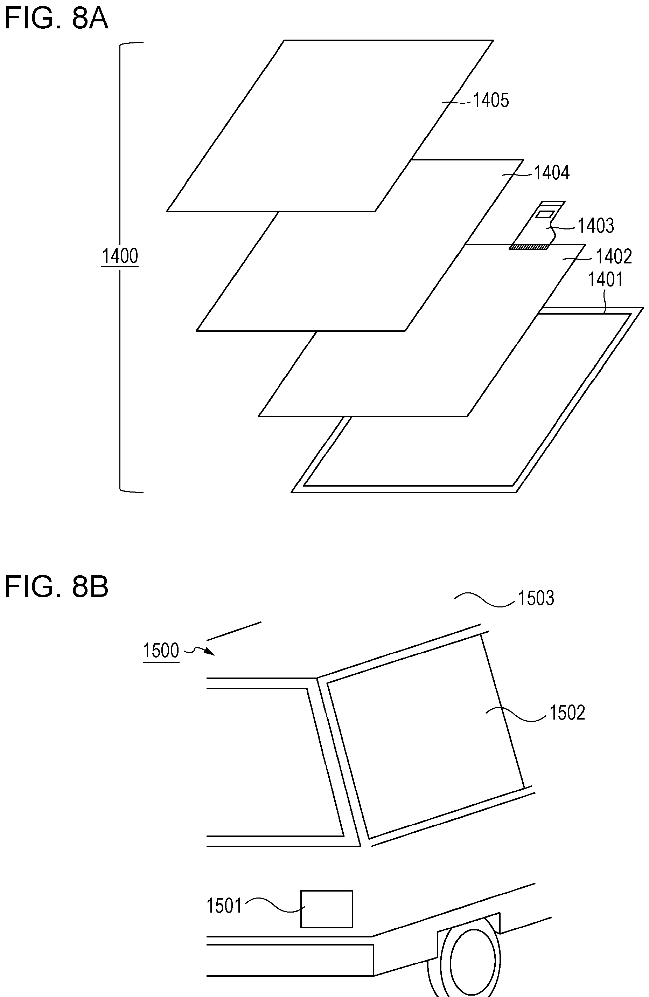

Fig. 8A is a schematic view of an example of a lighting apparatus according to the present embodiment. A lighting apparatus 1400 may include a housing 1401, a light source 1402, a circuit substrate 1403, an optical filter 1404 that transmits light emitted by the light source 1402, and a light-diffusing unit 1405. The light source 1402 may include the organic light-emitting element according to the present embodiment. The optical filter 1404 may be a filter that improves the color rendering properties of the light source. The light-diffusing unit 1405 can effectively diffuse light from the light source and widely spread light as in illumination. The optical filter 1404 and the light-diffusing unit 1405 may be provided on the light output side of the lighting apparatus. If necessary, a cover may be provided on the outermost side.

For example, the lighting apparatus is an interior lighting apparatus. The lighting apparatus may emit white light, neutral white light, or light of any color from blue to red. The lighting apparatus may have a light control circuit for controlling such light or a color control circuit for controlling emission color. The lighting apparatus may include the organic light-emitting element according to the present embodiment and a power supply circuit coupled thereto. The power supply circuit is a circuit that converts an AC voltage to a DC voltage. White has a color temperature of 4200 K, and neutral white has a color temperature of 5000 K. The lighting apparatus may have a color filter.

The lighting apparatus according to the present embodiment may include a heat dissipation unit. The heat dissipation unit releases heat from the apparatus to the outside and may be a metal or liquid silicon with a high specific heat.

Fig. 8B is a schematic view of an automobile as an example of a moving body according to the present embodiment. The automobile has a taillight as an example of a lamp. An automobile 1500 may have a taillight 1501, which comes on when a brake operation or the like is performed.

The taillight 1501 may include the organic light-emitting element according to the present embodiment. The taillight 1501 may include a protective member for protecting the organic light-emitting element. The protective member may be formed of any transparent material with moderately high strength and can be formed of polycarbonate or the like. The polycarbonate may be mixed with a furan dicarboxylic acid derivative, an acrylonitrile derivative, or the like.

The automobile 1500 may have a body 1503 and a window 1502 on the body 1503. The window 1502 may be a transparent display as long as it is not a window for checking the front and rear of the automobile. The transparent display may include the organic light-emitting element according to the present embodiment. In such a case, constituent materials, such as electrodes, of the organic light-emitting element are transparent materials.

The moving body according to the present embodiment may be a ship, an aircraft, a drone, or the like. The moving body may include a body and a lamp provided on the body. The lamp may emit light to indicate the position of the body. The lamp includes the organic light-emitting element according to the present embodiment.

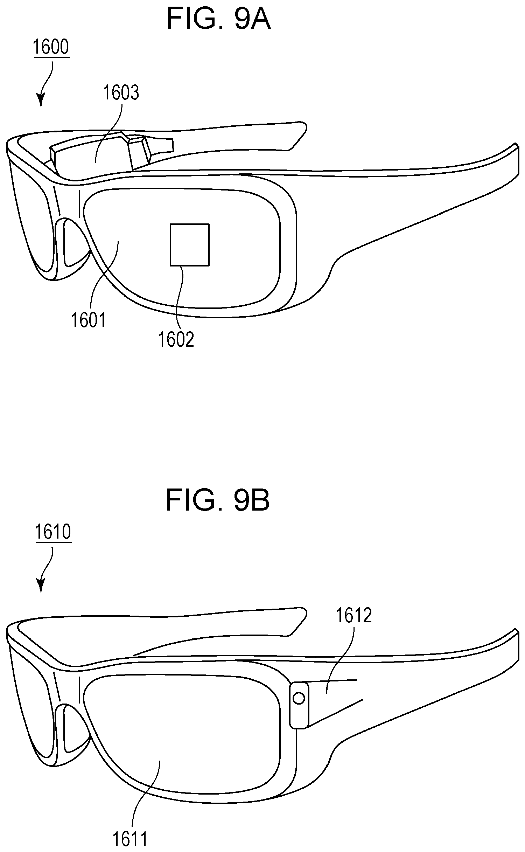

Application examples of the display apparatus according to one of the embodiments are described below with reference to Figs. 9A and 9B. The display apparatus can be applied to a system that can be worn as a wearable device, such as smart glasses, a head-mounted display (HMD), or smart contact lenses. An imaging and displaying apparatus used in such an application example includes an imaging apparatus that can photoelectrically convert visible light and a display apparatus that can emit visible light.

Fig. 9A is a schematic view of an example of a wearable device according to an embodiment of the present disclosure. Glasses 1600 (smart glasses) according to one application example are described below with reference to Fig. 9A. An imaging apparatus 1602, such as a complementary metal-oxide semiconductor (CMOS) sensor or a single-photon avalanche photodiode (SPAD), is provided on the front side of a lens 1601 of the glasses 1600. The display apparatus according to one of the embodiments is provided on the back side of the lens 1601.

The glasses 1600 further include a controller 1603. The controller 1603 functions as a power supply for supplying power to the imaging apparatus 1602 and the display apparatus. The controller 1603 controls the operation of the imaging apparatus 1602 and the display apparatus. The lens 1601 has an optical system for focusing light on the imaging apparatus 1602.

Fig. 9B is a schematic view of another example of a wearable device according to an embodiment of the present disclosure. Glasses 1610 (smart glasses) according to one application example are described below with reference to Fig. 9B. The glasses 1610 have a controller 1612, which includes an imaging apparatus corresponding to the imaging apparatus 1602 of Fig. 9A and a display apparatus. A lens 1611 includes an optical system for projecting light from the imaging apparatus of the controller 1612 and the display apparatus, and an image is projected on the lens 1611. The controller 1612 functions as a power supply for supplying power to the imaging apparatus and the display apparatus and controls the operation of the imaging apparatus and the display apparatus.

The controller 1612 may include a line-of-sight detection unit for detecting the line of sight of the wearer. Infrared radiation may be used to detect the line of sight. An infrared radiation unit emits infrared light to an eyeball of a user who is gazing at a display image. Reflected infrared light from the eyeball is detected by an imaging unit including a light-receiving element to capture an image of the eyeball. A reduction unit for reducing light from the infrared radiation unit to a display unit in a plan view is provided to reduce degradation in image quality. The line of sight of the user for the display image is detected from the image of the eyeball captured by infrared imaging. Any known technique can be applied to line-of-sight detection using the image of the eyeball. For example, it is possible to use a line-of-sight detection method based on a Purkinje image obtained by the reflection of irradiation light by the cornea. More specifically, a line-of-sight detection process based on a pupil-corneal reflection method is performed. The line of sight of the user is detected by calculating a line-of-sight vector representing the direction (rotation angle) of an eyeball on the basis of an image of a pupil and a Purkinje image included in a captured image of the eyeball using the pupil-corneal reflection method.

A display apparatus according to an embodiment of the present disclosure may include an imaging apparatus including a light-receiving element and may control a display image on the basis of line-of-sight information of a user from the imaging apparatus. More specifically, on the basis of the line-of-sight information, the display apparatus determines a first visibility region at which the user gazes and a second visibility region other than the first visibility region. The first visibility region and the second visibility region may be determined by the controller of the display apparatus or may be received from an external controller. In the display region of the display apparatus, the first visibility region may be controlled to have higher display resolution than the second visibility region. In other words, the second visibility region may have lower resolution than the first visibility region.

The display region has a first display region and a second display region different from the first display region, and the priority of the first display region and the second display region depends on the line-of-sight information. The first visibility region and the second visibility region may be determined by the controller of the display apparatus or may be received from an external controller. A region with a higher priority may be controlled to have higher resolution than another region. In other words, a region with a lower priority may have lower resolution.

The first visibility region or a region with a higher priority may be determined by artificial intelligence (AI). The AI may be a model configured to estimate the angle of the line of sight and the distance to a target ahead of the line of sight from an image of an eyeball using the image of the eyeball and the direction in which the eyeball actually viewed in the image as teaching data. The AI program may be stored in the display apparatus, the imaging apparatus, or an external device. The AI program stored in an external device is transmitted to the display apparatus via communication.

For display control based on visual recognition detection, the present disclosure can be applied to smart glasses further having an imaging apparatus for imaging the outside. Smart glasses can display captured external information in real time.

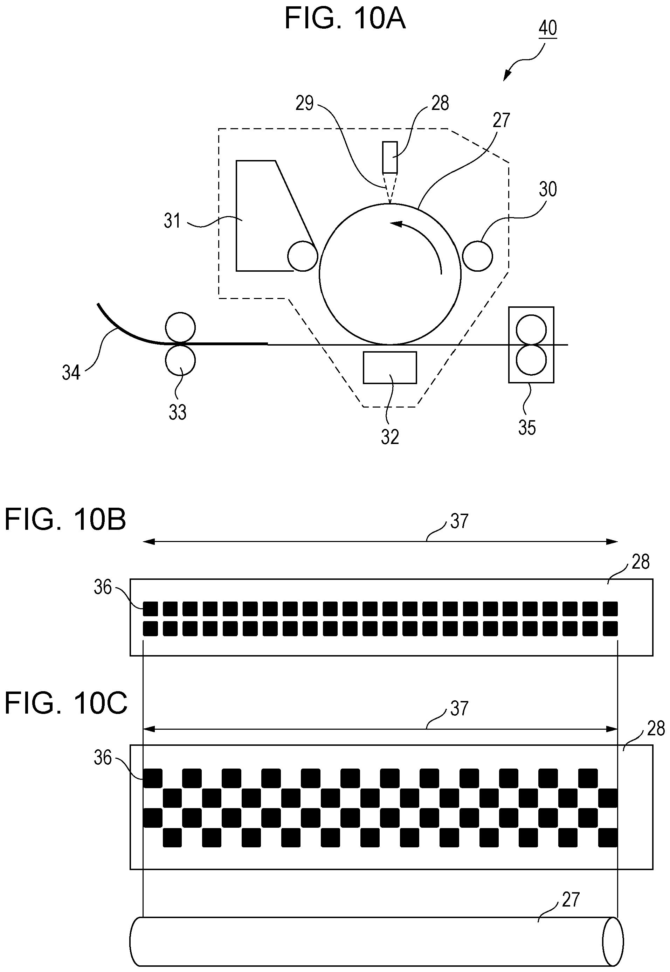

Fig. 10A is a schematic view of an example of an image-forming apparatus according to an embodiment of the present disclosure. An image-forming apparatus 40 is an electrophotographic image-forming apparatus and includes a photosensitive member 27, an exposure light source 28, a charging unit 30, a developing unit 31, a transfer unit 32, a conveying roller 33, and a fixing unit 35. The exposure light source 28 emits light 29, and an electrostatic latent image is formed on the surface of the photosensitive member 27. The exposure light source 28 includes the organic light-emitting element according to the present embodiment. The developing unit 31 contains toner and the like. The charging unit 30 electrifies the photosensitive member 27. The transfer unit 32 transfers a developed image onto a recording medium 34. The conveying roller 33 conveys the recording medium 34. The recording medium 34 is paper, for example. The fixing unit 35 fixes an image on the recording medium 34.

Figs. 10B and 10C are schematic views of the exposure light source 28, wherein a plurality of light-emitting portions 36 are arranged on a long substrate. An arrow 37 indicates a direction parallel to the axis of the photosensitive member and indicates a column direction in which the organic light-emitting elements are arranged. This column direction is the same as the direction of the rotation axis of the photosensitive member 27. This direction can also be referred to as the major-axis direction of the photosensitive member 27. In Fig. 10B, the light-emitting portions 36 are arranged in the major-axis direction of the photosensitive member 27. In Fig. 10C, unlike Fig. 10B, the light-emitting portions 36 are alternately arranged in the column direction in the first and second columns. The first and second columns are arranged at different positions in the row direction. In the first column, the light-emitting portions 36 are arranged at intervals. In the second column, the light-emitting portions 36 are arranged at positions corresponding to the spaces between the light-emitting portions 36 of the first column. Thus, the light-emitting portions 36 are also arranged at intervals in the row direction. The arrangement in Fig. 10C can also be referred to as a grid-like pattern, a staggered pattern, or a checkered pattern, for example.

As described above, an apparatus including the organic light-emitting element according to the present embodiment can be used to stably display a high-quality image for extended periods.

### EXAMPLES

The present disclosure is described below with exemplary embodiments. However, the present disclosure is not limited these exemplary embodiments.

### [Exemplary Embodiment 1 (Synthesis of Exemplary Compound AA1)]

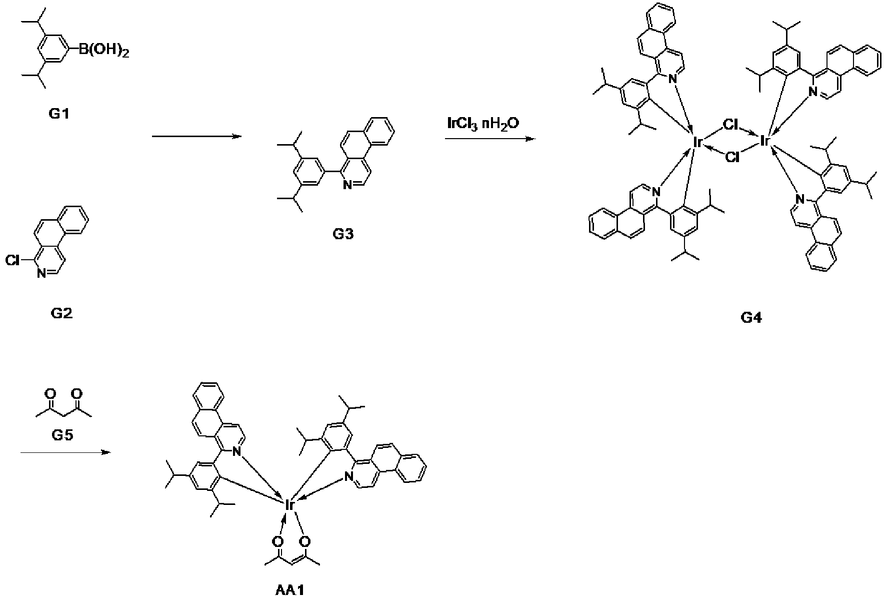

### (1) Synthesis of Compound G3

A 500-ml recovery flask was charged with the following reagent(s) and solvent(s).
Compound G1: 1.1 g (5.15 mmol)
Compound G2: 1.0 g (4.68 mmol)
Pd(Ph₃)₄: 162 mg (0.14 mmol)
Aqueous Na₂CO₃ (10%): 1.0 g/water 10 ml
Toluene: 20 ml
Ethanol: 10 ml

Next, the reaction solution was heated to 90°C in a nitrogen stream and was stirred at this temperature (90°C) for 5 hours. After completion of the reaction and extraction with toluene and water, the product was concentrated and purified by silica gel column chromatography (toluene) to yield 1.1 g of Compound G3 (yield: 70%).

### (2) Synthesis of Compound G4

After degassing a mixed solvent of 2-ethoxyethanol (40 ml) and water (10 ml), 226 mg (0.64 mmol) of iridium (III) chloride hydrate was added to the mixed solvent, and the mixture was stirred at room temperature for 30 minutes. Subsequently, 0.44 g (1.28 mmol) of G3 was added to the mixture, and the mixture was heated to 120°C and was stirred for 10 hours. After cooling, water was added to the product, and the product was filtered and was washed with water and methanol. The product was dried to yield 0.51 g of a red solid G4 (yield: 90%).

### (3) Synthesis of Exemplary Compound AA1

After degassing a 2-ethoxyethanol (10 ml) solvent, 0.18 g (0.10 mmol) of G4 and 50 mg (0.50 mmol) of G5 were added to the solvent, and the product was stirred at room temperature for 30 minutes. Subsequently, 69 mg (0.65 mmol) of sodium carbonate was added to the product, and the product was heated to 120°C and was stirred for 7 hours. After cooling, water was added to the product, and the product was filtered and was washed with water and methanol. The product was purified by silica gel column chromatography (dichloromethane) to yield 40 mg of an exemplary compound AA1 (yield: 37%).

The exemplary compound AA1 was subjected to mass spectrometry with MALDI-TOF-MS (Autoflex LRF manufactured by Bruker).

### [MALDI-TOF-MS]

Measured value: m/z = 968 Calculated value: C₅₅H₅₅IrN₂O₂ = 968

### [Exemplary Embodiments 2 to 51 (Synthesis of Exemplary Compounds)]

Exemplary compounds were synthesized in the same manner as in Exemplary Embodiment 1 except that the raw materials G1, G2, and G5 of Exemplary Embodiment 1 were changed to raw materials 1, 2, and 3 shown in Tables 1 to 8, respectively. Actual values m/z measured by mass spectrometry in the same manner as in Exemplary Embodiment 1 are also shown.

**Table 1**

| Exemplary embodiment | Exemplary compound | Raw material 1 | Raw material 2 | Raw material 3 | MALDI molecular weight |
|---|---|---|---|---|---|
| 2 | A1 | 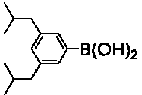 | 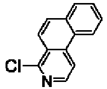 | 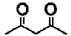 | 2024 |
| 3 | A9 | 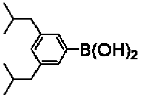 | 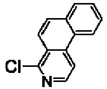 | 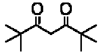 | 1109 |
| 4 | A10 | 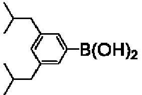 | 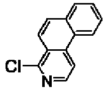 | 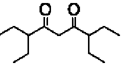 | 1137 |
| 5 | A11 | 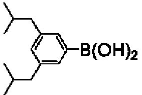 | 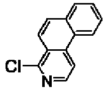 | 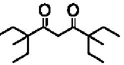 | 1165 |
| 6 | A22 | 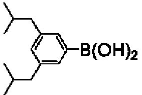 | 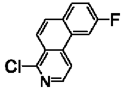 | 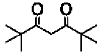 | 1145 |
| 7 | A24 | 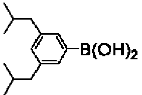 | 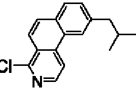 | 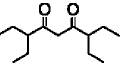 | 1249 |
| 8 | A30 | 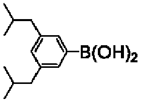 | 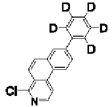 | 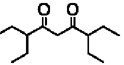 | 1299 |

**Table 2**

| Exemplary embodiment | Exemplary compound | Raw material 1 | Raw material 2 | Raw material 3 | MALDI molecular weight |
|---|---|---|---|---|---|
| 9 | A37 | 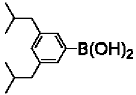 | 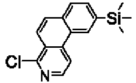 | 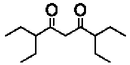 | 1281 |
| 10 | AA4 | 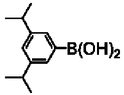 | 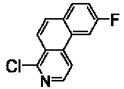 | 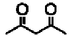 | 1004 |
| 11 | AA9 | 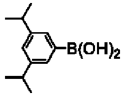 | 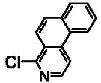 | 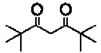 | 1052 |
| 12 | AA10 | 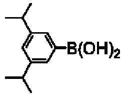 | 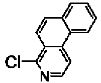 | 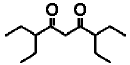 | 1080 |
| 13 | AA11 | 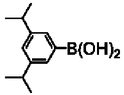 | 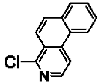 | 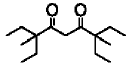 | 1109 |
| 14 | AA22 | 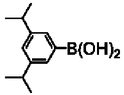 | 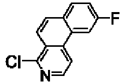 | 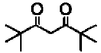 | 1088 |
| 15 | AA23 | 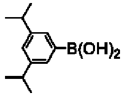 | 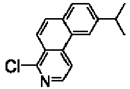 | 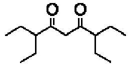 | 1165 |

**Table 3**

| Exemplary embodiment | Exemplary compound | Raw material 1 | Raw material 2 | Raw material 3 | MALDI molecular weight |
|---|---|---|---|---|---|
| 16 | AA25 | 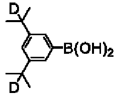 | 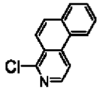 | 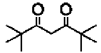 | 1056 |
| 17 | AA29 | 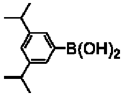 | 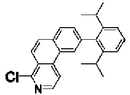 | 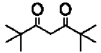 | 1373 |
| 18 | AA30 | 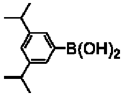 | 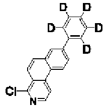 | 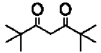 | 1215 |
| 19 | AA31 | 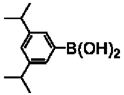 | 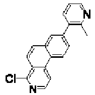 | 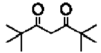 | 1235 |
| 20 | AA34 | 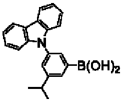 | 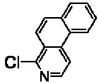 | 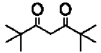 | 1299 |
| 21 | AA36 | 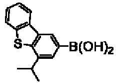 | 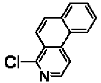 | 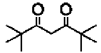 | 1181 |
| 22 | AA38 | 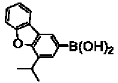 | 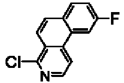 | 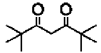 | 1184 |

**Table 4**

| Exemplary embodiment | Exemplary compound | Raw material 1 | Raw material 2 | Raw material 3 | MALDI molecular weight |
|---|---|---|---|---|---|
| 23 | AA42 | 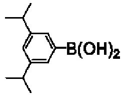 | 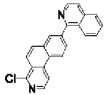 | 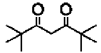 | 1307 |
| 24 | C1 | 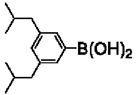 | 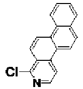 | 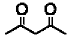 | 1125 |
| 25 | C9 | 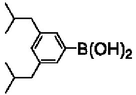 | 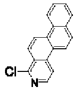 | 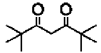 | 1209 |
| 26 | C10 | 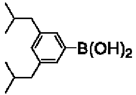 | 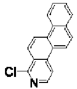 | 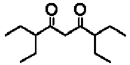 | 1237 |
| 27 | C11 | 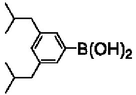 | 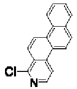 | 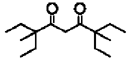 | 1265 |
| 28 | C22 | 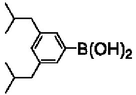 | 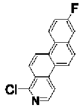 | 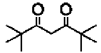 | 1245 |
| 29 | C23 | 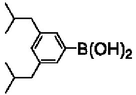 | 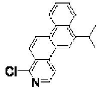 | 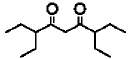 | 1321 |

**Table 5**

| Exemplary embodiment | Exemplary compound | Raw material 1 | Raw material 2 | Raw material 3 | MALDI molecular weight |
|---|---|---|---|---|---|
| 30 | C24 | 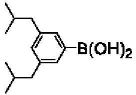 | 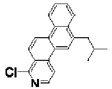 | 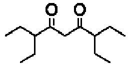 | 1349 |
| 31 | C29 | 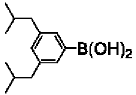 | 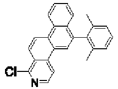 | 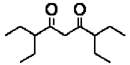 | 1449 |
| 32 | C30 | 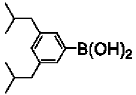 | 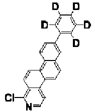 | 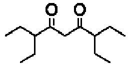 | 1399 |
| 33 | C31 | 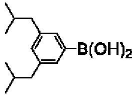 | 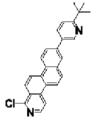 | 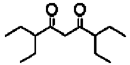 | 1503 |
| 34 | C36 | 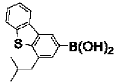 | 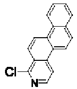 | 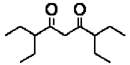 | 1337 |
| 35 | C40 | 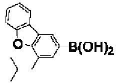 | 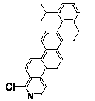 | 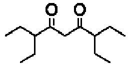 | 1625 |

**Table 6**

| Exemplary embodiment | Exemplary compound | Raw material 1 | Raw material 2 | Raw material 3 | MALDI molecular weight |
|---|---|---|---|---|---|
| 36 | CC1 | 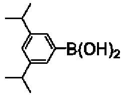 | 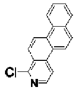 | 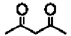 | 1180 |
| 37 | CC3 | 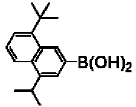 | 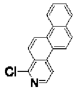 | 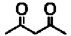 | 1197 |
| 38 | CC9 | 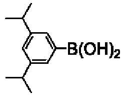 | 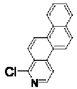 | 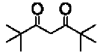 | 1153 |
| 39 | CC10 | 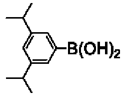 | 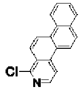 | 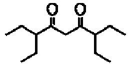 | 1181 |
| 40 | CC11 | 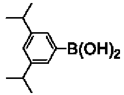 | 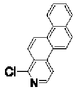 | 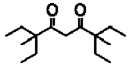 | 1209 |
| 41 | C22 | 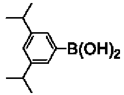 | 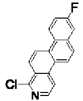 | 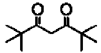 | 1159 |

**Table 7**

| Exemplary embodiment | Exemplary compound | Raw material 1 | Raw material 2 | Raw material 3 | MALDI molecular weight |
|---|---|---|---|---|---|
| 42 | CC23 | 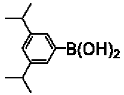 | 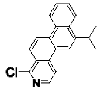 | 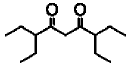 | 1265 |
| 43 | CC29 | 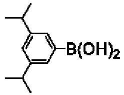 | 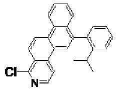 | 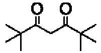 | 1389 |
| 44 | CC30 | 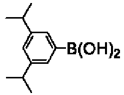 | 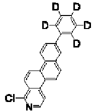 | 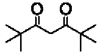 | 1315 |
| 45 | CC31 | 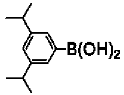 | 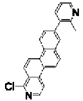 | 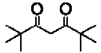 | 1335 |
| 46 | CC32 | 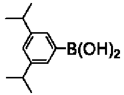 | 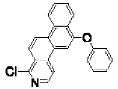 | 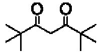 | 1337 |
| 47 | CC33 | 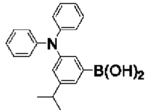 | 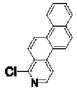 | 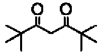 | 1403 |

**Table 8**

| Exemplary embodiment | Exemplary compound | Raw material 1 | Raw material 2 | Raw material 3 | MALDI molecular weight |
|---|---|---|---|---|---|
| 48 | CC35 | 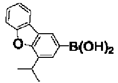 | 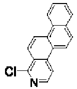 | 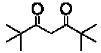 | 1249 |
| 49 | CC38 | 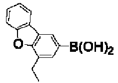 | 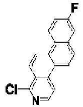 | 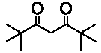 | 1285 |
| 50 | CC41 | 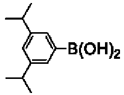 | 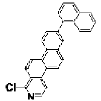 | 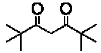 | 1405 |
| 51 | CC42 | 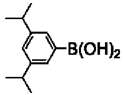 | 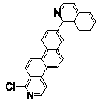 | 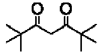 | 1407 |

### [Exemplary Embodiment 52 (Synthesis of Exemplary Compound B5)]

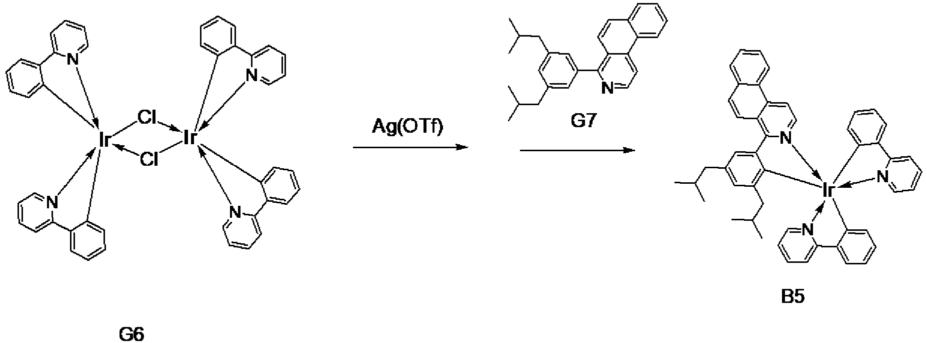

100 ml of dichloromethane was added to 1.0 g (0.93 mmol) of G6 and was purged with nitrogen. 503 mg (1.96 mmol) of silver trifluoromethanesulfonate dissolved in 10 ml of methanol was added dropwise to the product, and the product was stirred at room temperature for 8 hours. Subsequently, the product was filtered (Celite), was washed with dichloromethane, and was concentrated to yield a yellow solid.

Next, 10 ml of diethylene glycol dimethyl ether was added to the yellow solid and 170 mg (0.47 mmol) of G7, and the product was heated with stirring at 170°C for 7 hours. After cooling, water was added to the product, and the product was filtered and was washed with water and methanol. The product was purified by silica gel column chromatography (dichloromethane) to yield 32 mg of an exemplary compound B5 (yield: 8%).

The exemplary compound B5 was subjected to mass spectrometry in the same manner as in Exemplary Embodiment 1.

### [MALDI-TOF-MS]

Measured value: m/z = 1079 Calculated value: C₄₉H₄₄IrN₃ = 867

### [Exemplary Embodiments 53 to 69 (Synthesis of Exemplary Compounds)]

### (1) Exemplary Embodiments 53 and 62

A dichloro dimer derivative (a compound corresponding to G4) was synthesized in the same manner as in Exemplary Embodiment 1 except that the raw materials G1 and G2 of Exemplary Embodiment 1 were changed to raw materials 1 and 2 shown in Tables 9 and 11, respectively. Furthermore, exemplary compounds were synthesized in the same manner as in Exemplary Embodiment 52 except that the raw material G6 of Exemplary Embodiment 52 was changed to the dichloro dimer derivative and the raw material G7 was changed to the raw material 5 shown in Tables 9 and 11. Actual values m/z measured by mass spectrometry in the same manner as in Exemplary Embodiment 52 are also shown.

### (2) Exemplary Embodiments 54 to 61 and 63 to 69

Exemplary compounds were synthesized in the same manner as in Exemplary Embodiment 52 except that the raw materials G6 and G7 of Exemplary Embodiment 52 were changed to raw materials 4 and 5 shown in Tables 9 to 12, respectively. Actual values m/z measured by mass spectrometry in the same manner as in Exemplary Embodiment 52 are also shown.

**Table 9**

| Exemplary embodiment | Exemplary compound | Raw material 1 | Raw material 2 | Raw material 4 | Raw material 5 | MALDI molecular weight |
|---|---|---|---|---|---|---|
| 53 | B1 | 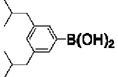 | 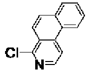 | - | 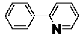 | 1079 |
| 54 | B7 | - | - | 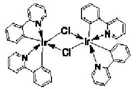 | 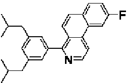 | 885 |
| 55 | B10 | - | - | 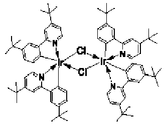 | 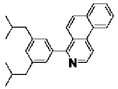 | 1092 |
| 56 | B12 | - | - | 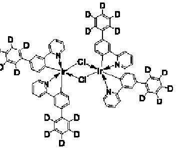 | 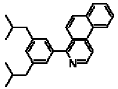 | 1029 |
| 57 | B17 | - | - | 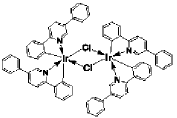 | 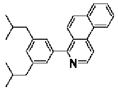 | 1019 |

**Table 10**

| Exemplary embodiment | Exemplary compound | Raw material 1 | Raw material 2 | Raw material 4 | Raw material 5 | MALDI molecular weight |
|---|---|---|---|---|---|---|
| 58 | B19 | - | - | 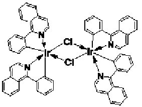 | 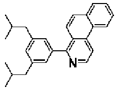 | 967 |
| 59 | B21 | - | - | 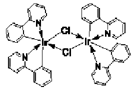 | 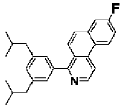 | 885 |
| 60 | B23 | - | - | 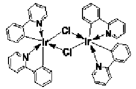 | 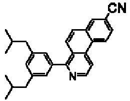 | 892 |
| 61 | BB1 | - | - | 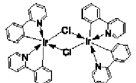 | 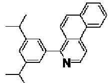 | 839 |

**Table 11**

| Exemplary embodiment | Exemplary compound | Raw material 1 | Raw material 2 | Raw material 4 | Raw material 5 | MALDI molecular weight |
|---|---|---|---|---|---|---|
| 62 | D1 | 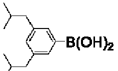 | 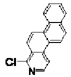 | - | 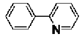 | 1180 |
| 63 | D5 | - | - | 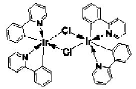 | 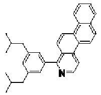 | 917 |
| 64 | D10 | - | - | 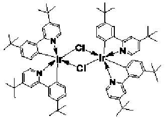 | 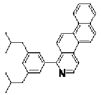 | 1142 |
| 65 | D11 | - | - | 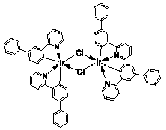 | 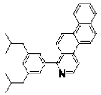 | 1069 |
| 66 | D19 | | | 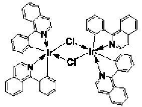 | 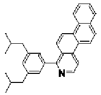 | 1017 |

**Table 12**

| Exemplary embodiment | Exemplary compound | Raw material 1 | Raw material 2 | Raw material 4 | Raw material 5 | MALDI molecular weight |
|---|---|---|---|---|---|---|
| 67 | D21 | - | - | 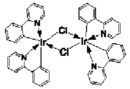 | 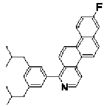 | 935 |
| 68 | D24 | - | - | 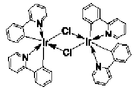 | 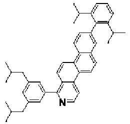 | 1077 |
| 69 | DD1 | - | - | 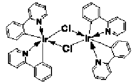 | 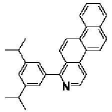 | 889 |

### [Exemplary Embodiments 70 and 71 and Comparative Examples 1 to 4 (Emission Spectrum)]

Emission spectra of the exemplary compounds AA1 and CC1 and comparative compounds 1-b, 2-b, 1-a, and 2-a dissolved in toluene at 1 x 10⁻⁵ mol/L were measured. In the measurement, the emission peak wavelength and the half-value width of photoluminescence were measured with F-4500 manufactured by Hitachi, Ltd. at an excitation wavelength of 350 nm. The half-value width was evaluated in accordance with the following criteria. Table 13 shows the results. The comparative compound 1-b is the compound 1-a described in PTL 1.
AA: 35 nm or less
A: more than 35 nm and less than 40 nm
B: 40 nm or more and less than 60 nm
C: 60 nm or more

**Table 13**

| No. | Exemplary compound | Molecular structure | Emission wavelength (toluene solution) Maximum peak/nm | Half-value width/nm |
|---|---|---|---|---|
| Exemplary embodiment 70 | AA1 | 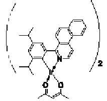 | 605 | 36(A) |
| Comparative example 1 | Comparative compound 1-b | 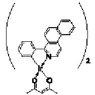 | 607 | 63(C) |
| Comparative example 2 | Comparative compound 2-b | 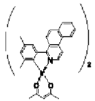 | 607 | 43(B) |
| Exemplary embodiment 71 | CC1 | 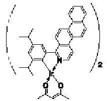 | 615 | 34(AA) |
| Comparative example 3 | Comparative compound 1-a | 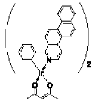 | 613 | 63(C) |
| Comparative example 4 | Comparative compound 2-a | 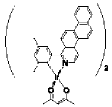 | 620 | 41(B) |

As shown in Table 13, with respect to the emission wavelength, the exemplary compound CC1 with the partial structure Ir(L)ₘ represented by the general formula [2-2] emits longer-wavelength light and has higher color purity than the exemplary compound AA1 with the partial structure Ir(L)ₘ represented by the general formula [2-1].

With respect to the half-value width, the comparative compounds with no bulky substituent at the ortho position of the benzene ring of the main ligand L are rated B or C, whereas the exemplary compounds with a bulky substituent at the same position are rated A or higher and have higher color purity.

### [Exemplary Embodiment 72]

An organic light-emitting element of a bottom emission type was produced. The organic light-emitting element included a positive electrode, a hole-injection layer, a hole-transport layer, an electron-blocking layer, a light-emitting layer, a hole-blocking layer, an electron-transport layer, an electron-injection layer, and a negative electrode sequentially formed on a substrate.

First, an ITO film was formed on a glass substrate and was subjected to desired patterning to form an ITO electrode (positive electrode). The ITO electrode had a thickness of 100 nm. The substrate on which the ITO electrode was formed was used as an ITO substrate in the following process. Vacuum evaporation was then performed by resistance heating in a vacuum chamber at 1.33 x 10⁻⁴ Pa to continuously form an organic compound layer and an electrode layer shown in Table 14 on the ITO substrate. The counter electrode (a metal electrode layer, a negative electrode) had an electrode area of 3 mm².

**Table 14**

| Element structure | Material | | Film thickness (nm) |
|---|---|---|---|
| Negative electrode | A1 | | 100 |
| Electron-injection layer (EIL) | LiF | | 1 |
| Electron-transport layer (ETL) | ET2 | | 20 |
| Hole-blocking layer (HBL) | ET11 | | 20 |
| Light-emitting layer | Host EM16 96wt% | Dopant A1 4wt% | 20 |
| Electron-blocking layer (EBL) | HT12 | | 15 |
| Hole-transport layer (HTL) | HT3 | | 30 |
| Hole-injection layer (HIL) | HT16 | | 5 |

The characteristics of the element were measured and evaluated. Table 15 shows the measurement results of the half-value width of an emission spectrum of the light-emitting element, the maximum external quantum efficiency (E.Q.E.), and the time to a luminance decay rate of 5% in a continuous operation test at a current density of 100 mA/cm².

The half-value width ratio with respect to the half-value width of Comparative Example 5, which was set to 1, was evaluated in accordance with the following criteria.
AA: 0.5 or less
A: more than 0.5 and 0.7 or less
B: more than 0.7 and 1.0 or less
C: more than 1.0

For the maximum external quantum efficiency (E.Q.E.) and the time to a luminance decay rate of 5%, the ratios to the measured values of Comparative Example 5, which are set to 1.0, are shown.

In the present exemplary embodiment, with respect to measuring apparatuses, more specifically, the current-voltage characteristics were measured with a microammeter 4140B manufactured by Hewlett-Packard Co., and the luminous brightness was measured with BM7 manufactured by Topcon Corporation.

### [Exemplary Embodiments 73 to 105 and Comparative Examples 5 and 6]

Organic light-emitting elements were produced in the same manner as in Exemplary Embodiment 72 except that the compounds shown in Tables 15 to 17 were used. Characteristics of the elements were measured and evaluated in the same manner as in Exemplary Embodiment 72. Tables 15 to 17 show the results.

**Table 15**

| | HIL | HTL | EBL | EML | | HBL | ETL | Half-value width | E.Q.E ratio | Luminance decay rate ratio |
|---|---|---|---|---|---|---|---|---|---|---|
| | | | | Host | Dopant | | | | | |
| Exemplary embodiment 72 | HT16 | HT3 | HT12 | EM16 | A1 | ET11 | ET2 | A | 1.1 | 1.1 |
| Exemplary embodiment 73 | HT16 | HT3 | HT12 | EM16 | A9 | ET11 | ET2 | A | 1.1 | 1.1 |
| Exemplary embodiment 74 | HT16 | HT3 | HT12 | EM16 | A10 | ET11 | ET2 | A | 1.1 | 1.1 |
| Exemplary embodiment 75 | HT16 | HT3 | HT12 | EM16 | A22 | ET11 | ET2 | A | 1.1 | 1.1 |
| Exemplary embodiment 76 | HT16 | HT3 | HT12 | EM16 | A30 | ET11 | ET2 | A | 1.1 | 1.1 |
| Exemplary embodiment 77 | HT16 | HT3 | HT12 | EM16 | AA1 | ET11 | ET2 | AA | 1.1 | 1.1 |
| Exemplary embodiment 78 | HT16 | HT3 | HT12 | EM16 | AA9 | ET11 | ET2 | AA | 1.1 | 1.1 |
| Exemplary embodiment 79 | HT16 | HT3 | HT12 | EM16 | AA10 | ET11 | ET2 | AA | 1.1 | 1.1 |
| Exemplary embodiment 80 | HT16 | HT3 | HT12 | EM16 | AA11 | ET11 | ET2 | AA | 1.1 | 1.1 |
| Exemplary embodiment 81 | HT16 | HT3 | HT12 | EM16 | AA22 | ET11 | ET2 | AA | 1.1 | 1.1 |
| Exemplary embodiment 82 | HT16 | HT3 | HT12 | EM16 | AA30 | ET11 | ET2 | AA | 1.1 | 1.1 |
| Exemplary embodiment 83 | HT16 | HT3 | HT12 | EM16 | AA31 | ET11 | ET2 | AA | 1.1 | 1.1 |
| Exemplary embodiment 84 | HT16 | HT3 | HT12 | EM16 | AA42 | ET11 | ET2 | AA | 1.1 | 1.1 |

**Table 16**

| | HIL | HTL | EBL | EML | | HBL | ETL | Half-value width | E.Q.E ratio | Luminance decay rate ratio |
|---|---|---|---|---|---|---|---|---|---|---|
| | | | | Host | Dopant | | | | | |
| Exemplary embodiment 85 | HT16 | HT3 | HT12 | EM16 | C1 | ET11 | ET2 | A | 1.1 | 1.1 |
| Exemplary embodiment 86 | HT16 | HT3 | HT12 | EM16 | C9 | ET11 | ET2 | A | 1.1 | 1.1 |
| Exemplary embodiment 87 | HT16 | HT3 | HT12 | EM16 | C10 | ET11 | ET2 | A | 1.1 | 1.1 |
| Exemplary embodiment 88 | HT16 | HT3 | HT12 | EM16 | CC11 | ET11 | ET2 | A | 1.1 | 1.1 |
| Exemplary embodiment 89 | HT16 | HT3 | HT12 | EM16 | C24 | ET11 | ET2 | A | 1.1 | 1.1 |
| Exemplary embodiment 90 | HT16 | HT3 | HT12 | EM16 | C29 | ET11 | ET2 | A | 1.1 | 1.1 |
| Exemplary embodiment 91 | HT16 | HT3 | HT12 | EM16 | CC1 | ET11 | ET2 | AA | 1.2 | 1.2 |
| Exemplary embodiment 92 | HT16 | HT3 | HT12 | EM16 | CC9 | ET11 | ET2 | AA | 1.2 | 1.2 |
| Exemplary embodiment 93 | HT16 | HT3 | HT12 | EM16 | CC10 | ET11 | ET2 | AA | 1.2 | 1.2 |
| Exemplary embodiment 94 | HT16 | HT3 | HT12 | EM16 | CC11 | ET11 | ET2 | AA | 1.2 | 1.2 |
| Exemplary embodiment 95 | HT16 | HT3 | HT12 | EM16 | CC22 | ET11 | ET2 | AA | 1.2 | 1.2 |
| Exemplary embodiment 96 | HT16 | HT3 | HT12 | EM16 | CC23 | ET11 | ET2 | AA | 1.2 | 1.3 |
| Exemplary embodiment 97 | HT16 | HT3 | HT12 | EM16 | CC30 | ET11 | ET2 | AA | 1.2 | 1.3 |
| Exemplary embodiment 98 | HT16 | HT3 | HT12 | EM16 | CC31 | ET11 | ET2 | AA | 1.2 | 1.2 |
| Exemplary embodiment 99 | HT16 | HT3 | HT12 | EM16 | CC42 | ET11 | ET2 | AA | 1.2 | 1.2 |

**Table 17**

| | HIL | HTL | EBL | EML | | HBL | ETL | Half-value width | E.Q.E ratio | Luminance decay rate ratio |
|---|---|---|---|---|---|---|---|---|---|---|
| | | | | Host | Dopant | | | | | |
| Exemplary embodiment 100 | HT16 | HT3 | HT10 | EM9 | AA9 | ET12 | ET3 | AA | 1.1 | 1.2 |
| Exemplary embodiment 101 | HT16 | HT3 | HT19 | EM14 | AA9 | ET16 | ET3 | AA | 1.1 | 1.1 |
| Exemplary embodiment 102 | HT16 | HT3 | HT10 | EM14 | AA9 | ET11 | ET3 | AA | 1.1 | 1.2 |
| Exemplary embodiment 103 | HT16 | HT3 | HT10 | EM9 | AA9 | ET12 | ET3 | AA | 1.2 | 1.3 |
| Exemplary embodiment 104 | HT16 | HT3 | HT19 | EM14 | AA9 | ET16 | ET3 | AA | 1.2 | 1.2 |
| Exemplary embodiment 105 | HT16 | HT3 | HT10 | EM14 | AA9 | ET11 | ET3 | AA | 1.2 | 1.3 |
| Comparative example 5 | HT16 | HT3 | HT12 | EM16 | Comparative compound 1-a | ET11 | ET2 | C | 1.0 | 1.0 |
| Comparative example 6 | HT16 | HT3 | HT12 | EM16 | Comparative compound 2-a | ET11 | ET2 | B | 1.1 | 1.1 |

As shown in Tables 15 to 17, the half-value widths of Comparative Example 5 and Comparative Example 6 were rated C and B, respectively. By contrast, the exemplary embodiments had a narrow half-value width rated AA or A and emitted red light with high color purity. This is because a bulky substituent at the ortho position of the benzene ring of the main ligand L in the organometallic complex according to the present embodiment reduces molecular vibration of the main ligand L. Furthermore, a bulky substituent at the ortho position of the benzene ring of the main ligand L in the organometallic complex according to the present embodiment increases the intermolecular distance, reduces TTA, and improves the luminance decay rate as compared with the organic light-emitting elements according to the comparative examples including the comparative compounds.

The present disclosure can provide an organometallic complex that can emit red light with high efficiency and high color purity.

The present invention is as defined in the independent claims. further beneficial embodiments are defined by the dependent claims.

## Claims

1. An organometallic complex represented by the following general formula [1]:
Ir(L)ₘ(L')ₙ [1]
wherein Ir denotes iridium,
L and L' denote different bidentate ligands,
m is 2, and m + n = 3,
a partial structure Ir(L)ₘ is a partial structure represented by the following general formula [2-1] or [2-2]: 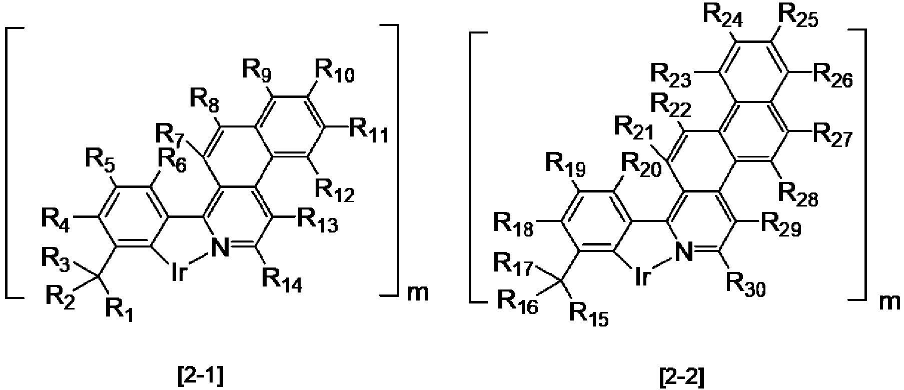
in the formula [2-1], R₁ to R₃ are each independently selected from the group consisting of a hydrogen atom, a deuterium atom, a substituted or unsubstituted alkyl group, a substituted or unsubstituted alkoxy group, a substituted or unsubstituted silyl group, a substituted or unsubstituted aryl group, and a substituted or unsubstituted heteroaryl group, at least one of R₁ to R₃ is not a hydrogen atom or a deuterium atom, provided that, when at least one of R₁ to R₃ is not a hydrogen atom or a deuterium atom and when two of R₁ to R₃ are a hydrogen atom or a deuterium atom, the other one of R₁ to R₃ is a substituted or unsubstituted secondary or higher alkyl group, and adjacent R₁ to R₃ may be bonded together to form a ring,
R₄ to R₁₄ are each independently selected from the group consisting of a hydrogen atom, a deuterium atom, a halogen atom, a substituted or unsubstituted alkyl group, a substituted or unsubstituted alkoxy group, a substituted or unsubstituted silyl group, a substituted or unsubstituted amino group, a substituted or unsubstituted allyl group, a substituted or unsubstituted aryl group, a substituted or unsubstituted heteroaryl group, a substituted or unsubstituted aryloxy group, a substituted or unsubstituted heteroaryloxy group, and a cyano group, and adjacent R₄ to R₁₄ may be bonded together to form a ring,
in the formula [2-2], R₁₅ to R₁₇ are each independently selected from the group consisting of a hydrogen atom, a deuterium atom, a substituted or unsubstituted alkyl group, a substituted or unsubstituted alkoxy group, a substituted or unsubstituted silyl group, a substituted or unsubstituted aryl group, and a substituted or unsubstituted heteroaryl group, at least one of R₁₅ to R₁₇ is not a hydrogen atom or a deuterium atom, provided that, when at least one of R₁₅ to R₁₇ is not a hydrogen atom or a deuterium atom and when two of R₁₅ to R₁₇ are a hydrogen atom or a deuterium atom, the other one of R₁₅ to R₁₇ is a substituted or unsubstituted secondary or higher alkyl group, and adjacent R₁₅ to R₁₇ may be bonded together to form a ring,
R₁₈ to R₃₀ are each independently selected from the group consisting of a hydrogen atom, a deuterium atom, a halogen atom, a substituted or unsubstituted alkyl group, a substituted or unsubstituted alkoxy group, a substituted or unsubstituted silyl group, a substituted or unsubstituted amino group, a substituted or unsubstituted allyl group, a substituted or unsubstituted aryl group, a substituted or unsubstituted heteroaryl group, a substituted or unsubstituted aryloxy group, a substituted or unsubstituted heteroaryloxy group, and a cyano group, and adjacent R₁₈ to R₃₀ may be bonded together to form a ring,
L' denotes a bidentate ligand represented by the following general formula [3] or [4]: 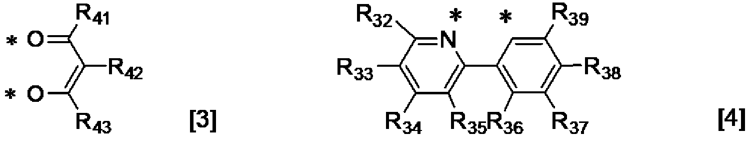
in the formula [3], R₄₁ to R₄₃ are each independently selected from the group consisting of a hydrogen atom, a deuterium atom, a fluorine atom, a substituted or unsubstituted alkyl group, a substituted or unsubstituted alkoxy group, a substituted or unsubstituted amino group, a substituted or unsubstituted aryl group, and a substituted or unsubstituted heteroaryl group, and adjacent R₄₁ to R₄₃ may be bonded together to form a ring, and
in the formula [4], R₃₂ to R₃₉ are each independently selected from the group consisting of a hydrogen atom, a deuterium atom, a fluorine atom, a substituted or unsubstituted alkyl group, a substituted or unsubstituted alkoxy group, a substituted or unsubstituted amino group, a substituted or unsubstituted allyl group, a substituted or unsubstituted aryl group, and a substituted or unsubstituted heteroaryl group, and adjacent R₃₂ to R₃₉ may be bonded together to form a ring.

2. The organometallic complex according to Claim 1, wherein the partial structure Ir(L)ₘ is a partial structure represented by the general formula [2-1].

3. The organometallic complex according to Claim 2, wherein at least two of R₁ to R₃ are not a hydrogen atom or a deuterium atom.

4. The organometallic complex according to Claim 3, wherein at least two of R₁ to R₃ are a substituted or unsubstituted alkyl group.

5. The organometallic complex according to Claim 1, wherein the partial structure Ir(L)ₘ is a partial structure represented by the general formula [2-2].

6. The organometallic complex according to Claim 5, wherein at least two of R₁₅ to R₁₇ are not a hydrogen atom or a deuterium atom.

7. The organometallic complex according to Claim 6, wherein at least two of R₁₅ to R₁₇ are a substituted or unsubstituted alkyl group.

8. The organometallic complex according to any one of Claims 1 to 7, wherein R₅ and R₁₉ are not a hydrogen atom or a deuterium atom.

9. An organic light-emitting element comprising: a first electrode (2); a second electrode (5); and an organic compound layer (4, 22) between the first electrode and the second electrode, wherein the organic compound layer has a layer containing the organometallic complex according to any one of Claims 1 to 8.

10. The organic light-emitting element according to Claim 9, wherein the layer containing the organometallic complex is a light-emitting layer (43, 44).

11. The organic light-emitting element according to Claim 10, wherein the organic light-emitting element emits red light.

12. The organic light-emitting element according to Claim 10 or 11, further comprising another light-emitting layer on the light-emitting layer, wherein the other light-emitting layer emits light of a different color from the light-emitting layer.

13. The organic light-emitting element according to Claim 12, wherein the organic light-emitting element emits white light.

14. A display apparatus comprising a plurality of pixels (10, 10R, 10G, 10B), wherein at least one of the plurality of pixels includes the organic light-emitting element according to any one of Claims 9 to 13 and an active element coupled to the organic light-emitting element.

15. An image display apparatus comprising:
an input portion configured to input image information; and
a display unit (1201, 1302, 1311, 1312) configured to output an image,
wherein the display unit includes the display apparatus according to claim 14.

16. A photoelectric conversion apparatus comprising:
an optical unit including a plurality of lenses;
an imaging element configured to receive light passing through the optical unit; and
a display unit configured to display an image taken by the imaging element,
wherein the display unit includes the organic light-emitting element according to any one of Claims 9 to 13.

17. Electronic equipment comprising:
a housing (1104, 1203, 1313, 1401);
a communication unit configured to communicate with the outside; and
a display unit,
wherein the display unit is the organic light-emitting element according to any one of Claims 9 to 13.

18. A lighting apparatus comprising:
a light source (1402) including the organic light-emitting element according to any one of Claims 9 to 13; and
a light-diffusing unit (1405) or an optical filter (1404) configured to transmit light emitted by the light source.

19. A moving body comprising:
a body (1503); and
a lamp provided on the body,
wherein the lamp includes the organic light-emitting element according to any one of Claims 9 to 13.

20. An image-forming apparatus comprising:
a photosensitive member (27); and
an exposure light source (28) configured to irradiate the photosensitive member with light,
wherein the exposure light source includes the organic light-emitting element according to any one of Claims 9 to 13.

## Patentansprüche

1. Organometallischer Komplex, dargestellt durch die folgende allgemeine Formel [1]:
Ir(L)ₘ(L')ₙ [1]
wobei Ir Iridium bezeichnet,
L und L' unterschiedliche bidentate Liganden bezeichnen,
m 2 ist, und m + n = 3 ist,
eine Teilstruktur Ir(L)ₘ eine Teilstruktur ist, dargestellt durch die folgende allgemeine Formel [2-1] oder [2-2]: 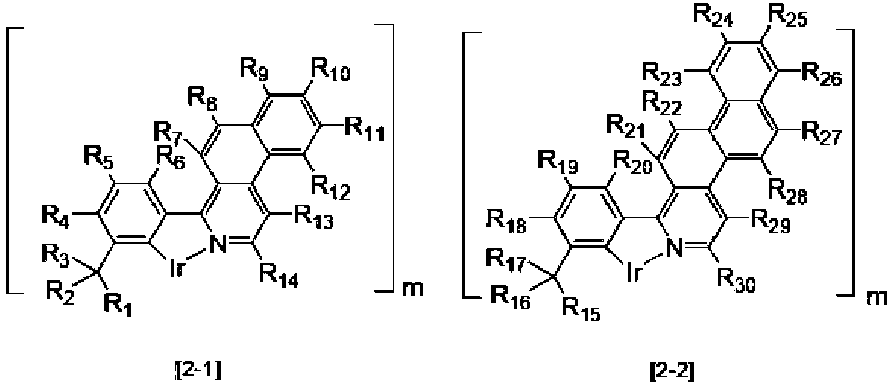
in der Formel [2-1], sind R₁ bis R₃ jeweils unabhängig ausgewählt aus der Gruppe bestehend aus einem Wasserstoffatom, einem Deuteriumatom, einer substituierten oder unsubstituierten Alkylgruppe, einer substituierten oder unsubstituierten Alkoxygruppe, einer substituierten oder unsubstituierten Silylgruppe, einer substituierten oder unsubstituierten Arylgruppe, und einer substituierten oder unsubstituierten Heteroarylgruppe, ist zumindest eine von R₁ bis R₃ kein Wasserstoffatom oder kein Deuteriumatom, vorausgesetzt, dass, wenn zumindest eine von R₁ bis R₃ kein Wasserstoffatom oder kein Deuteriumatom ist und wenn zwei von R₁ bis R₃ ein Wasserstoffatom oder ein Deuteriumatom sind, ist die eine andere von R₁ bis R₃ eine substituierte oder unsubstituierte sekundäre oder höhere Alkylgruppe, und können benachbarte R₁ bis R₃ miteinander verbunden sein, um einen Ring zu bilden,
sind R₄ bis R₁₄ jeweils unabhängig ausgewählt aus der Gruppe bestehend aus einem Wasserstoffatom, einem Deuteriumatom, einem Halogenatom, einer substituierten oder unsubstituierten Alkylgruppe, einer substituierten oder unsubstituierten Alkoxygruppe, einer substituierten oder unsubstituierten Silylgruppe, einer substituierten oder unsubstituierten Aminogruppe, einer substituierten oder unsubstituierten Allylgruppe, einer substituierten oder unsubstituierte Arylgruppe, einer substituierten oder unsubstituierten Heteroarylgruppe, einer substituierten oder unsubstituierten Aryloxygruppe, einer substituierten oder unsubstituierten Heteroaryloxygruppe, und einer Cyanogruppe, und können benachbarte R₄ bis R₁₄ miteinander verbunden sein, um einen Ring zu bilden,
in der Formel [2-2], sind R₁₅ bis R₁₇ jeweils unabhängig ausgewählt aus der Gruppe bestehend aus einem Wasserstoffatom, einem Deuteriumatom, einer substituierten oder unsubstituierten Alkylgruppe, einer substituierten oder unsubstituierten Alkoxygruppe, einer substituierten oder unsubstituierten Silylgruppe, einer substituierten oder unsubstituierten Arylgruppe und einer substituierten oder unsubstituierten Heteroarylgruppe, ist zumindest eine von R₁₅ bis R₁₇ kein Wasserstoffatom oder kein Deuteriumatom, vorausgesetzt, dass, wenn zumindest eine von R₁₅ bis R₁₇ kein Wasserstoffatom oder kein Deuteriumatom ist und wenn zwei von R₁₅ bis R₁₇ ein Wasserstoff oder ein Deuteriumatom sind, ist die eine andere von R₁₅ bis R₁₇ eine substituierte oder unsubstituierte sekundäre oder höhere Alkylgruppe, und können benachbarte R₁₅ bis R₁₇ miteinander verbunden sein, um einen Ring zu bilden,
sind R₁₈ bis R₃₀ jeweils unabhängig ausgewählt aus der Gruppe bestehend aus einem Wasserstoffatom, einem Deuteriumatom, einem Halogenatom, einer substituierten oder unsubstituierten Alkylgruppe, einer substituierten oder unsubstituierten Alkoxygruppe, einer substituierten oder unsubstituierten Silylgruppe, einer substituierten oder unsubstituierten Aminogruppe, einer substituierten oder unsubstituierten Allylgruppe, einer substituierten oder unsubstituierten Arylgruppe, einer substituierten oder unsubstituierten Heteroarylgruppe, einer substituierten oder unsubstituierten Aryloxygruppe, einer substituierten oder unsubstituierten Heteroaryloxygruppe, und einer Cyanogruppe, und können benachbarte R₁₈ bis R₃₀ miteinander verbunden sein, um einen Ring zu bilden,
bezeichnet L' einen bidentaten Liganden, dargestellt durch die folgende allgemeine Formel [3] oder [4]: 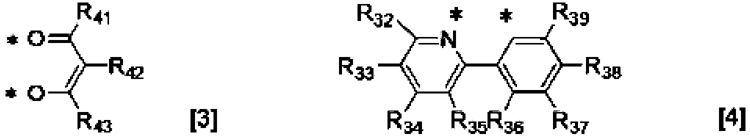
in der Formel [3], sind R₄₁ bis R₄₃ jeweils unabhängig ausgewählt aus der Gruppe bestehend aus einem Wasserstoffatom, einem Deuteriumatom, einem Fluoratom, einer substituierten oder unsubstituierten Alkylgruppe, einer substituierten oder unsubstituierten Alkoxygruppe, einer substituierten oder unsubstituierten Aminogruppe, einer substituierten oder unsubstituierten Arylgruppe, und einer substituierten oder unsubstituierten Heteroarylgruppe, und können benachbarte R₄₁ bis R₄₃ miteinander verbunden sein, um einen Ring zu bilden, und
in der Formel [4], sind R₃₂ bis R₃₉ jeweils unabhängig ausgewählt aus der Gruppe bestehend aus einem Wasserstoffatom, einem Deuteriumatom, einem Fluoratom, einer substituierten oder unsubstituierten Alkylgruppe, einer substituierten oder unsubstituierten Alkoxygruppe, einer substituierten oder unsubstituierten Aminogruppe, einer substituierten oder unsubstituierten Allylgruppe, einer substituierten oder unsubstituierten Arylgruppe, und einer substituierten oder unsubstituierten Heteroarylgruppe, und können benachbarte R₃₂ bis R₃₉ miteinander verbunden sein, um einen Ring zu bilden.

2. Organometallischer Komplex nach Anspruch 1, wobei die Teilstruktur Ir(L)ₘ eine Teilstruktur ist, dargestellt durch die allgemeine Formel [2-1].

3. Organometallischer Komplex nach Anspruch 2, wobei zumindest zwei von R₁ bis R₃ kein Wasserstoffatom oder kein Deuteriumatom sind.

4. Organometallischer Komplex nach Anspruch 3, wobei zumindest zwei von R₁ bis R₃ eine substituierte oder unsubstituierte Alkylgruppe sind.

5. Organometallischer Komplex nach Anspruch 1, wobei die Teilstruktur Ir(L)ₘ eine Teilstruktur ist, dargestellt durch die allgemeine Formel [2-2].

6. Organometallischer Komplex nach Anspruch 5, wobei zumindest zwei von R₁₅ bis R₁₇ kein Wasserstoffatom oder kein Deuteriumatom sind.

7. Organometallischer Komplex nach Anspruch 6, wobei zumindest zwei von R₁₅ bis R₁₇ eine substituierte oder unsubstituierte Alkylgruppe sind.

8. Organometallischer Komplex nach einem der Ansprüche 1 bis 7, wobei R₅ und R₁₉ kein Wasserstoffatom oder kein Deuteriumatom sind.

9. Organisches lichtemittierendes Element, umfassend: eine erste Elektrode (2); eine zweite Elektrode (5); und eine organische Verbindungsschicht (4, 22) zwischen der ersten Elektrode und der zweiten Elektrode, wobei die organische Verbindungsschicht eine Schicht aufweist, die den organometallischen Komplex nach einem der Ansprüche 1 bis 8 enthält.

10. Organisches lichtemittierendes Element nach Anspruch 9, wobei die Schicht, die den organometallischen Komplex enthält, eine lichtemittierende Schicht (43, 44) ist.

11. Organisches lichtemittierendes Element nach Anspruch 10, wobei das organische lichtemittierende Element rotes Licht emittiert.

12. Organisches lichtemittierendes Element nach Anspruch 10 oder 11, ferner umfassend eine andere lichtemittierende Schicht auf der lichtemittierenden Schicht, wobei die andere lichtemittierende Schicht Licht einer anderen Farbe als die lichtemittierende Schicht emittiert.

13. Organisches lichtemittierendes Element nach Anspruch 12, wobei das organische lichtemittierende Element weißes Licht emittiert.

14. Anzeigevorrichtung, umfassend eine Vielzahl von Pixeln (10, 10R, 10G, 10B), wobei zumindest eine der Vielzahl von Pixeln das organische lichtemittierende Element nach einem der Ansprüche 9 bis 13 und ein Aktivelement, das an das organische lichtemittierende Element gekoppelt ist, beinhaltet.

15. Bildanzeigevorrichtung, umfassend:
einen Eingabeabschnitt konfiguriert, um Bildinformationen einzugeben; und
eine Anzeigeeinheit (1201, 1302, 1311, 1312) konfiguriert, um ein Bild auszugeben,
wobei die Anzeigeeinheit die Anzeigevorrichtung nach Anspruch 14 beinhaltet.

16. Photoelektrische Umwandlungsvorrichtung, umfassend:
eine optische Einheit, die eine Vielzahl von Linsen beinhaltet;
ein Bildgebungselement konfiguriert, um Licht zu empfangen, das durch die optische Einheit läuft; und
eine Anzeigeeinheit konfiguriert, um ein Bild anzuzeigen, das durch das Bildgebungselement aufgenommen wurde,
wobei die Anzeigeeinheit das organische lichtemittierende Element nach einem der Ansprüche 9 bis 13 beinhaltet.

17. Elektronische Ausrüstung, umfassend:
ein Gehäuse (1104, 1203, 1313, 1401);
eine Kommunikationseinheit konfiguriert, um mit der Außenwelt zu kommunizieren; und
eine Anzeigeeinheit,
wobei die Anzeigeeinheit das organische lichtemittierende Element nach einem der Ansprüche 9 bis 13 ist.

18. Beleuchtungsvorrichtung, umfassend:
eine Lichtquelle (1402), die das organische lichtemittierende Element nach einem der Ansprüche 9 bis 13 beinhaltet; und
eine Lichtstreueinheit (1405) oder ein optischer Filter (1404) konfiguriert, um Licht, das von der Lichtquelle emittiert wurde, zu transmittieren.

19. Bewegender Körper, umfassend:
einen Körper (1503); und
eine Lampe, die auf dem Körper bereitgestellt ist,
wobei die Lampe das organische lichtemittierende Element nach einem der Ansprüche 9 bis 13 beinhaltet.

20. Bilderzeugungsvorrichtung, umfassend:
ein lichtempfindliches Bauteil (27); und
eine Belichtungslichtquelle (28) konfiguriert, um das lichtempfindliche Bauteil mit Licht zu bestrahlen,
wobei die Belichtungslichtquelle das organische lichtemittierende Element nach einem der Ansprüche 9 bis 13 beinhaltet.

## Revendications

1. Complexe organométallique représenté par la formule générale [1] suivante :
Ir(L)ₘ(L')ₙ [1]
dans laquelle Ir représente un iridium,
L et L' désignent des ligands bidentés différents,
m est 2, et m + n = 3,
une structure partielle Ir(L)ₘ est une structure partielle représentée par la formule générale [2-1] ou [2-2] suivante : 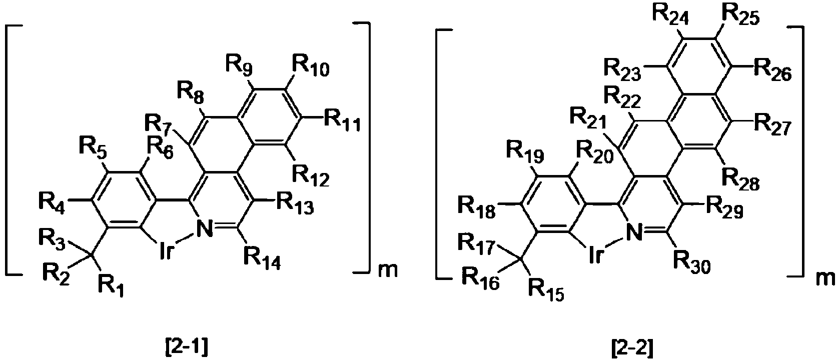
dans la formule [2-1], R₁ à R₃ sont sélectionnés chacun indépendamment dans le groupe consistant en un atome d'hydrogène, un atome de deutérium, un groupe alkyle substitué ou non substitué, un groupe alcoxy substitué ou non substitué, un groupe silyle substitué ou non substitué, un groupe aryle substitué ou non substitué, et un groupe hétéroaryle substitué ou non substitué, au moins un parmi R₁ à R₃ n'est pas un atome d'hydrogène ou un atome de deutérium, à condition que quand au moins un parmi R₁ à R₃ n'est pas un atome d'hydrogène ou un atome de deutérium et que deux parmi R₁ à R₃ sont un atome d'hydrogène ou un atome de deutérium, l'autre parmi R₁ à R₃ soit un groupe alkyle secondaire ou supérieur substitué ou non substitué, et des R₁ à R₃ adjacents peuvent être liés ensemble pour former un cycle,
R₄ à R₁₄ sont sélectionnés chacun indépendamment dans le groupe consistant en un atome d'hydrogène, un atome de deutérium, un atome d'halogène, un groupe alkyle substitué ou non substitué, un groupe alcoxy substitué ou non substitué, un groupe silyle substitué ou non substitué, un groupe amino substitué ou non substitué, un groupe allyle substitué ou non substitué, un groupe aryle substitué ou non substitué, un groupe hétéroaryle substitué ou non substitué, un groupe aryloxy substitué ou non substitué, un groupe hétéroaryloxy substitué ou non substitué, et un groupe cyano, et des R₄ à R₁₄ adjacents peuvent être liés ensemble pour former un cycle,
dans la formule [2-2], R₁₅ à R₁₇ sont sélectionnés chacun indépendamment dans le groupe consistant en un atome d'hydrogène, un atome de deutérium, un groupe alkyle substitué ou non substitué, un groupe alcoxy substitué ou non substitué, un groupe silyle substitué ou non substitué, un groupe aryle substitué ou non substitué, et un groupe hétéroaryle substitué ou non substitué, au moins un parmi R₁₅ à R₁₇ n'est pas un atome d'hydrogène ou un atome de deutérium, à condition que, quand au moins un parmi R₁₅ à R₁₇ n'est pas un atome d'hydrogène ou un atome de deutérium et que deux parmi R₁₅ à R₁₇ sont un atome d'hydrogène ou un atome de deutérium, l'autre parmi R₁₅ à R₁₇ soit un groupe alkyle secondaire ou supérieur substitué ou non substitué, et des R₁₅ à R₁₇ adjacents peuvent être liés ensemble pour former un cycle,
R₁₈ à R₃₀ sont sélectionnés chacun indépendamment dans le groupe consistant en un atome d'hydrogène, un atome de deutérium, un atome d'halogène, un groupe alkyle substitué ou non substitué, un groupe alcoxy substitué ou non substitué, un groupe silyle substitué ou non substitué, un groupe amino substitué ou non substitué, un groupe aryle substitué ou non substitué, un groupe aryle substitué ou non substitué, un groupe hétéroaryle substitué ou non substitué, un groupe aryloxy substitué ou non substitué, un groupe hétéroaryloxy substitué ou non substitué, et un groupe cyano, et des R₁₈ à R₃₀ adjacents peuvent être liés ensemble pour former un anneau,
L' désigne un ligand bidenté représenté par la formule générale [3] ou [4] suivante : 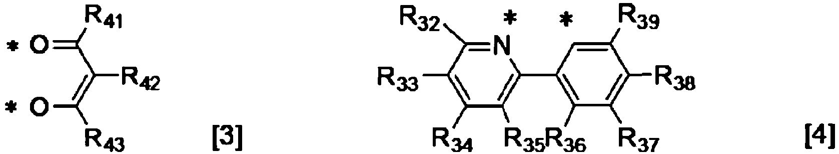
dans la formule [3], R₄₁ à R₄₃ sont sélectionnés chacun indépendamment dans le groupe consistant en un atome d'hydrogène, un atome de deutérium, un atome de fluor, un groupe alkyle substitué ou non substitué, un groupe alcoxy substitué ou non substitué, un groupe amino substitué ou non substitué, un groupe aryle substitué ou non substitué et un groupe hétéroaryle substitué ou non substitué, et des R₄₁ à R₄₃ adjacents peuvent être liés ensemble pour former un cycle, et
dans la formule [4], R₃₂ à R₃₉ sont sélectionnés chacun indépendamment dans le groupe consistant en un atome d'hydrogène, un atome de deutérium, un atome de fluor, un groupe alkyle substitué ou non substitué, un groupe alcoxy substitué ou non substitué, un groupe amino substitué ou non substitué, un groupe allyle substitué ou non substitué, un groupe aryle substitué ou non substitué et un groupe hétéroaryle substitué ou non substitué, et des R₃₂ à R₃₉ adjacents peuvent être liés ensemble pour former un cycle.

2. Complexe organométallique selon la revendication 1, dans lequel la structure partielle Ir(L)ₘ est une structure partielle représentée par la formule générale [2-1].

3. Complexe organométallique selon la revendication 2, dans lequel au moins deux parmi R₁ à R₃ ne sont pas un atome d'hydrogène ou un atome de deutérium.

4. Complexe organométallique selon la revendication 3, dans lequel au moins deux parmi R₁ à R₃ sont un groupe alkyle substitué ou non substitué.

5. Complexe organométallique selon la revendication 1, dans lequel la structure partielle Ir(L)ₘ est une structure partielle représentée par la formule générale [2-2].

6. Complexe organométallique selon la revendication 5, dans lequel au moins deux parmi R₁₅ à R₁₇ ne sont pas un atome d'hydrogène ou un atome de deutérium.

7. Complexe organométallique selon la revendication 6, dans lequel au moins deux parmi R₁₅ à R₁₇ sont un groupe alkyle substitué ou non substitué.

8. Complexe organométallique selon l'une quelconque des revendications 1 à 7, dans lequel R₅ et R₁₉ ne sont pas un atome d'hydrogène ou un atome de deutérium.

9. Élément organique émetteur de lumière comprenant : une première électrode (2) ; une seconde électrode (5) ; et une couche de composé organique (4, 22) entre la première électrode et la seconde électrode, dans lequel la couche de composé organique a une couche contenant le complexe organométallique selon l'une quelconque des revendications 1 à 8.

10. Élément organique émetteur de lumière selon la revendication 9, dans lequel la couche contenant le complexe organométallique est une couche émettrice de lumière (43, 44).

11. Élément organique émetteur de lumière selon la revendication 10, dans lequel l'élément organique émetteur de lumière émet une lumière rouge.

12. Élément organique émetteur de lumière selon la revendication 10 ou 11, comprenant en outre une autre couche émettrice de lumière sur la couche émettrice de lumière, dans lequel l'autre couche émettrice de lumière émet une lumière d'une couleur différente de celle de la couche émettrice de lumière.

13. Élément organique émetteur de lumière selon la revendication 12, dans lequel l'élément organique émetteur de lumière émet une lumière blanche.

14. Appareil d'affichage comprenant une pluralité de pixels (10, 10R, 10G, 10B), dans lequel au moins l'un de la pluralité de pixels comprend l'élément organique émetteur de lumière selon l'une quelconque des revendications 9 à 13 et un élément actif couplé à l'élément organique émetteur de lumière.

15. Appareil d'affichage d'image comprenant :
une partie entrée configurée pour entrer des informations d'image ; et
une unité d'affichage (1201, 1302, 1311, 1312) configurée pour afficher une image,
dans lequel l'unité d'affichage comprend l'appareil d'affichage selon la revendication 14.

16. Appareil de conversion photoélectrique comprenant :
une unité optique comprenant une pluralité de lentilles ;
un élément d'imagerie configuré pour recevoir la lumière passant à travers l'unité optique ; et
une unité d'affichage configurée pour afficher une image prise par l'élément d'imagerie,
dans lequel l'unité d'affichage comprend l'élément organique émetteur de lumière selon l'une quelconque des revendications 9 à 13.

17. Équipement électronique comprenant :
un boîtier (1104, 1203, 1313, 1401)
une unité de communication configurée pour communiquer avec l'extérieur ; et
une unité d'affichage,
dans lequel l'unité d'affichage est l'élément organique émetteur de lumière selon l'une quelconque des revendications 9 à 13.

18. Appareil d'éclairage comprenant :
une source de lumière (1402) comprenant l'élément organique émetteur de lumière selon l'une quelconque des revendications 9 à 13 ; et
une unité de diffusion de lumière (1405) ou un filtre optique (1404) configuré pour transmettre une lumière émise par la source de lumière.

19. Corps mobile comprenant :
un corps (1503) ; et
une lampe fournie sur le corps,
dans lequel la lampe comprend l'élément organique émetteur de lumière selon l'une quelconque des revendications 9 à 13.

20. Appareil de formation d'image comprenant :
un organe photosensible (27) ; et
une source de lumière d'exposition (28) configurée pour irradier l'organe photosensible avec une lumière,
dans lequel la source de lumière d'exposition comprend l'élément organique émetteur de lumière selon l'une quelconque des revendications 9 à 13.
